# EUROPEAN PATENT APPLICATION

(11) **EP 4 772 357 A1**
(43) Date of publication of application: **08.07.2026**
(21) Application number: 24859964.9
(22) Date of filing: 30.08.2024
(51) Int. Cl.: B41N 1/14, B41C 1/10, G03F 7/00, G03F 7/004, G03F 7/09, G03F 7/027, G03F 7/028, G03F 7/029

(54) **ON-PRESS DEVELOPABLE LITHOGRAPHIC PRINTING PLATE PRECURSOR AND METHOD FOR MANUFACTURING PRINTING PLATE**

(30) Priority: 31.08.2023 JP 2023141847; 29.02.2024 JP 2024030807
(71) Applicant: FUJIFILM Corporation, Tokyo 106-8620 (JP)
(72) Inventor: WATANABE Shumpei, Haibara-gun, Shizuoka 421-0396 (JP); MIZUNO Akio, Haibara-gun, Shizuoka 421-0396 (JP); UEMURA Minoru, Haibara-gun, Shizuoka 421-0396 (JP)
(74) Representative: HGF
(86) International application number: PCT/JP2024/031228
(87) International publication number: WO 2025/047939

(57) **Abstract**

In the present invention, there are provided an on-press development type lithographic printing plate precursor including an image-recording layer on a support, in which the image-recording layer contains a color-forming compound having a group that cleaves by infrared exposure, a polymerization initiator, a polymerizable compound, and a hydrogen-donating compound, and the hydrogen-donating compound is a compound different from the polymerization initiator, the polymerizable compound, the color-forming compound, and an acid-cleavable compound and is a compound having at least one group selected from the group consisting of -OH, -NH-, -SO₂-NH-, -SO₂-OH, -CO-NH-, and -CO-OH in a molecule and having a molecular weight of less than 3,000, and a method of preparing a printing plate.

## Description

### BACKGROUND OF THE INVENTION

### 1. Field of the Invention

The present invention relates to an on-press development type lithographic printing plate precursor and a method of preparing a printing plate.

### 2. Description of the Related Art

Generally, a lithographic printing plate consists of a lipophilic image area that receives ink in a printing process and a hydrophilic non-image area that receives dampening water. Lithographic printing is a printing method that utilizes the property that water and oil-based ink repel each other to cause differences in ink attachment behavior on a surface of the lithographic printing plate by using lipophilic image areas on the lithographic printing plate as an ink-receiving area and using hydrophilic non-image areas on the lithographic printing plate as dampening water-receiving areas (non-ink-receiving areas), thereby depositing the ink only to the image areas, and then transferring the ink to a printing material, such as paper.

Currently, in a plate making step of preparing a lithographic printing plate from a lithographic printing plate precursor, image exposure is performed by a computer-to-plate (CTP) technique. That is, the image exposure is performed by performing scanning exposure or the like directly on a lithographic printing plate precursor by using a laser or a laser diode without the intervention of a lith film.

Incidentally, due to the increasing concern for the global environment, in regard to making a lithographic printing plate precursor, attention is paid to the environmental issues relating to the waste liquid involved in a wet treatment such as a development treatment. As a result, there is a trend towards simplification or elimination of the development treatment. As one of the simple development treatments, a method called "on-press development" has been proposed. The on-press development is a method of performing image exposure on a lithographic printing plate precursor, then directly mounting the lithographic printing plate precursor on a printing press without performing the wet development treatment of the related art, and removing a non-image area of an image-recording layer at the initial stage of the general printing step.

JP2020-069789A describes a lithographic printing plate precursor including a support and an image-recording layer on the support, in which the image-recording layer contains an infrared absorber that decomposes by infrared exposure, a binder polymer having a constitutional unit formed of an aromatic vinyl compound, a polymerization initiator, and a polymerizable compound.
JP7280351B discloses a color-forming composition including an acid generator, a tetraaryl borate, an acid-sensitive dye precursor, and a compound having a specific structure (I).

### SUMMARY OF THE INVENTION

Incidentally, in a case where a lithographic printing plate precursor is mounted to a printing press, an image of an exposed portion is usually visually recognized. In a case where the wet development treatment in the related art is performed, since the lithographic printing plate from which the non-image area has been removed is mounted on a printing press, it is easy to visually recognize the image of the exposed portion of the lithographic printing plate. On the other hand, in a case where on-press development is performed, since the lithographic printing plate precursor from which the non-image area has not yet been removed is mounted on the printing press, it tends to be difficult to visually recognize the image of the lithographic printing plate.

In consideration of the above, in view of improving color formability in the exposed portion, a lithographic printing plate precursor has been developed, in which the image-recording layer contains a color-forming compound having a group that cleaves by infrared exposure.

Here, it is common to store the lithographic printing plate precursor after exposure under a white light, but in the lithographic printing plate precursor in which the image-recording layer contains the color-forming compound having a group that cleaves by infrared exposure, it has been found that the visibility of the exposed portion is likely to deteriorate after storage under a white light. On the other hand, in a case of not using the color-forming compound having a group that cleaves by infrared exposure in order to suppress the deterioration in visibility of the image portion after storage under a white light, it has been found that the good visibility of the exposed portion immediately after exposure is difficult to maintain.

The present invention has been made in view of the above, and an object thereof is to provide an on-press development type lithographic printing plate precursor in which visibility of an exposed portion is good immediately after exposure, good visibility immediately after exposure is easily maintained, and visibility of the exposed portion is also good after storage under a white light, and a method of producing a printing plate using the on-press development type lithographic printing plate precursor.

The means for achieving the above objects will be described below.

[1] An on-press development type lithographic printing plate precursor comprising:
an image-recording layer on a support,
in which the image-recording layer contains a color-forming compound having a group that cleaves by infrared exposure, a polymerization initiator, a polymerizable compound, and a hydrogen-donating compound, and
the hydrogen-donating compound is a compound different from the polymerization initiator, the polymerizable compound, the color-forming compound, and an acid-cleavable compound and is a compound having at least one group selected from the group consisting of -OH, -NH-, -SO₂-NH-, -SO₂-OH, -CO-NH-, and -CO-OH in a molecule and having a molecular weight of less than 3,000.

[2] The on-press development type lithographic printing plate precursor according to [1],
in which the hydrogen-donating compound is a compound having at least one partial structure represented by the following Formula (I) in a molecule.

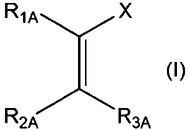

In Formula (I),
X is a hydrogen-donating group selected from the group consisting of -OH, -NH-, -SO₂-NH-, -SO₂-OH, -CO-NH-, and -CO-OH.
R_{1A} to R_{3A} each independently are a group having at least one selected from the group consisting of a hydrogen atom, a carbon atom, a halogen atom, and a heteroatom.

At least two of R_{1A} to R_{3A} may be linked to each other to form a ring.

In a case where X is a monovalent group, one or more hydrogen atoms included in R_{1A} to R_{3A} are removed to form a bonding site.

In a case where X is a divalent group, one or more hydrogen atoms included in R_{1A} to R_{3A} may be further removed to form a bonding site.

[3] The on-press development type lithographic printing plate precursor according to [1] or [2],
in which the hydrogen-donating compound is a compound having at least one partial structure represented by Formula (II) in a molecule.

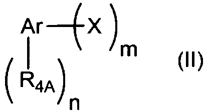

In Formula (II),
Ar represents an aromatic ring group.
X is a group selected from the group consisting of -OH, -NH-, -SO₂-NH-, -SO₂-OH, -CO-NH-, and -CO-OH.
R_{4A} is a group having at least one selected from the group consisting of a hydrogen atom, a carbon atom, a halogen atom, and a heteroatom.
m represents an integer of 1 to 5. In a case where m represents an integer of 2 or more, a plurality of X's may be the same or different from each other.
n represents an integer of 0 to 5. In a case where n represents an integer of 2 or more, a plurality of R_{4A}'s may be the same or different from each other. In a case where n is 2 or more, a plurality of R_{4A}'s may be linked to each other to form a ring.

In a case where all X's are monovalent groups, one or more hydrogen atoms included in R_{4A} are removed to form a bonding site.

In a case where at least one X is a divalent group, one or more hydrogen atoms included in R_{4A} may be further removed to form a bonding site.

[4]
The on-press development type lithographic printing plate precursor according to any one of [1] to [3],
in which the hydrogen-donating compound is a compound having at least one partial structure represented by Formula (III) in a molecule.

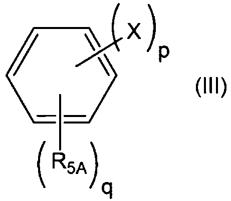

In Formula (III),
X is a group selected from the group consisting of -OH, -NH-, -SO₂-NH-, -SO₂-OH, -CO-NH-, and -CO-OH.
R_{5A} is a group having at least one selected from the group consisting of a hydrogen atom, a carbon atom, a halogen atom, and a heteroatom.
p represents an integer of 1 to 5. In a case where p represents an integer of 2 or more, a plurality of X's may be the same or different from each other.
q represents an integer of 0 to 5. In a case where q represents an integer of 2 or more, a plurality of R₅'s may be the same or different from each other. In a case where q is 2 or more, a plurality of R_{5A}'s may be linked to each other to form a ring.
p + q is 6 or less.

In a case where all X's are monovalent groups, one or more hydrogen atoms included in R_{5A} are removed to form a bonding site.

In a case where at least one X is a divalent group, one or more hydrogen atoms included in R_{5A} may be further removed to form a bonding site.
[5] The on-press development type lithographic printing plate precursor according to any of [1] to [4], in which the hydrogen-donating compound is a compound having at least two groups selected from the group consisting of -OH, -NH-, -SO₂-NH-, -SO₂-OH, -CO-NH-, and -CO-OH in a molecule.
[6] The on-press development type lithographic printing plate precursor according to any one of [1] to [5], in which the hydrogen-donating compound has at least one group selected from the group consisting of -OH and -SO₂-NH-.
[7] The on-press development type lithographic printing plate precursor according to any one of [1] to [6],
   in which the hydrogen-donating compound has at least two groups selected from the group consisting of -OH and -SO₂-NH-.
[8]
   The on-press development type lithographic printing plate precursor according to any one of [1] to [7],
   in which the hydrogen-donating compound has at least one phenolic hydroxyl group.
[9]
   The on-press development type lithographic printing plate precursor according to any one of [1] to [8],
   in which the hydrogen-donating compound has two or more phenolic hydroxyl groups.
[10]
   The on-press development type lithographic printing plate precursor according to any one of [1] to [9],
   in which the color-forming compound having the group that cleaves by the infrared exposure is a cyanine coloring agent represented by Formula 1.

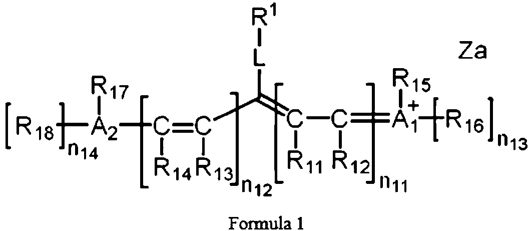

In Formula 1, R¹ represents a group having an R¹-L bond that cleaves by the infrared exposure, R₁₁ to R₁₈ each independently represent a hydrogen atom, a halogen atom, -Ra, -ORb, -SRc, or -NRdRe, Ra to Re each independently represent a hydrocarbon group, A₁, A₂, and a plurality of R₁₁'s to R₁₈'s may be linked to each other to form a monocycle or a polycycle, A₁ and A₂ each independently represent an oxygen atom, a sulfur atom, or a nitrogen atom, n₁₁ and n₁₂ each independently represent an integer of 0 to 5, where a total of n₁₁ and n₁₂ is 2 or greater, n₁₃ and n₁₄ each independently represent 0 or 1, L represents an oxygen atom, a sulfur atom, or -NR¹⁰-, R¹⁰ represents a hydrogen atom, an alkyl group, or an aryl group, and Za represents a counterion that neutralizes charge.

[11]
The on-press development type lithographic printing plate precursor according to [10],
in which the color-forming compound having the group that cleaves by the infrared exposure is a compound represented by Formula 2.

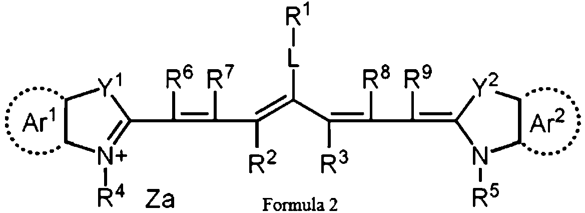

In Formula 2, R¹ represents a group having an R¹-L bond that cleaves by the infrared exposure, R² and R³ each independently represent a hydrogen atom or an alkyl group and may be linked to each other to form a ring, Ar¹ and Ar² each independently represent a group that forms a benzene ring or a naphthalene ring, Y¹ and Y² each independently represent an oxygen atom, a sulfur atom, -NR⁰-, or a dialkylmethylene group, R⁰ represents a hydrogen atom, an alkyl group, or an aryl group, R⁴ and R⁵ each independently represent an aliphatic hydrocarbon group, R⁶ to R⁹ each independently represent a hydrogen atom or an alkyl group, L represents an oxygen atom, a sulfur atom, or -NR¹⁰-, R¹⁰ represents a hydrogen atom, an alkyl group, or an aryl group, and Za represents a counterion that neutralizes charge.

[12] The on-press development type lithographic printing plate precursor according to [11],
in which L in Formula 2 represents an oxygen atom.
[13] The on-press development type lithographic printing plate precursor according to [12],
in which R¹ in Formula 2 is a group represented by Formula (5).

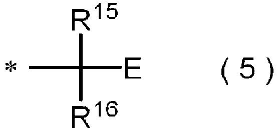

In Formula (5), R¹⁵ and R¹⁶ each independently represent a hydrogen atom, an alkyl group, or an aryl group, E represents an onium group, and * represents a bonding site with respect to the oxygen atom represented by L in Formula 2.
[14]
   The on-press development type lithographic printing plate precursor according to any one of [1] to [13],
   in which the polymerizable compound includes a polymerizable compound having 11 or more functional groups.
[15]
   The on-press development type lithographic printing plate precursor according to any one of [1] to [14],
   in which the polymerization initiator includes a borate compound as an electron-donating polymerization initiator.
[16]
   The on-press development type lithographic printing plate precursor according to any one of [1] to [15],
   in which the polymerization initiator includes an onium salt compound as an electron-accepting polymerization initiator.
[17]
   The on-press development type lithographic printing plate precursor according to any one of [1] to [16],
   in which the image-recording layer contains an acid color-forming agent in addition to the color-forming compound having the group that cleaves by the infrared exposure.
[18]
   The on-press development type lithographic printing plate precursor according to any one of [1] to [17], further comprising:
   a protective layer on the image-recording layer.
[19]
   The on-press development type lithographic printing plate precursor according to [18],
   in which the protective layer contains an inorganic lamellar compound.
[20]
   The on-press development type lithographic printing plate precursor according to [19],
   in which a content of the inorganic lamellar compound is 5 to 80 mg/m².
[21]
   The on-press development type lithographic printing plate precursor according to any one of [1] to [20],
   in which micropores in an anodic oxide film of the support each inlcude a large-diameter pore portion extending from a surface of the anodic oxide film to a position at a depth of 10 nm to 1,000 nm from the surface, and a small-diameter pore portion communicating with a bottom of the large-diameter pore portion and extending in a depth direction from a point of communication to a position at a depth of 20 nm to 2,000 nm from the point of communication,
   an average diameter of the large-diameter pore portion at the surface of the anodic oxide film is 15 nm to 100 nm, and
   an average diameter of the small-diameter pore portion at the point of communication is 15 nm or less..
[22]
   The on-press development type lithographic printing plate precursor according to any one of [1] to [20],
   in which micropores in an anodic oxide film of the support each inlcude a small-diameter pore portion extending from a surface of the anodic oxide film to a position at a depth of 10 nm to 1,000 nm from the surface, and a large-diameter pore portion communicating with a bottom of the small-diameter pore portion and extending in a depth direction from a point of communication to a position at a depth of 20 nm to 2,000 nm from the point of communication,
   an average diameter of the small-diameter pore portion at the surface of the anodic oxide film is 35 nm or less, and
   an average maximum diameter of the large-diameter pore portion is 40 to 300 nm.
[23]
   The on-press development type lithographic printing plate precursor according to any one of [1] to [20],
   in which the support has an anodic oxide film, and
   the anodic oxide film comprises, in order in a depth direction from a surface of the anodic oxide film:
      an upper layer having a thickness of 30 nm to 500 nm and having micropores with an average diameter of 20 nm to 100 nm;
      an intermediate layer having a thickness of 100 nm to 300 nm and having micropores with an average diameter of 1/2 to 5 times the average diameter of the micropores in the upper layer; and
   a lower layer having a thickness of 300 nm to 2,000 nm and having micropores with an average diameter of 15 nm or less.
[24]
   A method of preparing a printing plate, comprising:
   a step of image-exposing the on-press development type lithographic printing plate precursor according to any one of [1] to [23]; and
   a step of supplying at least one of printing ink or dampening water on a printing press to remove an unexposed portion of the image-recording layer in the on-press development type lithographic printing plate precursor.

With the present invention, it is possible to provide an on-press development type lithographic printing plate precursor in which visibility of an exposed portion is good immediately after exposure, good visibility immediately after exposure is easily maintained, and visibility of the exposed portion is also good after storage under a white light, and a method of producing a printing plate using the on-press development type lithographic printing plate precursor.

### BRIEF DESCRIPTION OF THE DRAWINGS

FIG. 1 is a graph of an example of a waveform diagram of alternating waveform current used for an electrochemical roughening treatment.
   FIG. 2 is a lateral view showing an example of a radial cell in an electrochemical roughening treatment using alternating current.
   FIG. 3 is a schematic view showing a cross-sectional shape of an end part of a lithographic printing plate precursor.
   FIG. 4 is a conceptual view showing an example of a cutting portion of a slitter device.
   FIG. 5 is a lateral view conceptually showing a brush graining step used in a mechanical roughening treatment in preparing an aluminum support.
   FIG. 6 is a schematic view of an anodization treatment device used for an anodization treatment.

### DESCRIPTION OF THE PREFERRED EMBODIMENTS

Although the configuration requirements to be described below may be described based on representative embodiments of the present invention, the present invention is not limited to such embodiments.

In the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present specification, "(meth)acryl" is a term used to explain a concept including both the acryl and methacryl, and "(meth)acryloyl" is a term used to explain a concept including both the acryloyl and methacryloyl.

The term "step" in the present specification means not only an independent step but also a step that cannot be clearly differentiated from other steps as long as the intended goal of the step is achieved.

In the present invention, a combination of two or more preferred aspects is a more preferred aspect.

In addition, in the present specification, unless otherwise specified, each of the mass-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

Hereinafter, the present invention will be described in detail.

### [On-press development type lithographic printing plate precursor]

There is provided an on-press development type lithographic printing plate precursor including:
an image-recording layer on a support,
in which the image-recording layer contains a color-forming compound having a group that cleaves by infrared exposure, a polymerization initiator, a polymerizable compound, and a hydrogen-donating compound, and
the hydrogen-donating compound is a compound different from the polymerization initiator, the polymerizable compound, the color-forming compound, and an acid-cleavable compound and is a compound having at least one group selected from the group consisting of -OH, -NH-, -SO₂-NH-, -SO₂-OH, -CO-NH-, and -CO-OH in a molecule and having a molecular weight of less than 3,000.

With the on-press development type lithographic printing plate precursor according to the present invention, by adopting the above-described configuration, it is possible to obtain an on-press development type lithographic printing plate precursor in which visibility of an exposed portion is good immediately after exposure, good visibility immediately after exposure is easily maintained, and visibility of the exposed portion is also good after storage under a white light.

A reason therefor is not clear, but is presumed as follows.

In view of the visibility of the exposed portion, it is generally performed to add a color-forming compound having a group that cleaves by infrared exposure to the image-recording layer of the lithographic printing plate. By containing the color-forming compound having a group that cleaves by infrared exposure in the image-recording layer, the visibility of the exposed portion immediately after exposure was good, and the good visibility immediately after exposure was maintained.

As described above, it is generally performed to store the lithographic printing plate precursor after exposure under a white light (under a white fluorescent lamp), but in the lithographic printing plate precursor containing the color-forming compound having a group that cleaves by infrared exposure in the image-recording layer, it has been found that the visibility of the exposed portion is likely to deteriorate after storage under a white light. It is presumed that the color-forming substance formed by the color-forming compound having a group that cleaves by infrared exposure in the exposed portion is oxidatively decomposed in storage under a white light, so that the good visibility immediately after exposure can not be maintained and is easily deteriorated.

In the on-press development type lithographic printing plate precursor according to the embodiment of the present invention, the image-recording layer contains a hydrogen-donating compound. Even in a case where the lithographic printing plate precursor is stored under a white light, the color-forming substance formed by the color-forming compound having a group that cleaves by infrared exposure in the exposed portion can be suppressed from being oxidatively decomposed in storage under a white light by coexisting the hydrogen-donating compound and the color-forming compound having a group that cleaves by infrared exposure in the image-recording layer. It is considered that the hydrogen-donating compound donates a hydrogen radical to a highly active peroxyl radical generated in the oxidative decomposition reaction of the color-forming substance, to form a hydroperoxide, thereby suppressing the oxidative decomposition reaction. As a result, it is considered that the deterioration in visibility of the image portion after storage under a white light can be suppressed.

As described above, it is considered that it is possible to obtain an on-press development type lithographic printing plate precursor in which visibility of an exposed portion is good immediately after exposure, good visibility immediately after exposure is easily maintained, and visibility of the exposed portion is also good after storage under a white light.

### [On-press development type lithographic printing plate precursor]

First, a lithographic printing plate precursor according to the embodiment of the present invention will be described.

### (Support)

As the support, an aluminum support is preferable. The aluminum plate used in the aluminum support consists of a dimensionally stable metal containing aluminum as a main component, that is, aluminum or an aluminum alloy. It is preferable that the aluminum plate be selected from a pure aluminum plate and an alloy that contains aluminum as a main component and traces of foreign elements.

The foreign elements contained in the aluminum alloy include silicon, iron, manganese, copper, magnesium, chromium, zinc, bismuth, nickel, titanium, and the like. The content of the foreign elements in the alloy is 10% by mass or less. As the aluminum plate, a pure aluminum plate is suitable. However, the aluminum plate may be an alloy that contains traces of foreign elements, because it is difficult to manufacture perfectly pure aluminum by smelting technologies. The composition of the aluminum plate used for the aluminum support is not specified, and it is possible to appropriately use aluminum plates known in the related art, for example, JIS A 1050, JIS A 1100, JIS A 3103, and JIS A 3005, and the like.

The thickness of the support (preferably, the aluminum plate) is preferably about 0.1 to 0.6 mm.

### (Anodic oxide film)

The support preferably has an anodic oxide film.

The anodic oxide film means an anodic oxide film (preferably an anodic aluminum oxide film) which is formed on the surface of a support (preferably an aluminum plate) by an anodization treatment and has supermicropores (also called micropores). The micropores extend from the surface of the anodic oxide film on the side opposite to the support along the thickness direction (support side, depth direction).

From the viewpoints of tone reproducibility, printing durability, and blanket stain property, the average diameter (average opening diameter) of the micropores within the surface of the anodic oxide film is preferably 7 nm to 150 nm, more preferably 10 nm to 100 nm, even more preferably 10 nm to 60 nm, particularly preferably 15 nm to 60 nm, and most preferably 18 nm to 40 nm.

The depth of the micropores is preferably 10 nm to 3,000 nm, more preferably 10 nm to 2,000 nm, and even more preferably 10 nm to 1,000 nm.

Usually, the micropores have a substantially straight tubular shape (substantially cylindrical shape) in which the diameter of the micropores substantially does not change in the depth direction (thickness direction). The micropores may also have a conical shape that continues to taper in the depth direction (thickness direction). In addition, the diameter of the micropores may have a shape that discontinuously tapers along the depth direction (thickness direction).

Examples of the micropores having a shape that discontinuously tapers in the depth direction (thickness direction) include micropores each configured with a large diameter portion that extends along the depth direction from the surface of the anodic oxide film and a small-diameter pore portion that is in communication with the bottom portion of the large-diameter pore portion and extends along the depth direction from the communicate position.

Specifically, the micropores are preferable which are each configured with a large-diameter pore portion that extends 10 nm to 1,000 nm in the depth direction from the surface of the anodic oxide film and a small-diameter pore portion that is in communication with the bottom portion of the large-diameter pore portion and extends 20 nm to 2,000 nm in the depth direction from the communicate position.

Hereinafter, the large-diameter pore portion and the small-diameter pore portion will be specifically described.

### -Large-diameter pore portion-

From the viewpoints of tone reproducibility, printing durability, and stain resistance, the average diameter (average opening diameter) of the large-diameter pore portion within the surface of the anodic oxide film is preferably 7 nm to 150 nm, more preferably 10 nm to 100 nm, still more preferably 15 nm to 100 nm, particularly preferably 15 nm to 60 nm, and most preferably 18 nm to 40 nm.

The average diameter of the large-diameter pore portion is calculated by a method of observing the surface of the anodic oxide film with a field emission scanning electron microscope (FE-SEM) at 150,000X magnification (N = 4), by randomly selecting 50 micropores (large-diameter pore portions) existing in a range of 400 nm × 600 nm in the obtained 4 images, by measuring the sizes (diameters), and by calculating the arithmetic mean.

In a case where the shape of the large-diameter pore portion is not circular, the equivalent circle diameter is used. "Equivalent circular diameter" is a diameter determined on an assumption that the opening portion is in the form of a circle having the same projected area as the projected area of the opening portion.

The bottom portion of the large-diameter pore portion is preferably in a position at a depth of 70 nm to 1,000 nm (hereinafter, also called depth A) from the surface of the anodic oxide film. That is, the large-diameter pore portion is preferably a pore portion extending to a position at a depth of 70 nm to 1,000 nm from the surface of the anodic oxide film in the depth direction (thickness direction). Particularly, from the viewpoint of further improving the effect of the manufacturing method of a lithographic printing plate precursor, the depth A is more preferably 90 nm to 850 nm, even more preferably 90 nm to 800 nm, and particularly preferably 90 nm to 600 nm.

The depth is a value obtained by taking an image (150,000X magnification) of a cross section of the anodic oxide film, measuring the depths of 25 or more large-diameter pore portions, and calculating the arithmetic mean thereof.

The shape of the large-diameter pore portion is not particularly limited. Examples of the shape of the large-diameter pore portion include a substantially straight tubular shape (substantially cylindrical shape) and a conical shape that tapers along the depth direction (thickness direction). Among these, a substantially straight tubular shape is preferable. The shape of the bottom portion of the large-diameter pore portion is not particularly limited, and may be a curved (convex) or planar shape.

The inner diameter of the large-diameter pore portion is not particularly limited, but is preferably as large as the diameter of the opening portion or smaller than the diameter of the opening portion. There may be a difference of about 1 nm to 10 nm between the inner diameter of the large-diameter pore portion and the diameter of the opening portion.

### -Small-diameter pore portion-

The small-diameter pore portion is a pore portion that is in communication with the bottom portion of the large-diameter pore portion and further extends from the communicate position in the depth direction (thickness direction). Generally, one small-diameter pore portion is in communication with one large-diameter pore portion. However, two or more small-diameter pore portions may be in communication with the bottom portion of one large-diameter pore portion.

The average diameter of the small-diameter pore portion at the communicate position is preferably 15 nm or less, more preferably 13 nm or less, even more preferably 11 nm or less, and particularly preferably 10 nm or less. The lower limit thereof is not particularly limited, but is preferably 5 nm.

The average diameter of the small-diameter pore portion is obtained by observing the surface of the anodic oxide film with FE-SEM at 150,000X magnification (N = 4), by randomly selecting 50 micropores (small-diameter pore portion) existing in a range of 400 nm × 600 nm in the obtained 4 images, by measuring the sizes (diameters), and by calculating the arithmetic mean of the diameters. In a case where the large-diameter pore portion is deep, as necessary, the upper portion of the anodic oxide film (region where the large-diameter pore portion is located) may be cut (for example, cut by using argon gas), then the surface of the anodic oxide film may be observed with FE-SEM described above, and the average diameter of the small-diameter pore portion may be determined.

In a case where the shape of the small-diameter pore portion is not circular, the equivalent circle diameter is used. "Equivalent circular diameter" is a diameter determined on an assumption that the opening portion is in the form of a circle having the same projected area as the projected area of the opening portion.

The bottom portion of the small-diameter pore portion is preferably in a position 20 nm to 2,000 nm distant from the communicate position (corresponding to the depth A described above) with the large-diameter pore portion in the depth direction. In other words, the small-diameter pore portion is a pore portion that extends further from the communicate position with the large-diameter pore portion in the depth direction (thickness direction), and the depth of the small-diameter pore portion is preferably 20 nm to 2,000 nm, more preferably 100 nm to 1,500 nm, and particularly preferably 200 nm to 1,000 nm.

The depth is a value obtained by taking an image (150,000X magnification) of a cross section of the anodic oxide film, measuring the depths of 25 or more small-diameter pore portions, and calculating the arithmetic mean thereof.

The shape of the small-diameter pore portion is not particularly limited. Examples of the shape of the small-diameter pore portion include a substantially straight tubular shape (substantially cylindrical shape) and a conical shape that tapers along the depth direction. Among these, a substantially straight tubular shape is preferable. In addition, the shape of the bottom portion of the small-diameter pore portion is not particularly limited, and may be a curved (convex) or planar shape.

The inner diameter of the small-diameter pore portion is not particularly limited, and may be the same as the diameter at the communicate position, or may be smaller or larger than the diameter at the communicate position. Generally, there may be a difference of about 1 nm to 10 nm between the inner diameter of the small-diameter pore portion and the diameter of the opening portion.

The ratio of the average diameter of the large-diameter pore portion within the surface of the anodic oxide film to the average diameter of the small-diameter pore portion at the communicate position, (average diameter of large-diameter pore portion within surface of anodic oxide film)/(average diameter of small-diameter pore portion at communicate position) is preferably 1.1 to 13, and more preferably 2.5 to 6.5.

The ratio of the depth of the large-diameter pore portion to the depth of the small-diameter pore portion, (depth of large-diameter pore portion)/(depth of small-diameter pore portion) is preferably 0.005 to 50, and more preferably 0.025 to 40.

The micropores have a substantially straight tubular shape (substantially cylindrical shape) in which the diameter of the micropores substantially does not change in the depth direction (thickness direction). The micropores may also have a conical shape that continues to widen in the depth direction (thickness direction). The micropores may have a shape that discontinuously widens along the depth direction (thickness direction).

Examples of the micropores having a shape that discontinuously widens in the depth direction (thickness direction) include micropores each configured with a small-diameter pore portion that extends along the depth direction from the surface of the anodic oxide film and a large-diameter pore portion that is in communication with the bottom portion of the small-diameter pore portion and extends along the depth direction from the communicate position.

Specifically, the micropores are preferable which are each configured with a small-diameter pore portion that extends 10 nm to 1,000 nm in the depth direction from the surface of the anodic oxide film and a large-diameter pore portion that is in communication with the bottom portion of the small-diameter pore portion and further extends 20 nm to 2,000 nm in the depth direction from the communicate position.

### -Small-diameter pore portion-

The average diameter (average opening diameter) of the small-diameter pore portion within the surface of the anodic oxide film is not particularly limited, but is preferably 35 nm or less, more preferably 25 nm or less, and particularly preferably 20 nm or less. The lower limit thereof is not particularly limited, but is preferably 15 nm.

The average diameter of the small-diameter pore portion is calculated by a method of observing the surface of the anodic oxide film with a field emission scanning electron microscope (FE-SEM) at 150,000X magnification (N = 4), by randomly selecting 50 micropores (small-diameter pore portions) existing in a range of 400 nm × 600 nm in the obtained 4 images, by measuring the sizes (diameters), and by calculating the arithmetic mean of the diameters.

In a case where the shape of the small-diameter pore portion is not circular, the equivalent circle diameter is used. "Equivalent circular diameter" is a diameter determined on an assumption that the opening portion is in the form of a circle having the same projected area as the projected area of the opening portion.

The bottom portion of the small-diameter pore portion is preferably in a position at a depth of 70 nm to 1,000 nm (hereinafter, also called depth A') from the surface of the anodic oxide film. That is, the small-diameter pore portion is preferably a pore portion extending 70 nm to 1,000 nm in the depth direction (thickness direction) from the surface of the anodic oxide film.

The depth is a value obtained by taking an image (150,000X magnification) of a cross section of the anodic oxide film, measuring the depths of 25 or more large-diameter pore portions, and calculating the arithmetic mean thereof.

The shape of the small-diameter pore portion is not particularly limited. Examples of the shape of the large-diameter pore portion include a substantially straight tubular shape (substantially cylindrical shape) and a conical shape that widens along the depth direction (thickness direction). Among these, a substantially straight tubular shape is preferable. In addition, the shape of the bottom portion of the small-diameter pore portion is not particularly limited, and may be a curved (convex) or planar shape.

The inner diameter of the small-diameter pore portion is not particularly limited, but is preferably as large as the diameter of the opening portion or smaller than the diameter of the opening portion. There may be a difference of about 1 nm to 10 nm between the inner diameter of the small-diameter pore portion and the diameter of the opening portion.

### -Large-diameter pore portion-

The large-diameter pore portion is a pore portion that is in communication with the bottom portion of the small-diameter pore portion and further extends from the communicate position in the depth direction (thickness direction). Generally, the bottom portion of one large-diameter pore portion may be in communication with two or more small-diameter pore portions.

The average diameter of the large-diameter pore portion at the communicate position is preferably 20 nm to 400 nm, more preferably 40 nm to 300 nm, even more preferably 50 nm to 200 nm, and particularly preferably 50 nm to 100 nm.

The average diameter of the large-diameter pore portion is obtained by observing the surface of the anodic oxide film with FE-SEM at 150,000X magnification (N = 4), by randomly selecting 50 micropores (large-diameter pore portion) existing in a range of 400 nm × 600 nm in the obtained 4 images, by measuring the sizes (diameters), and by calculating the arithmetic mean of the diameters. In a case where the small-diameter pore portion is deep, as necessary, the upper portion of the anodic oxide film (region where the small-diameter pore portion is located) may be cut (for example, cut by using argon gas), then the surface of the anodic oxide film may be observed with FE-SEM described above, and the average diameter of the large-diameter pore portion may be determined.

In a case where the shape of the large-diameter pore portion is not circular, the equivalent circle diameter is used. "Equivalent circular diameter" is a diameter determined on an assumption that the opening portion is in the form of a circle having the same projected area as the projected area of the opening portion.

The bottom portion of the large-diameter pore portion is preferably in a position 20 nm to 2,000 nm distant from the communicate position (corresponding to the depth A' described above) with the small-diameter pore portion in the depth direction. In other words, the large-diameter pore portion is a pore portion that extends further from the communicate position with the small-diameter pore portion in the depth direction (thickness direction), and the depth of the large-diameter pore portion is preferably 20 nm to 2,000 nm, more preferably 100 nm to 1,500 nm, and particularly preferably 200 nm to 1,000 nm.

The depth is a value obtained by taking an image (150,000X magnification) of a cross section of the anodic oxide film, measuring the depths of 25 or more large-diameter pore portions, and calculating the arithmetic mean thereof.

The shape of the large-diameter pore portion is not particularly limited. Examples of the shape of the large-diameter pore portion include a substantially straight tubular shape (substantially cylindrical shape) and a conical shape that tapers along the depth direction. Among these, a substantially straight tubular shape is preferable. The shape of the bottom portion of the large-diameter pore portion is not particularly limited, and may be a curved (convex) or planar shape.

The inner diameter of the large-diameter pore portion is not particularly limited, and may be the same as the diameter at the communicate position, or may be smaller or larger than the diameter at the communicate position. Generally, there may be a difference of about 1 nm to 10 nm between the inner diameter of the large-diameter pore portion and the diameter of the opening portion.

It is preferable that the support has an anodic oxide film, and
the anodic oxide film has, in order from a surface of the anodic oxide film in a depth direction,
an upper layer having micropores with an average diameter of 20 to 100 nm and having a thickness of 30 to 500 nm,
an intermediate layer having micropores with an average diameter of 1/2 to 5 times the average diameter of the micropores in the upper layer having the micropores and having a thickness of 100 to 300 nm, and
a lower layer having micropores with an average diameter of 15 nm or less and having a thickness of 300 to 2000 nm.

In an on-press development type lithographic printing plate precursor, from the viewpoint of improving image visibility, a support is useful in which the surface of an anodic oxide film (surface on which an image-recording layer is to be formed) has high brightness.

Usually, in a printing step using a lithographic printing plate, before the printing plate is mounted on a printing press, the plate is inspected to check whether an image is printed as intended. For the on-press development type lithographic printing plate precursor, it is required to check the image at the stage where the image is exposed. Therefore, a unit generating a so-called printed image in an image exposed portion is used.

Examples of a method of quantitatively evaluating the visibility of an image area (image visibility) of the on-press development type lithographic printing plate precursor having undergone exposure of an image include a method of measuring the brightness of an image exposed portion and the brightness of an unexposed portionand calculating the difference therebetween. As the brightness, a value of brightness L* in the CIEL*a*b* color system can be used. The brightness can be measured using a color difference meter (Spectro Eye, manufactured by X-Rite, Incorporated.). The larger the difference between the measured brightness of the image exposed portion and the measured brightness of the unexposed portion is, the higher the visibility of the image area is.

It has been revealed that the larger the value of brightness L* of the surface of the anodic oxide film in the CIEL*a*b* color system is, the more effective it is to increase the difference between the brightness of the image exposed portion and the brightness of theunexposed portion. That is, the value of the brightness L* is preferably 60 to 100.

As necessary, the support having an anodic oxide film may have a backcoat layer containing the organic high-molecular-weight compound described in JP1993-45885A (JP-H5-45885A), the alkoxy compound of silicon described in JP1994-35174A (JP-H6-35174A), or the like, on a surface opposite to the side where a constitutional layer containing a hydroxy acid compound having two or more hydroxyl groups is formed.

### (Manufacturing of aluminum support having anodic oxide film)

The manufacturing method of an aluminum support having an anodic oxide film, which is an example of support, will be described.

The aluminum support having an anodic oxide film can be manufactured using known methods. The manufacturing method of the aluminum support having an anodic oxide film is not particularly limited. Examples of preferred aspects of the manufacturing method of the aluminum support having an anodic oxide film include a method including a step of performing a roughening treatment on an aluminum plate (roughening treatment step), a step of anodizing the aluminum plate having undergone the roughening treatment (anodization treatment step), and a step of bringing the aluminum plate having an anodic oxide film obtained by the anodization treatment step into contact with an aqueous acid solution or an alkaline aqueous solution to increase the diameter of micropores in the anodic oxide film (pore widening treatment step).

### Hereinafter, each step will be described in detail.

### <Roughening treatment step>

The roughening treatment step is a step of performing a roughening treatment including an electrochemical roughening treatment on the surface of the aluminum plate. The roughening treatment step is preferably performed before the anodization treatment step which will be described later. However, in a case where the surface of the aluminum plate already has a preferable shape, the roughening treatment step may not be performed.

As the roughening treatment, only an electrochemical roughening treatment may be performed, or an electrochemical roughening treatment may be performed in combination with at least either a mechanical roughening treatment or a chemical roughening treatment.

In a case where the mechanical roughening treatment and the electrochemical roughening treatment are combined, it is preferable to perform the electrochemical roughening treatment after the mechanical roughening treatment.

The electrochemical roughening treatment is preferably performed in an aqueous solution of nitric acid or hydrochloric acid.

Generally, the mechanical roughening treatment is performed such that the aluminum plate has a surface roughness Ra: 0.35 to 1.0 µm.

The conditions of the mechanical roughening treatment are not particularly limited. For example, the mechanical roughening treatment can be performed according to the method described in JP1975-40047B (JP-S50-40047B). The mechanical roughening treatment can be performed by a brush graining treatment using a pumice stone suspension or by a transfer method.

The chemical roughening treatment is also not particularly limited, and can be performed according to known methods.

After the mechanical roughening treatment, it is preferable to perform the following chemical etching treatment.

By the chemical etching treatment performed after the mechanical roughening treatment, the edge portion of surface irregularities of the aluminum plate is smoothed, such that ink clotting that may occur during printing is prevented, the antifouling property of the lithographic printing plate is improved, and unnecessary substances such as abrasive particles remaining on the surface are removed.

As the chemical etching treatment, etching with an acid and etching with an alkali are known. One of the examples of particularly efficient etching methods is a chemical etching treatment using an alkaline solution (hereinafter, also called "alkaline etching treatment").

The alkaline agent used in the alkaline solution is not particularly limited. Suitable examples thereof include caustic soda, caustic potash, sodium metasilicate, sodium carbonate, sodium aluminate, sodium gluconate, and the like.

The alkaline solution may contain aluminum ions. The concentration of the alkaline agent in the alkaline solution is preferably 0.01% by mass or more and more preferably 3% by mass or more. In addition, the concentration is preferably 30% by mass or less and more preferably 25% by mass or less.

The temperature of the alkaline solution is preferably equal to or more than room temperature and more preferably 30°C or more. In addition, the temperature is preferably 80°C or less and more preferably 75°C or less.

The etching amount is preferably 0.01 g/m² or more, and more preferably 0.05 g/m² or more. In addition, the etching amount is preferably 30 g/m² or less, and more preferably 20 g/m² or less.

The treatment time preferably is in a range of 2 seconds to 5 minutes depending on the etching amount. In view of improving productivity, the treatment time is more preferably 2 to 10 seconds.

In a case where the alkaline etching treatment is performed after the mechanical roughening treatment, in order to remove products generated by the alkaline etching treatment, the chemical etching treatment by using a low-temperature acidic solution (hereinafter, also called "desmutting treatment") is preferably performed.

The acid used in the acidic solution is not particularly limited, and examples thereof include sulfuric acid, nitric acid, and hydrochloric acid. The concentration of the acidic solution is preferably 1% to 50% by mass. The temperature of the acidic solution is preferably 20°C to 80°C. In a case where the concentration and temperature of the acidic solution are in this range, the lithographic printing plate using an aluminum support is more resistant to dot-like stain.

Examples of preferred aspects of the roughening treatment step are as below.

### -Aspect SA-

An aspect in which the following treatments (1) to (8) are performed in this order.
(1) Chemical etching treatment using alkaline aqueous solution (first alkaline etching treatment)
(2) Chemical etching treatment using acidic aqueous solution (first desmutting treatment)
(3) Electrochemical roughening treatment using aqueous solution containing nitric acid as main component (first electrochemical roughening treatment)
(4) Chemical etching treatment using alkaline aqueous solution (second alkaline etching treatment)
(5) Chemical etching treatment using acidic aqueous solution (second desmutting treatment)
(6) Electrochemical roughening treatment using aqueous solution containing hydrochloric acid as main component (second electrochemical roughening treatment)
(7) Chemical etching treatment using alkaline aqueous solution (third alkaline etching treatment)
(8) Chemical etching treatment using acidic aqueous solution (third desmutting treatment)

### -Aspect SB-

An aspect in which the following treatments (11) to (15) are performed in this order.
(11) Chemical etching treatment using alkaline aqueous solution (fourth alkaline etching treatment)
(12) Chemical etching treatment using acidic aqueous solution (fourth desmutting treatment)
(13) Electrochemical roughening treatment using aqueous solution containing hydrochloric acid as main component (third electrochemical roughening treatment)
(14) Chemical etching treatment using alkaline aqueous solution (fifth alkaline etching treatment)
(15) Chemical etching treatment using acidic aqueous solution (fifth desmutting treatment)

As necessary, a mechanical roughening treatment may be performed before the treatment (1) of the aspect SA or before the treatment (11) of the aspect SB.

The amount of the aluminum plate dissolved by the first alkaline etching treatment and the fourth alkaline etching treatment is preferably 0.5 g/m² to 30 g/m² and more preferably 1.0 g/m² to 20 g/m².

Examples of the aqueous solution containing nitric acid as a main component used in the first electrochemical roughening treatment of the aspect SA include aqueous solutions used in the electrochemical roughening treatment using direct current or alternating current. Examples thereof include an aqueous solution obtained by adding aluminum nitrate, sodium nitrate, ammonium nitrate, or the like to a 1 g/L to 100 g/L aqueous nitric acid solution.

Examples of the aqueous solution containing hydrochloric acid as a main component used in the second electrochemical roughening treatment of the aspect SA and in the third electrochemical roughening treatment of the aspect SB include aqueous solutions used in the electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, or ammonium nitrate; or hydrochloric acid ions such as aluminum chloride, sodium chloride, or ammonium chloride may be further added to the aqueous solution.

As the waveform of an alternating current power source for the electrochemical roughening treatment, a sine wave, a square wave, a trapezoidal wave, a triangular wave, or the like can be used. The frequency is preferably 0.1 Hz to 250 Hz.

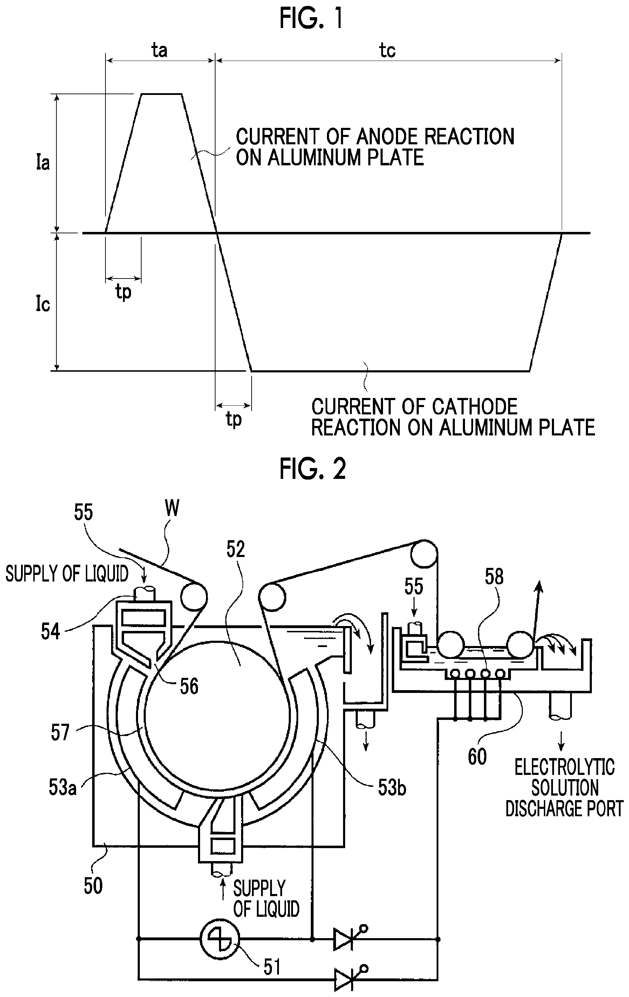

FIG. 1 is a graph showing an example of waveform diagram of alternating waveform current used for an electrochemical roughening treatment.

In FIG. 1, ta represents an anodic reaction time, tc represents a cathodic reaction time, tp represents the time taken for current to reach a peak from 0, Ia represents the peak current on the anodic cycle side, and Ic represents the peak current on the cathodic cycle side. For a trapezoidal wave, the time tp taken for current to reach a peak from 0 is preferably 1 msec to 10 msec. Regarding the conditions of one cycle of alternating current used for the electrochemical roughening treatment, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 msec to 1,000 msec. The peak current density of the trapezoidal wave is preferably 10 to 200 A/dm² at both the anodic cycle side Ia and the cathodic cycle side Ic of the current. Ic/Ia is preferably 0.3 to 20. At a point in time when the electrochemical roughening treatment has ended, the total quantity of electricity that participates in the anodic reaction of the aluminum plate is preferably 25 C/dm² to 1,000 C/dm².

The electrochemical roughening treatment using alternating current can be performed using the device shown in FIG. 2.

FIG. 2 is a lateral view showing an example of a radial cell in an electrochemical roughening treatment using alternating current.

In FIG. 2, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic solution channel, 58 represents an auxiliary anode, 60 represents an auxiliary anode cell, and W represents an aluminum plate. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution channel 57 between the radial drum roller 52 and the main poles 53a and 53b through the slit 56. The aluminum plate W treated in the main electrolytic cell 50 is then electrolyzed in the auxiliary anode cell 60. In the auxiliary anode cell 60, the auxiliary anode 58 is disposed to face the aluminum plate W. The electrolytic solution 55 is supplied to flow in the space between the auxiliary anode 58 and the aluminum plate W.

In view of easily manufacturing a predetermined lithographic printing plate precursor, the amount of the aluminum plate dissolved by the second alkaline etching treatment is preferably 1.0 g/m² to 20 g/m² and more preferably 2.0 g/m² to 10 g/m².

In view of easily manufacturing a predetermined lithographic printing plate precursor, the amount of the aluminum plate dissolved by the third alkaline etching treatment and the fifth alkaline etching treatment is preferably 0.01 g/m² to 0.8 g/m² and more preferably 0.05 g/m² to 0.3 g/m².

In the chemical etching treatment (first to fifth desmutting treatments) using an acidic aqueous solution, an acidic aqueous solution containing phosphoric acid, nitric acid, sulfuric acid, chromic acid, hydrochloric acid, or a mixed acid consisting of two or more of these acids is suitably used.

The concentration of the acid in the acidic aqueous solution is preferably 0.5% by mass to 60% by mass.

### <Anodization treatment step>

The anodization treatment step is a step of performing an anodization treatment on the aluminum plate having undergone the roughening treatment such that an aluminum oxide film is formed on the surface of the aluminum plate. By the anodization treatment, an anodic oxide film of aluminum having micropores is formed on the surface of the aluminum plate.

The anodization treatment can be performed according to the method known in the field of the related art, by appropriately setting manufacturing conditions in consideration of the desired micropore shape.

In the anodization treatment step, an aqueous solution of sulfuric acid, phosphoric acid, oxalic acid, or the like can be mainly used as an electrolytic solution. In some cases, an aqueous solution or a non-aqueous solution of chromic acid, sulfamic acid, benzenesulfonic acid, or the like or an aqueous solution or a non-aqueous solution containing two or more acids among the above acids can also be used. In a case where direct current or alternating current is applied to the aluminum plate in the electrolytic solution, an anodic oxide film can be formed on the surface of the aluminum plate. The electrolytic solution may contain aluminum ions. The content of the aluminum ions is not particularly limited, and is preferably 1 to 10 g/L.

The conditions of the anodization treatment are appropriately set depending on the electrolytic solution used. Generally, the concentration of the electrolytic solution of 1% to 80% by mass (preferably 5% to 20% by mass), the liquid temperature of 5°C to 70°C (preferably 10°C to 60°C), the current density of 0.5 to 60 A/dm² (preferably 5 to 50 A/dm²), the voltage of 1 to 100 V (preferably 5 to 50 V), and the electrolysis time of 1 to 100 seconds (preferably 5 to 60 seconds) are appropriate.

One of the preferred examples of the anodization treatment is the anodization method described in British Patent 1,412,768, which is performed in a sulfuric acid at a high current density.

The anodization treatment can also be performed multiple times. It is possible to change one or more of conditions, such as the type, concentration, and liquid temperature of the electrolytic solution used in each anodization treatment, the current density, the voltage, and the electrolysis time. In a case where the anodization treatment is performed twice, sometimes the firstly performed anodization treatment is called first anodization treatment, and the secondly performed anodization treatment is called second anodization treatment. Performing the first anodization treatment and the second anodization treatment makes it possible to form anodic oxide films having different shapes and to provide a lithographic printing plate precursor having excellent printing performance.

Furthermore, it is also possible to perform the following pore widening treatment after the anodization treatment and then perform the anodization treatment again. In this case, the first anodization treatment, the pore widening treatment, and the second anodization treatment are performed.

Using the method of performing the first anodization treatment, the pore widening treatment, and the second anodization treatment makes it possible to form micropores each configured with a large-diameter pore portion that extends from the surface of the anodic oxide film along the depth direction and a small-diameter pore portion that is in communication with the bottom portion of the large-diameter pore portion and extends from the communicate position along the depth direction.

### <Pore widening treatment step>

The pore widening treatment step is a treatment of enlarging the diameter of micropores (pore diameter) present in the anodic oxide film formed by the aforementioned anodization treatment step (pore diameter enlarging treatment). By the pore widening treatment, the diameter of the micropores is enlarged, and an anodic oxide film having micropores having a larger average diameter is formed.

The pore widening treatment can be carried out by bringing the aluminum plate obtained by the anodization treatment step into contact with an aqueous acid solution or an alkaline aqueous solution. The contact method is not particularly limited, and examples thereof include a dipping method and a spraying method. Among these, a dipping method is preferable.

In a case where an alkaline aqueous solution is used in the pore widening treatment step, it is preferable to use at least one alkaline aqueous solution selected from the group consisting of sodium hydroxide, potassium hydroxide, and lithium hydroxide. The concentration of the alkaline aqueous solution is preferably 0.1% to 5% by mass. As a proper treatment method, the pH of the alkaline aqueous solution is adjusted to 11 to 13, and the aluminum plate is brought into contact with the alkaline aqueous solution for 1 to 300 seconds (preferably 1 to 50 seconds) under the condition of 10°C to 70°C (preferably 20°C to 50°C). At this time, the alkaline treatment liquid may contain a metal salt of a polyvalent weak acid such as carbonate, borate, or phosphate.

In a case where an aqueous acid solution is used in the pore widening treatment step, it is preferable to use an aqueous solution of an inorganic acid such as sulfuric acid, phosphoric acid, nitric acid, or hydrochloric acid, or a mixture of these. The concentration of the aqueous acid solution is preferably 1% to 80% by mass, and more preferably 5% to 50% by mass. As a proper treatment method, the aluminum plate is brought into contact with the aqueous acid solution for 1 to 300 seconds (preferably 1 to 150 seconds) under the condition of a liquid temperature of the aqueous acid solution of 5°C to 70°C (preferably 10°C to 60°C).

The alkaline aqueous solution or the aqueous acid solution may contain aluminum ions. The content of the aluminum ions is not particularly limited, and is preferably 1 to 10 g/L.

The manufacturing method of the aluminum support having an anodic oxide film may include a hydrophilic treatment step of performing a hydrophilic treatment after the pore widening treatment step described above. As the hydrophilic treatment, it is possible to use the known method described in paragraphs "0109" to "0114" of JP2005-254638A.

The hydrophilic treatment is preferably performed by a method of immersing the aluminum plate in an aqueous solution of an alkali metal silicate such as sodium silicate or potassium silicate, a method of coating the aluminum plate with a hydrophilic vinyl polymer or a hydrophilic compound to form a hydrophilic undercoat layer, or the like.

The hydrophilic treatment using an aqueous solution of an alkali metal silicate such as sodium silicate or potassium silicate can be performed according to the method and procedure described in US2714066A and US3181461A.

### [Image-recording layer]

The image-recording layer contains a color-forming compound having a group that cleaves by infrared exposure, a polymerization initiator, a polymerizable compound, and a hydrogen-donating compound.

### [Color-forming compound having group that cleaves by infrared exposure]

The image-recording layer in the lithographic printing plate precursor according to the present invention contains a color-forming compound having a group that cleaves by infrared exposure (hereinafter, also referred to as "color-forming compound").

The color-forming compound contained in the image-recording layer is preferably an infrared absorber having a function of absorbing infrared rays and decomposing and coloring by infrared exposure.

The decomposition represents that the group that cleaves by infrared exposure cleaves.

"Developing color" mentioned herein means that absorption that substantially does not occur in the visible light region (wavelength range of 400 nm or longer and shorter than 750 nm) before exposure to infrared occurs in the visible light region by exposure to infrared. "Developing color" also describes a case where absorption that occurs in a wavelength range shorter than the visible light region also occurs in a longer wavelength range such as the visible light region.

Hereinafter, the colored compound formed by the color-forming compound absorbing infrared rays and decomposing by the infrared exposure is also referred to as a "color-forming substance of the color-forming compound".

In addition, the color-forming compound preferably has a function of absorbing infrared rays and converting the absorbed infrared rays into heat by the infrared exposure.

The decomposable infrared absorber is not limited as long as the agent absorbs at least a part of light in the infrared wavelength range (wavelength of 750 nm to 1 mm) and is decomposed, and an infrared absorber having a maximum absorption in a wavelength range of 750 nm to 1400 nm is preferable.

The color-forming compound is preferably an infrared absorber that decomposes due to heat, electron movement, or both caused by the infrared exposure, and more preferably an infrared absorber that decomposes due to electron movement caused by the infrared exposure. Here, the expression of "decomposed due to electron transfer" indicates that electrons excited to LUMO (lowest unoccupied molecular orbital) from HOMO (highest occupied molecular orbital) of the decomposable infrared absorber by infrared exposure show intramolecular electron transfer to an electron-accepting group (a group having a potential close to that of LUMO) in a molecule and decomposition occurs accordingly.

From the viewpoint of color formability and UV printing durability of the obtained lithographic printing plate, the color-forming compound is preferably a cyanine coloring agent that decomposes by infrared exposure.

From the viewpoint of color formability and UV printing durability of the obtained lithographic printing plate, the color-forming compound is more preferably a cyanine coloring agent represented by Formula 1.

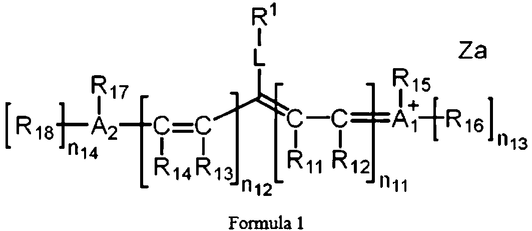

In Formula 1, R¹ represents a group having an R¹-L bond that cleaves by the infrared exposure, R₁₁ to R₁₈ each independently represent a hydrogen atom, a halogen atom, -Ra, -ORb, -SRc, or -NRdRe, Ra to Re each independently represent a hydrocarbon group, A₁, A₂, and a plurality of R₁₁'s to R₁₈'s may be linked to each other to form a monocycle or a polycycle, A₁ and A₂ each independently represent an oxygen atom, a sulfur atom, or a nitrogen atom, n₁₁ and n₁₂ each independently represent an integer of 0 to 5, where a total of n₁₁ and n₁₂ is 2 or greater, n₁₃ and n₁₄ each independently represent 0 or 1, L represents an oxygen atom, a sulfur atom, or -NR¹⁰-, R¹⁰ represents a hydrogen atom, an alkyl group, or an aryl group, and Za represents a counterion that neutralizes charge.

In a case where the cyanine coloring agent represented by Formula 1 is exposed to infrared rays, the R¹-L bond cleaves, and L is =O, =S, or =NR¹⁰, and a color-forming substance of the color-forming compound is formed. R¹ is liberated and forms a radical or ionic substance. These contribute to the polymerization of the polymerizable compound contained in the image recording layer.

In Formula 1, it is preferable that R₁₁ to each independently represent a hydrogen atom, -Ra, -ORb, -SRc, or -NRdRe.

As the hydrocarbon groups represented by Ra to Re, a hydrocarbon group having 1 to 30 carbon atoms (the number of carbon atoms) is preferable, a hydrocarbon group having 1 to 15 carbon atoms is more preferable, and a hydrocarbon group having 1 to 10 carbon atoms is still more preferable. The hydrocarbon group may be linear or branched or may have a ring structure.

R₁₁ to R₁₄ in Formula 1 each independently represent preferably a hydrogen atom or a hydrocarbon group, more preferably a hydrogen atom or an alkyl group, and still more preferably a hydrogen atom.

Each of R₁₁ and R₁₃ bonded to the carbon atom that is bonded to the carbon atom to which L is bonded is preferably an alkyl group. It is more preferable that R₁₁ and R₁₃ be linked to each other to form a ring. The formed ring is preferably a 5- or 6-membered ring, and more preferably a 5-membered ring.

R₁₂ bonded to the carbon atom to which A₁+ is bonded and R₁₄ bonded to the carbon atom to which A₂ is bonded are preferably linked to R₁₅ and R₁₇ respectively so as to form a ring.

It is preferable that R₁₅ in Formula 1 represents a hydrocarbon group. Furthermore, it is preferable that R₁₅ and R₁₂ bonded to the carbon atom to which A₁+ is bonded be linked to each other to form a ring. As the ring to be formed, an indolium ring, a pyrylium ring, a thiopyrylium ring, a benzoxazoline ring, or a benzoimidazoline ring is preferable. Among these, from the viewpoint of the color formability, an indolium ring is more preferable.

It is preferable that R₁₇ in Formula 1 represents a hydrocarbon group. Furthermore, it is preferable that R₁₇ and R₁₄ bonded to the carbon atom to which A₂ is bonded be linked to each other to form a ring. As the ring to be formed, an indole ring, a pyran ring, a thiopyran ring, a benzoxazole ring, or a benzimidazole ring is preferable. Among these, from the viewpoint of the color formability, an indole ring is more preferable.

It is preferable that R₁₅ and R₁₇ in Formula 1 represent the same group, and in a case where R₁₅ and R₁₇ each form a ring, it is preferable to form the same ring.

It is preferable that R₁₆ and R₁₈ in Formula 1 represent the same group.

Further, from the viewpoint of improving the water solubility of the compound represented by Formula 1, R₁₆ and each independently represent preferably an alkyl group containing a (poly)oxyalkylene group or an alkyl group having an anion structure, more preferably an alkyl group containing an alkoxyalkyl group, a carboxylate group, or a sulfonate group, and still more preferably an alkyl group containing a sulfonate group at the terminal. As the alkyl group, an alkyl group having 1 to 10 carbon atoms is preferable, and an alkyl group having 1 to 4 carbon atoms is more preferable.

The counter cation of the anion structure may be a cation that can be contained in R¹-L in Formula 1 or A₁+ or may also be an alkali metal cation or an alkaline earth metal cation.

The counter cation of the sulfonate group may be a cation that can be contained in R¹-L in Formula 1 or A₁+ or may also be an alkali metal cation or an alkaline earth metal cation.

Further, from the viewpoints of increasing the maximum absorption wavelength of the compound represented by Formula 1 and the color formability and the printing durability of the lithographic printing plate, it is preferable that R₁₆ and each independently represent an alkyl group or an alkyl group having an aromatic ring. As the alkyl group, an alkyl group having 1 to 10 carbon atoms is preferable, an alkyl group having 1 to 4 carbon atoms is more preferable, and a methyl group or an ethyl group is still more preferable. The alkyl group having an aromatic ring is preferably an alkyl group having an aromatic ring on a terminal, and more preferably a 2-phenylethyl group, a 2-naphthalenyl ethyl group, or a 2-(9-anthracenyl)ethyl group.

Both n₁₁ and n₁₂ in Formula 1 represent preferably an integer of 0 to 5, more preferably an integer of 1 to 3, still more preferably 1 or 2, and particularly preferably 2 at the same time.

A₁ and A₂ in Formula 1 each independently represent an oxygen atom, a sulfur atom, or a nitrogen atom and preferably a nitrogen atom.

It is preferable that both A₁ and A₂ in Formula 1 represent the same atom at the same time.

Za in Formula 1 represents a counterion that neutralizes charge. In a case where Za represents an anionic species, examples thereof include a sulfonate ion, a carboxylate ion, a tetrafluoroborate ion, a hexafluorophosphate ion, a hexafluoroantimonate ion, a p-toluenesulfonate ion, and a perchlorate ion. Among these, a hexafluorophosphate ion or a hexafluoroantimonate ion is preferable. In a case where Za represents a cation species, examples thereof include an alkali metal ion, an alkaline earth metal ion, an ammonium ion, a pyridinium ion, sulfonium ion, and the like. Among these, a sodium ion, a potassium ion, an ammonium ion, a pyridinium ion or a sulfonium ion is preferable, and a sodium ion, a potassium ion, or an ammonium ion is more preferable.

R₁₁ to R₁₈ and R¹-L may have an anion structure or a cation structure, and in a case where all R₁₁ to R₁₈ and R¹-L represent a charge-neutral group, Za represents a monovalent counter anion. However, for example, in a case where R₁₁ to and R¹-L have two or more anion structures, Za may represent a counter cation.

Further, in a case where the cyanine coloring agent represented by Formula 1 is a charge-neutral structure in the entire compound, Za is not present.

In Formula 1, the group in which the R¹-L bond is cleaved by infrared exposure represented by R¹ will be described in detail below.

From the viewpoints of the color formability and the UV printing durability of the lithographic printing plate to be obtained, a cyanine coloring agent represented by Formula 2 is more preferable as the cyanine coloring agent decomposed by infrared exposure.

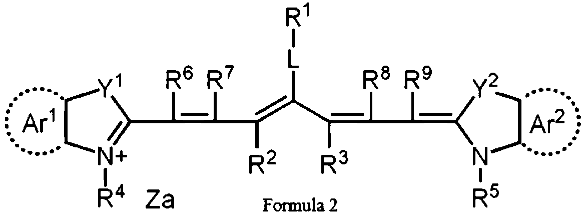

In Formula 2, R¹ represents a group having an R1-L bond that cleaves by the infrared exposure, R² and R³ each independently represent a hydrogen atom or an alkyl group and may be linked to each other to form a ring, Ar¹ and Ar² each independently represent a group that forms a benzene ring or a naphthalene ring, Y¹ and Y² each independently represent an oxygen atom, a sulfur atom, -NR⁰-, or a dialkylmethylene group, R⁰ represents a hydrogen atom, an alkyl group, or an aryl group, R⁴ and R⁵ each independently represent an aliphatic hydrocarbon group, a -CO₂M group, or a -PO₃M₂ group, M represents a hydrogen atom, a Na atom, a K atom, or an onium group, R⁶ to R⁹ each independently represent a hydrogen atom or an alkyl group, L represents an oxygen atom, a sulfur atom, or -NR¹⁰-, R¹⁰ represents a hydrogen atom, an alkyl group, or an aryl group, and Za represents a counterion that neutralizes charge.

The aliphatic hydrocarbon group of R⁴ and R⁵ is not particularly limited, but is preferably an alkyl group.

In Formula 2, as the alkyl group as R² to R⁹ and R⁰, an alkyl group having 1 to 30 carbon atoms is preferable, an alkyl group having 1 to 15 carbon atoms is more preferable, and an alkyl group having 1 to 10 carbon atoms is still more preferable. The alkyl group described above may be linear or branched, or may have a ring structure.

Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, or a butyl group is preferable.

The alkyl group described above may have a substituent. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and a group obtained by combining these groups.

As the aryl group represented by R⁰, an aryl group having 6 to 30 carbon atoms is preferable, an aryl group having 6 to 20 carbon atoms is more preferable, and an aryl group having 6 to 12 carbon atoms is still more preferable.

The above-described aryl group may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

Specific examples thereof include a phenyl group, a naphthyl group, a p-tolyl group, a p-chlorophenyl group, a p-fluorophenyl group, a p-methoxyphenyl group, a p-dimethylaminophenyl group, a p-methylthiophenyl group, and a p-phenylthiophenyl group.

Among these aryl groups, a phenyl group, a p-methoxyphenyl group, a p-dimethylaminophenyl group, or a naphthyl group is preferable.

It is preferable that R² and R³ be linked to each other to form a ring.

In a case where R² and R³ are linked to each other to form a ring, a 5-membered ring or a 6-membered ring is preferable, and a 5-membered ring is particularly preferable.

Y¹ and Y² each independently represent an oxygen atom, a sulfur atom, -NR⁰-, or a dialkylmethylene group, preferably -NR⁰- or a dialkylmethylene group, and more preferably a dialkylmethylene group.

R⁰ represents a hydrogen atom, an alkyl group, or an aryl group and preferably an alkyl group.

The alkyl group represented by R⁴ or R⁵ may be substituted alkyl. Examples of the substituted alkyl group represented by R⁴ or R⁵ include a group represented by any of Formula (a1) to Formula (a5).

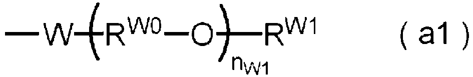

-R^{W2}-CO₂M ( a2 )

-R^{W3}-PO₃M₂ ( a3 )

-R^{W4}-SO₃M ( a4 )

-R^{W6}-R^{W7} (a5)

In Formulae (a1) to (a4), R^{W0} represents an alkylene group having 2 to 6 carbon atoms, W represents a single bond or an oxygen atom, n_{W1} represents an integer of 1 to 45, R^{W1} represents an alkyl group having 1 to 12 carbon atoms or -C(=O)-R^{W5}, R^{W5} represents an alkyl group having 1 to 12 carbon atoms, R^{W2} to R^{W4}, and R^{W6} each independently represent a single bond or an alkylene group having 1 to 12 carbon atoms, and M represents a hydrogen atom, a Na atom, a K atom, or an onium group.

R^{W7} represents an aryl group. The aryl group is the same as the aryl group of R⁰, and the same applies to the preferred range thereof.

In Formula (a1), specific examples of the alkylene group represented by R^{W0} include an ethylene group, an n-propylene group, an isopropylene group, an n-butylene group, an isobutylene group, an n-pentylene group, an isopentylene group, an n-hexyl group, and an isohexyl group. Among these, an ethylene group, an n-propylene group, an isopropylene group, or an n-butylene group is preferable, and an n-propylene group is particularly preferable.

n_{W1} is preferably 1 to 10, more preferably 1 to 5, and particularly preferably 1 to 3.

Specific examples of the alkyl group represented by R^{W1} include a methyl group, an ethyl group, a n-propyl group, an isopropyl group, a n-butyl group, an isobutyl group, a tert-butyl group, a n-pentyl group, an isopentyl group, a neopentyl group, a n-hexyl group, a n-octyl group, a n-dodecyl group, and the like. Among these, a methyl group, an ethyl group, a n-propyl group, an isopropyl group, a n-butyl group, and a tert-butyl group are preferable, a methyl group and an ethyl group are more preferable, and a methyl group is particularly preferable.

The alkyl group represented by R^{W5} is the same as the alkyl group represented by R^{W1}. Preferred aspects of the alkyl group represented by R^{W5} are the same as preferred aspects of the alkyl group represented by R^{W1}.

Specific examples of the group represented by Formula (a1) will be shown below. However, the present invention is not limited thereto. In the following structural formulas, Me represents a methyl group, Et represents an ethyl group, and * represents a bonding site.

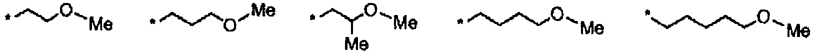

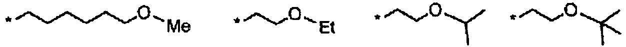

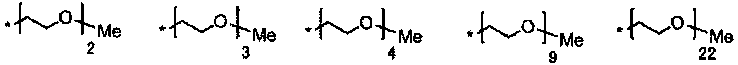

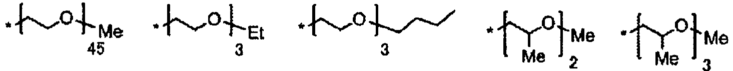

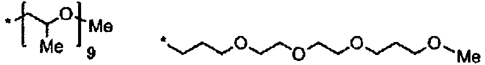

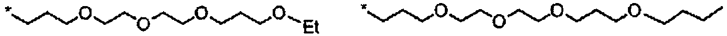

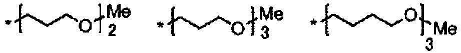

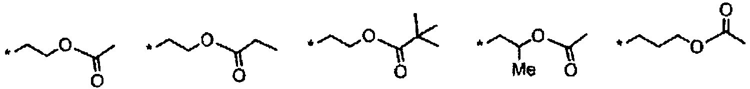

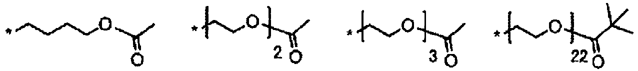

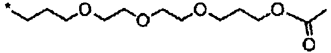

In Formulae (a2) to (a5), specific examples of the alkylene group represented by R^{W2} to R^{W4}, and R^{W6} include a methylene group, an ethylene group, an n-propylene group, an isopropylene group, an n-butylene group, an isobutylene group, an n-pentylene group, an isopentylene group, an n-hexyl group, an isohexyl group, an n-octylene group, and an n-dodecylene group. Among these, an ethylene group, an n-propylene group, an isopropylene group, or an n-butylene group is preferable, and an ethylene group or an n-propylene group is particularly preferable.

In Formula (a3), two Ms may be the same as or different from each other.

Examples of the onium group represented by M in Formula (a2) to Formula (a4) include an ammonium group, an iodonium group, a phosphonium group, a sulfonium group, and the like.

Among the groups represented by the Formulae (a1) to (a5), the group represented by Formula (a1) or Formula (a4) is preferable.

In Formula 2, it is preferable that R⁴ and R⁵ each represent an unsubstituted alkyl group. It is preferred that both R⁴ and R⁵ represent the same group.

R⁶ to R⁹ each independently represent a hydrogen atom or an alkyl group, and preferably each independently represent a hydrogen atom.

Ar¹ and Ar² each independently represent a group forming a benzene ring or a naphthalene ring. The benzene ring and the naphthalene ring may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, an acyloxy group, a phosphonic acid group, groups obtained by combining these, and the like. As the substituent, an alkyl group is preferable.

Further, from the viewpoints of increasing the maximum absorption wavelength of the compound represented by Formula 2 and the color formability and the printing durability of the lithographic printing plate, Ar¹ and Ar² each independently represent preferably a naphthalene ring or a group that forms a benzene ring containing an alkyl group or an alkoxy group as a substituent, more preferably a naphthalene ring or a group that forms a benzene ring containing an alkoxy group as a substituent, and particularly preferably a naphthalene ring or a group that forms a benzene ring containing a methoxy group as a substituent.

In Formula 2, it is preferable that Ar¹ or Ar² represents a group that forms a group represented by Formula (b1).

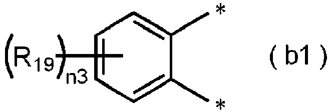

In Formula (b1), R¹⁹ represents an alkyl group having 1 to 12 carbon atoms. n3 represents an integer of 1 to 4. * Represents a binding site.

Za represents a counterion for neutralizing charge. Here, in a case where the compound represented by Formula 2 has a corresponding ionic substituent in the structure thereof and the neutralization of charge is not required, Za is not necessary. In a case where Za represents an anionic species, examples thereof include a sulfonate ion, a carboxylate ion, a tetrafluoroborate ion, a hexafluorophosphate ion, a hexafluoroantimonate ion, a p-toluenesulfonate ion, and a perchlorate ion. Among these, a hexafluorophosphate ion or a hexafluoroantimonate ion is preferable. In a case where Za represents a cationic species, examples thereof include an alkali metal ion, an alkaline earth metal ion, an ammonium ion, a pyridinium ion, and a sulfonium ion. Among these, a sodium ion, a potassium ion, an ammonium ion, a pyridinium ion, or a sulfonium ion is preferable, and a sodium ion, a potassium ion, or an ammonium ion is more preferable.

R¹ to R⁹, R⁰, Ar¹, Ar², Y¹, and Y² may have an anion structure or a cation structure, and in a case where all R¹ to R⁹, R⁰, Ar¹, Ar², Y¹, and Y² represent a charge-neutral group, Za represents a monovalent counter anion. However, for example, in a case where R¹ to R⁹, R⁰, Ar¹, Ar², Y¹, and Y² have two or more anion structures, Za may represent a counter cation.

In Formulae 1 and 2, the group represented by R¹, in which the R¹-L bond is cleaved by infrared exposure, will be described below.

In a case where L in Formula 1 or Formula 2 represents an oxygen atom, from the viewpoint of the color formability, R¹ represents preferably a group represented by any of Formulae (1-1) to (1-7) and more preferably a group represented by any of Formulae (1-1) to (1-3).

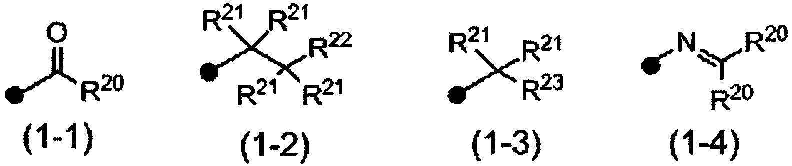

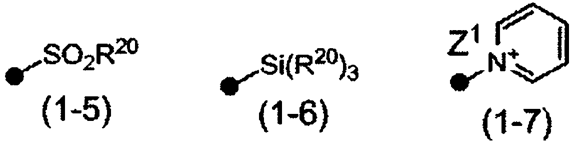

In Formulae (1-1) to (1-7), "•" represents a bonding site with respect to the oxygen atom represented by L in Formula 1 or Formula 2, R²⁰'s each independently represent a hydrogen atom, an alkyl group, an alkenyl group, an aryl group, -OR²⁴, -NR²⁵R²⁶, or -SR²⁷, R²¹'s each independently represent a hydrogen atom, an alkyl group, or an aryl group, R²² represents an aryl group, -OR²⁴, -NR²⁵R²⁶, -SR²⁷, -C(=O)R²⁸, -OC(=O)R²⁸, or a halogen atom, R²³ represents an aryl group, an alkenyl group, an alkoxy group, or an onium group, R²⁴ to R²⁷ each independently represent a hydrogen atom, an alkyl group, or an aryl group, R²⁸ represents an alkyl group, an aryl group, -OR²⁴, -NR²⁵R²⁶, or -SR²⁷, and Z¹ represents a counterion for neutralizing charge.

The preferred embodiment in a case where R²⁰, R²¹, and R²⁴ to R²⁸ represent an alkyl groups is the same as the preferred embodiment of the alkyl group as R² to R⁹ and R⁰.

The number of carbon atoms in the alkenyl group represented by R²⁰ and R²³ is preferably 1 to 30, more preferably 1 to 15, and even more preferably 1 to 10.

In a case where R²⁰ to R²⁸ each represent an aryl group, preferred aspects of the aryl group are the same as preferred aspects of the aryl group represented by R⁰.

From the viewpoint of the color formability, R²⁰ in Formula (1-1) represents preferably an alkyl group, an alkenyl group, an aryl group, -OR²⁴, -NR²⁵R²⁶, or -SR²⁷, more preferably an alkyl group, -OR²⁴, -NR²⁵R²⁶, or -SR²⁷, still more preferably an alkyl group or -OR²⁴, and particularly preferably -OR²⁴.

In a case where R²⁰ in Formula (1-1) represents an alkyl group, the alkyl group may be an alkyl group having an arylthio group, an alkyloxycarbonyl group, or an arylsulfonyl group at the α-position. The alkyl group is preferably an alkyl group having an arylthio group or an alkyloxycarbonyl group at the α-position.

In a case where R²⁰ in Formula (1-1) represents -OR²⁴, R²⁴ is preferably an alkyl group, more preferably an alkyl group having 1 to 8 carbon atoms, even more preferably an isopropyl group or a tert-butyl group, and particularly preferably a t-butyl group.

In a case where R²⁰ in Formula (1-1) represents an alkenyl group, the alkenyl group may be an alkenyl group having an aryl group or a hydroxyaryl group.

From the viewpoint of the color formability, it is preferable that R²¹ in Formula (1-2) represents a hydrogen atom.

Furthermore, from the viewpoint of color formability, R²² in Formula (1-2) is preferably -C(=O)OR²⁴, -OC(=O)OR²⁴, or a halogen atom, and more preferably -C(=O)OR²⁴ or -OC(=O)OR²⁴. In a case where R²² in Formula (1-2) is -C(=O)OR²⁴ or -OC(=O)OR²⁴, R²⁴ is preferably an alkyl group.

From the viewpoint of the color formability, it is preferable that R²¹'s in Formula (1-3) each independently represent a hydrogen atom or an alkyl group and more preferable that at least one R²¹ in Formula (1-3) represents an alkyl group.

The alkyl group represented by R²¹ is preferably an alkyl group having 1 to 10 carbon atoms, more preferably an alkyl group having 3 to 10 carbon atoms.

Furthermore, the alkyl group represented by R²¹ is preferably an alkyl group having a branched or ring structure, and more preferably an isopropyl group, a cyclopentyl group, a cyclohexyl group, or a tert-butyl group. In addition, the alkyl group represented by R²¹ is preferably a secondary or tertiary alkyl group.

From the viewpoint of color formability, R²³ in Formula (1-3) is preferably an aryl group, an alkoxy group, or an onium group, more preferably a p-dimethylaminophenyl group or a pyridinium group, and even more preferably a pyridinium group.

Examples of the onium group represented by R²³ include a pyridinium group, an ammonium group, a sulfonium group, and the like. The onium group may have a substituent. Examples of the substituent include an alkyl group, an aryl group, an alkoxy group, an aryloxy group, an amino group, an alkylthio group, an arylthio group, a halogen atom, a carboxy group, a sulfo group, an alkyloxycarbonyl group, an aryloxycarbonyl group, groups formed by combining these, and the like. Among these, an alkyl group, an aryl group, and groups formed by combining these are preferable.

Among these, a pyridinium group is preferable, an N-alkyl-3-pyridinium group, an N-benzyl-3-pyridinium group, an N-(alkoxypolyalkyleneoxyalkyl)-3-pyridinium group, an N-alkoxycarbonylmethyl-3-pyridinium group, an N-alkyl-4-pyridinium group, an N-benzyl-4-pyridinium group, an N-(alkoxypolyalkyleneoxyalkyl)-4-pyridinium group, an N-alkoxycarbonylmethyl-4-pyridinium group, or an N-alkyl-3,5-dimethyl-4-pyridinium group is more preferable, an N-alkyl-3-pyridinium group or an N-alkyl-4-pyridinium group is even more preferable, an N-methyl-3-pyridinium group, an N-octyl-3-pyridinium group, an N-methyl-4-pyridinium group, or an N-octyl-4-pyridinium group is particularly preferable, and an N-octyl-3-pyridinium group or an N-octyl-4-pyridinium group is most preferable.

Further, in a case where R²³ represents a pyridinium group, examples of the counter anion include a sulfonate ion, a carboxylate ion, a tetrafluoroborate ion, a hexafluorophosphate ion, a hexafluoroantimonate ion, a p-toluenesulfonate ion, and a perchlorate ion. Among these, a p-toluenesulfonate ion, a hexafluorophosphate ion, or a hexafluoroantimonate ion is preferable.

From the viewpoint of the color formability, it is preferable that R²⁰ in Formula (1-4) represents an alkyl group or an aryl group and more preferable that one of two R²⁰'s represents an alkyl group and the other represents an aryl group. These two R²⁰'s may be linked to each other to form a ring.

From the viewpoint of color formability, R²⁰ in Formula (1-5) is preferably an alkyl group or an aryl group, more preferably an aryl group, and even more preferably a p-methylphenyl group.

From the viewpoint of color formability, R²⁰ in Formula (1-6) preferably each independently represents an alkyl group or an aryl group, and more preferably each independently represents a methyl group or a phenyl group.

From the viewpoint of the color formability, Z¹ in Formula (1-7) may represent a counterion for neutralizing charge, and the entire compound may be included in Za.

Z¹ represents preferably a sulfonate ion, a carboxylate ion, a tetrafluoroborate ion, a hexafluorophosphate ion, a hexafluoroantimonate ion, a p-toluenesulfonate ion, or a perchlorate ion and more preferably a p-toluenesulfonate ion, a hexafluorophosphate ion, or a hexafluoroantimonate ion.

In a case where L in Formula 1 or 2 represents an oxygen atom, from the viewpoint of the color formability, it is more preferable that R¹ represents a group represented by Formula (5).

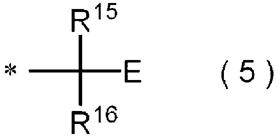

In Formula (5), R¹⁵ and R¹⁶ each independently represent a hydrogen atom, an alkyl group, or an aryl group, E represents an onium group, and "*" represents a bonding site with respect to the oxygen atom represented by L in Formula 1 or 2.

The alkyl group represented by R¹⁵ or R¹⁶ has the same definition as that for the alkyl group represented by R² to R⁹ and R⁰, and the preferred embodiment thereof is also the same as the preferred embodiment of the alkyl group represented by R² to R⁹ and R⁰.

The aryl group represented by R¹⁵ or R¹⁶ is the same as the aryl group represented by R⁰, and preferred aspects of the aryl group are the same as preferred aspects of the aryl group represented by R⁰.

The onium group represented by E is the same as the onium group represented by R²³, and preferred aspects of the onium group are the same as preferred aspects of the onium group represented by R²³.

As a preferred aspect, it is preferable that R¹⁵ represents a hydrogen atom and R¹⁶ represents an alkyl group.

In Formula (5), the onium group represented by E is preferably a pyridinium group represented by Formula (6).

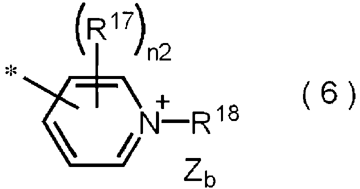

In Formula (6), R¹⁷ represents a halogen atom, an alkyl group, an aryl group, a hydroxyl group, or an alkoxy group. In a case where there is a plurality of R¹⁷'s in Formula (6), the plurality of R¹⁷'s may be the same as each other or linked to each other to form a ring. n2 represents an integer of 0 to 4. R¹⁸ represents an alkyl group, an aryl group, or an aralkyl group. Z_{b} represents a counterion for neutralizing charge.

The alkyl group or the aryl group represented by R¹⁷ or R¹⁸ is the same as the alkyl group represented by R² to R⁹ and R⁰ or the aryl group represented by R⁰. Preferred aspects of the alkyl group or the aryl group represented by R¹⁷ or R¹⁸ are the same as preferred aspects of the alkyl group represented by R² to R⁹ and R⁰ or the aryl group represented by R⁰.

The alkoxy group represented by R¹⁷ is preferably an alkoxy group having 1 to 10 carbon atoms. Examples thereof include a methoxy group, an ethoxy group, a n-propoxy group, an isopropoxy group, a n-butoxy group, an isobutoxy group, a tert-butoxy group, and the like.

The aralkyl group in R¹⁸ is preferably an aralkyl group having 7 to 31 carbon atoms, more preferably an aralkyl group having 7 to 21 carbon atoms, and still more preferably an aralkyl group having 7 to 13 carbon atoms.

Specific examples of the aralkyl group include a benzyl group.

The aralkyl group may have a substituent. Examples of the substituent include an alkyl group, an alkoxy group, and a group formed by a combination of these groups.

R¹⁸ preferably represents an alkyl group or an aralkyl group.

n2 is preferably 0.

The counterion represented by Z_{b} for neutralizing charge is the same as Z¹ in Formula (1-7). Preferred aspects of Z_{b} are the same as preferred aspects of Z¹ in Formula (1-7).

Hereinafter, in a case where L in Formula 1 or 2 represents an oxygen atom, specific examples of the group represented by R¹ are described below, but the present invention is not limited thereto. In the following structural formulae, TsO⁻ represents a tosylate anion, and "•" represents a bonding site with respect to an oxygen atom represented by L in Formula 1 or Formula 2.

Me represents methyl.

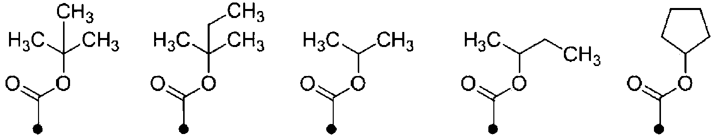

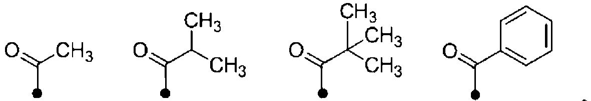

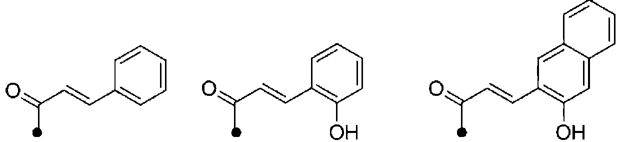

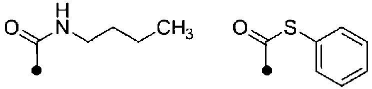

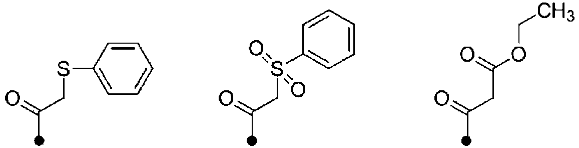

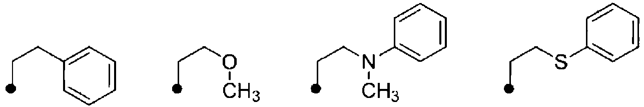

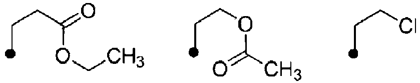

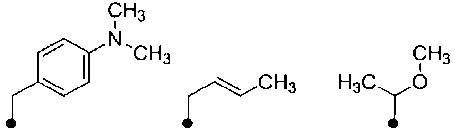

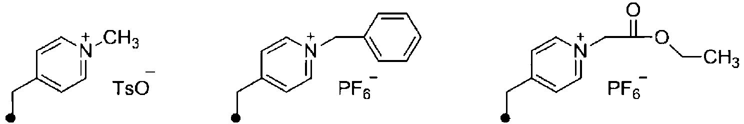

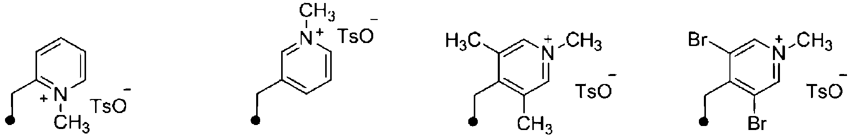

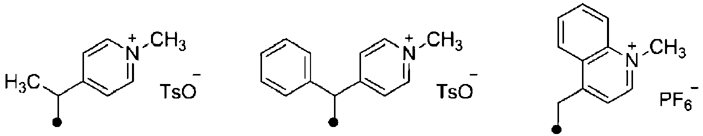

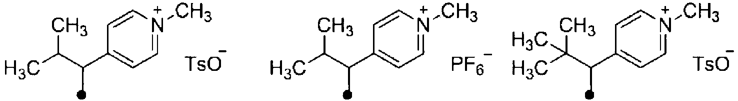

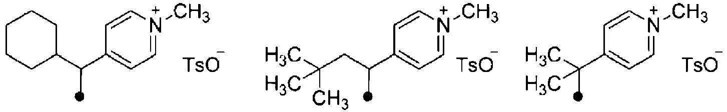

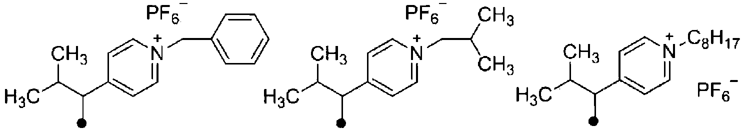

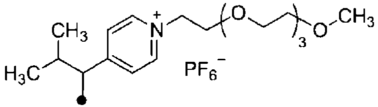

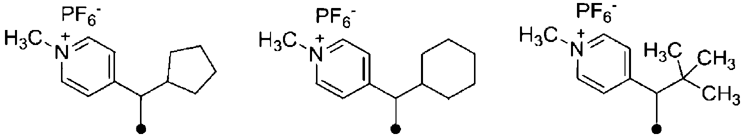

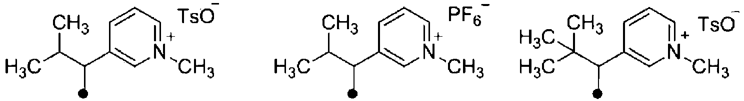

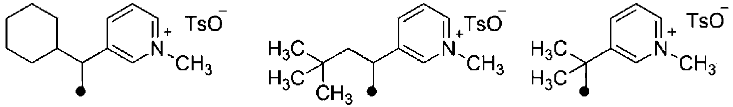

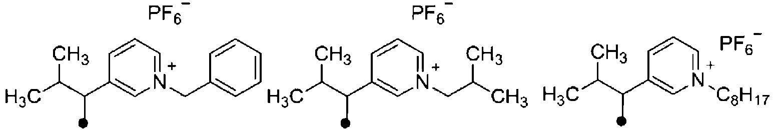

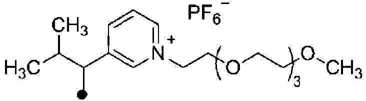

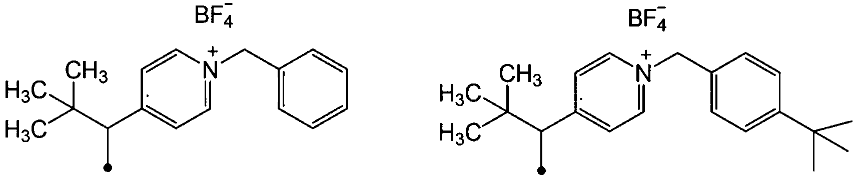

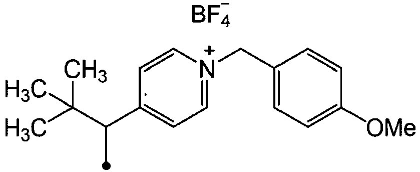

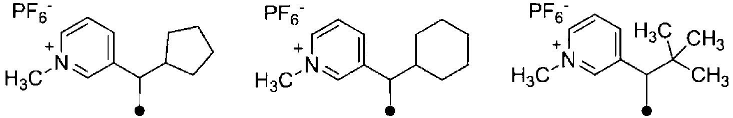

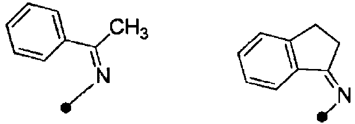

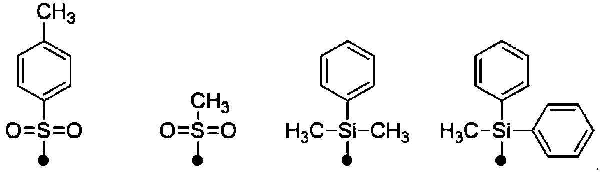

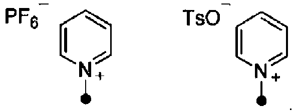

In a case where L represents an oxygen atom and R¹ represents an aryl group or a linear alkyl group, cleavage of the R¹-O bond due to infrared exposure does not occur.

In a case where L in Formula 1 or 2 represents a sulfur atom, it is preferable that R¹ represents a group represented by Formula (2-1).

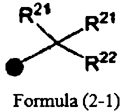

In Formula (2-1), "•" represents a bonding site with respect to the sulfur atom represented by L in Formula 1 or 2, R²¹'s each independently represent a hydrogen atom, an alkyl group, or an aryl group, and R²² represents an aryl group, an alkenyl group, an alkoxy group, or an onium group.

In a case where L in Formula 1 or 2 represents -NR¹⁰-, it is preferable that R¹ bonded to N represents a group represented by Formula (3-1).

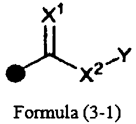

In Formula (3-1), "•" represents a bonding site with respect to a nitrogen atom contained in L in Formula 1 or 2, X¹ and X² each independently represent an oxygen atom or a sulfur atom, and Y represents a group represented by Formula (2-1).

What are described above regarding the alkyl group, the aryl group, the alkenyl group, the alkoxy group, and the onium group in Formula (1-1) to Formula (1-7) can be applied to the alkyl group, the aryl group, the alkenyl group, the alkoxy group, and the onium group represented by R²¹ and R²² in Formula (2-1).

In Formula 1 or 2, from the viewpoint of improving the printing durability, it is preferable that L represents a sulfur atom or -NR¹⁰- and R¹⁰ represents a hydrogen atom, an alkyl group, or an aryl group.

Specific examples of the compound represented by Formula 1 or Formula 2 will be described below, but the present invention is not limited thereto. In the following structural formulae, Ph represents phenyl.

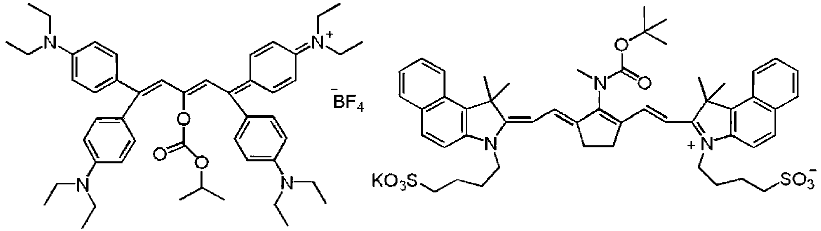

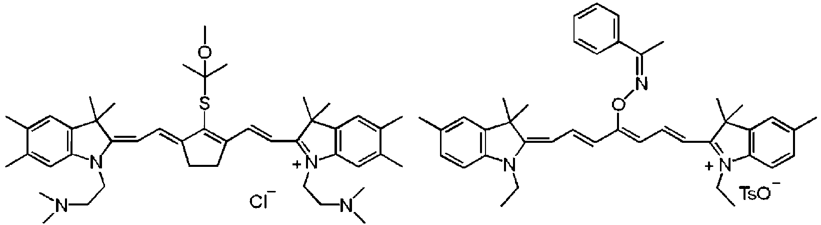

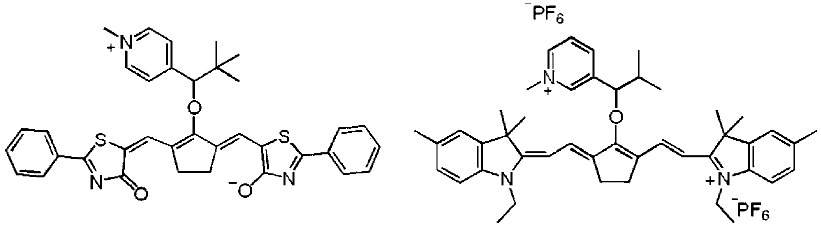

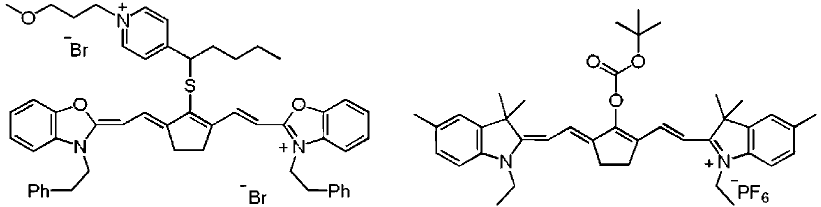

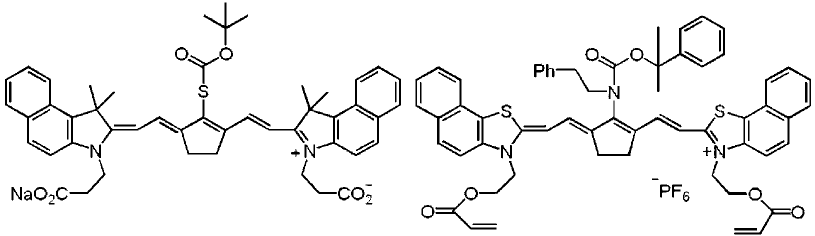

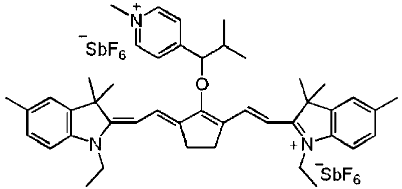

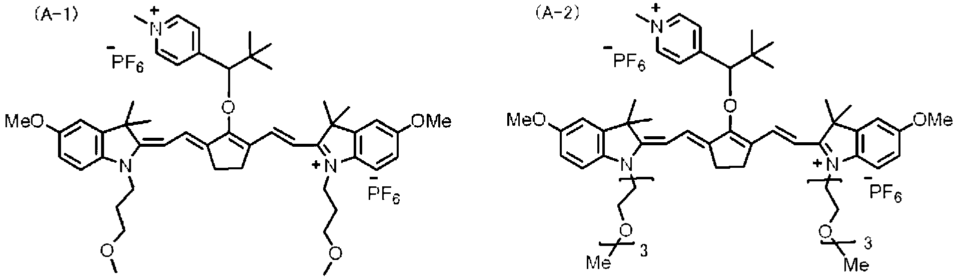

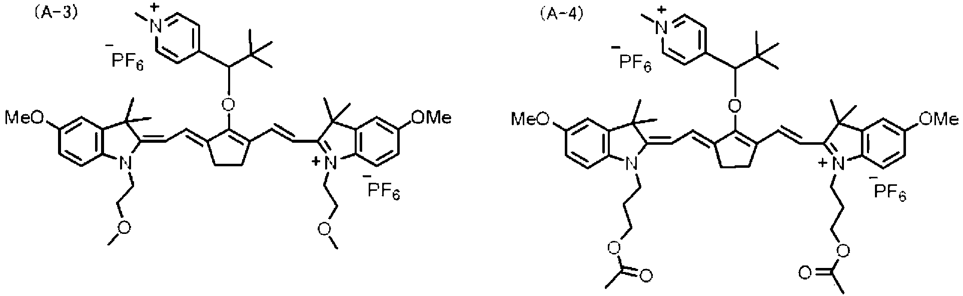

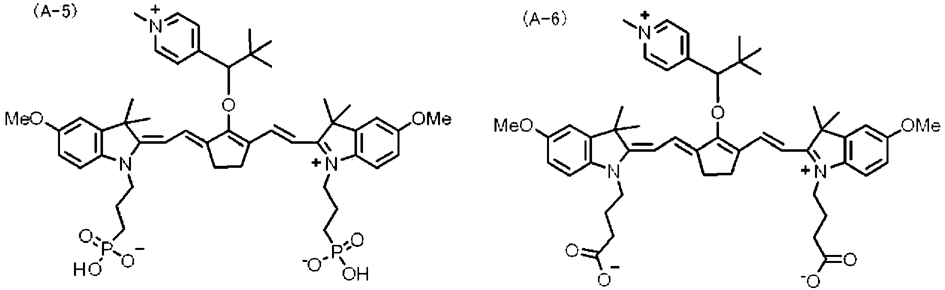

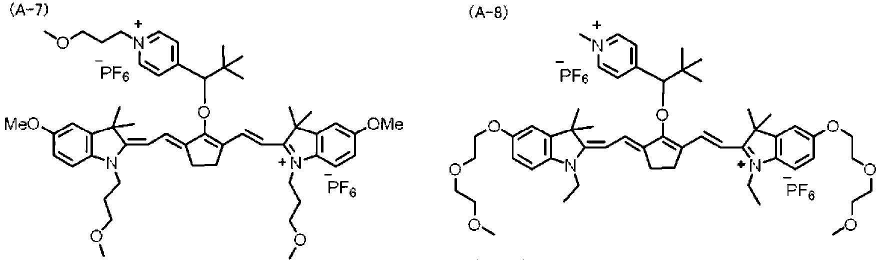

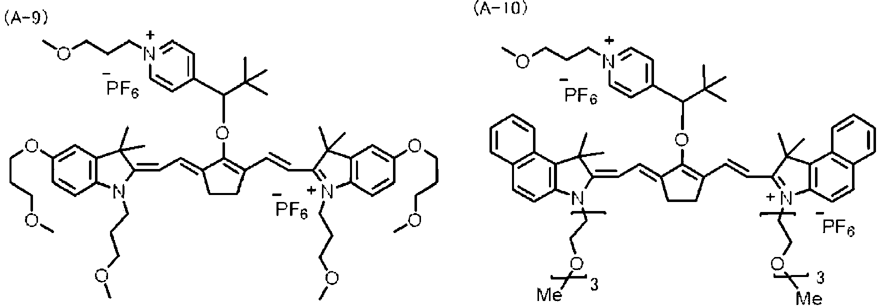

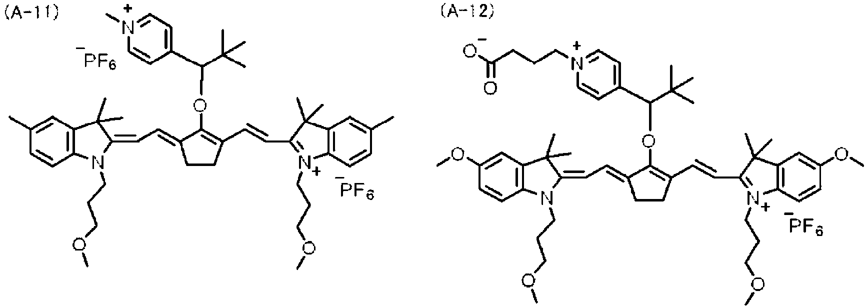

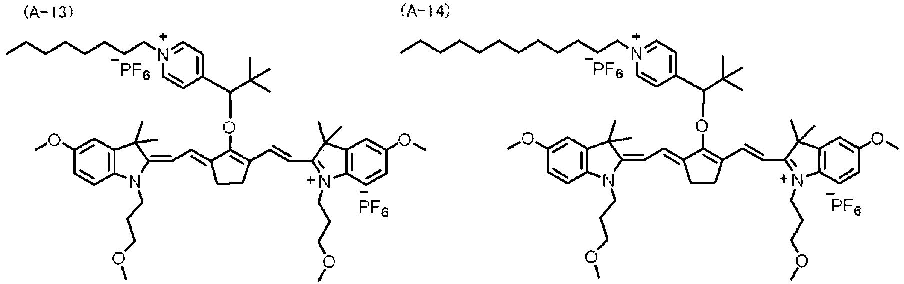

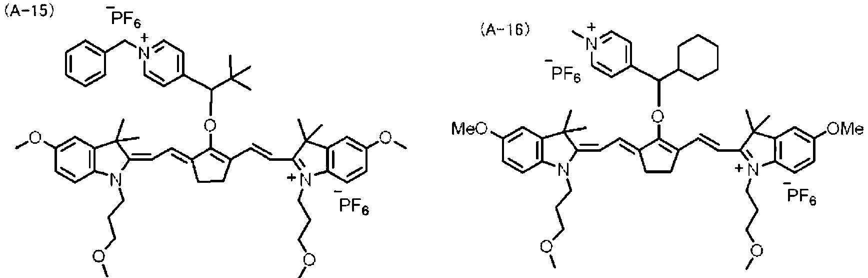

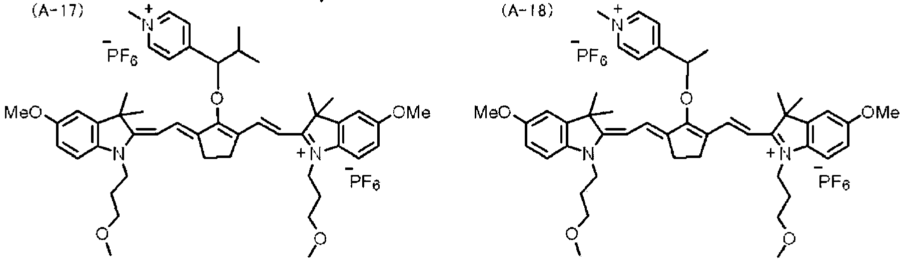

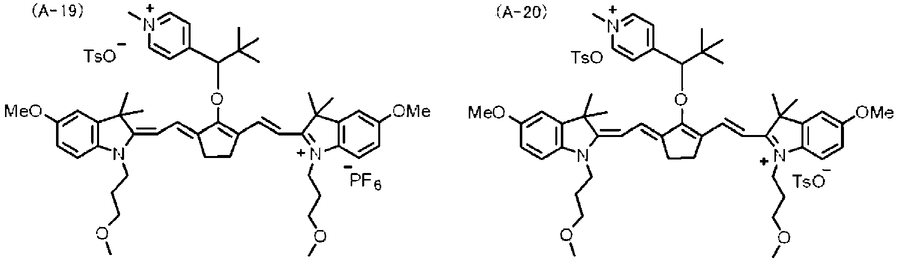

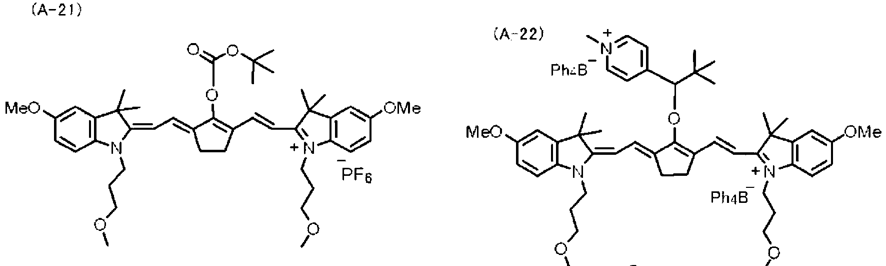

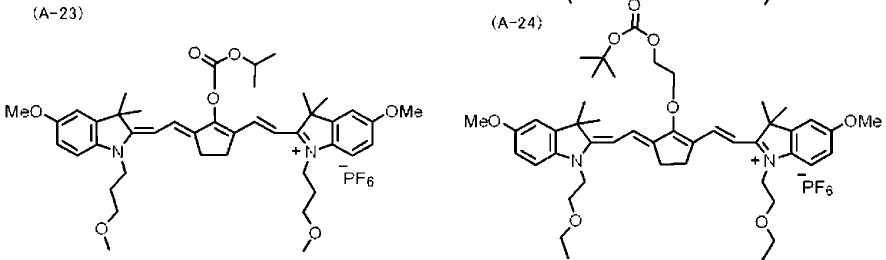

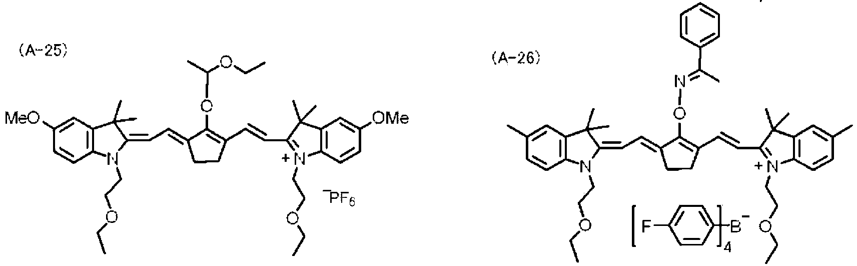

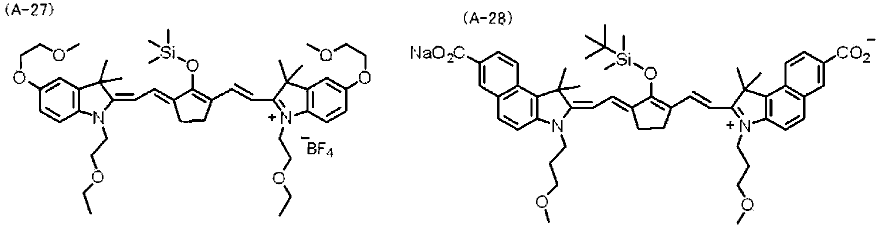

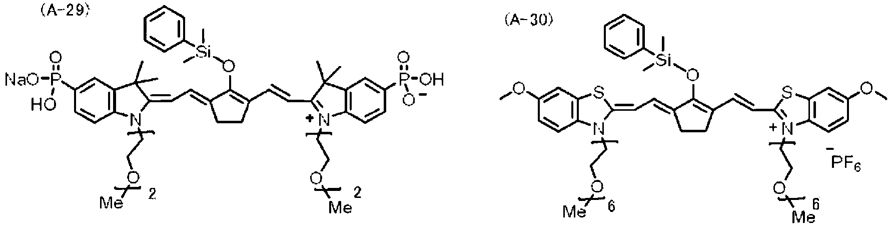

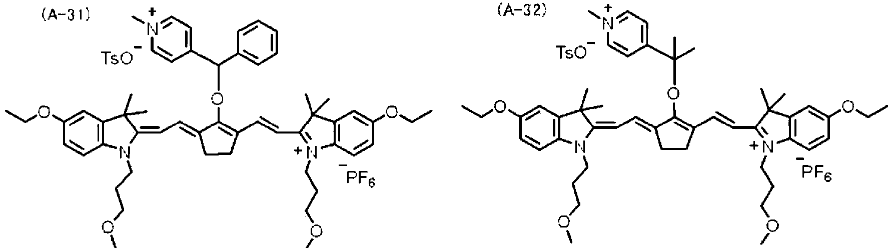

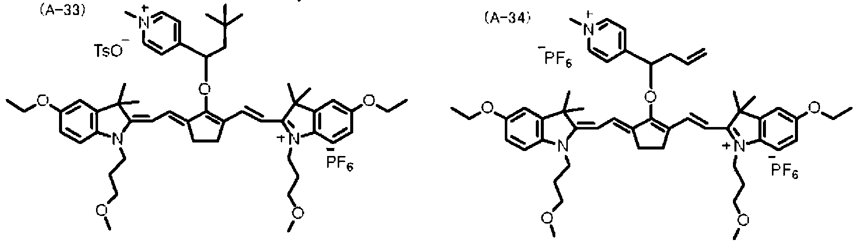

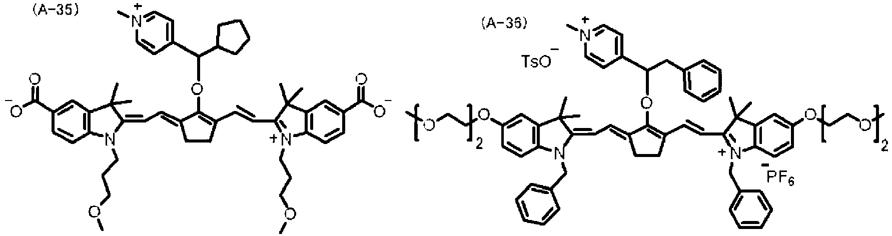

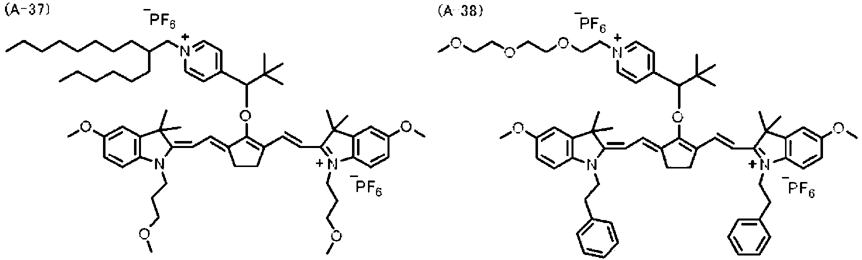

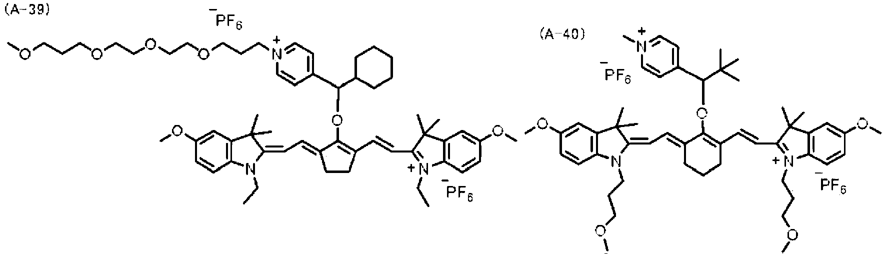

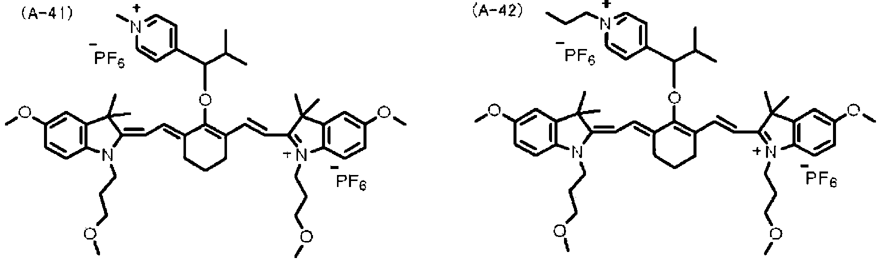

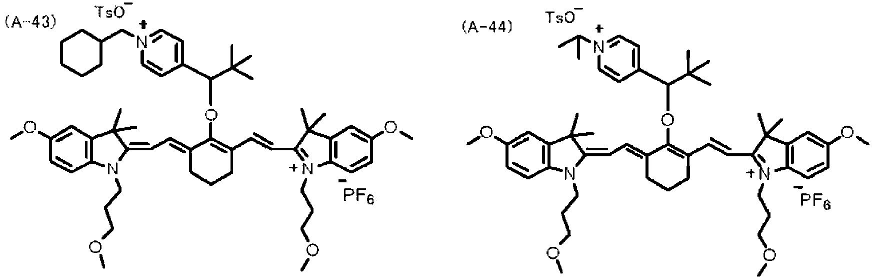

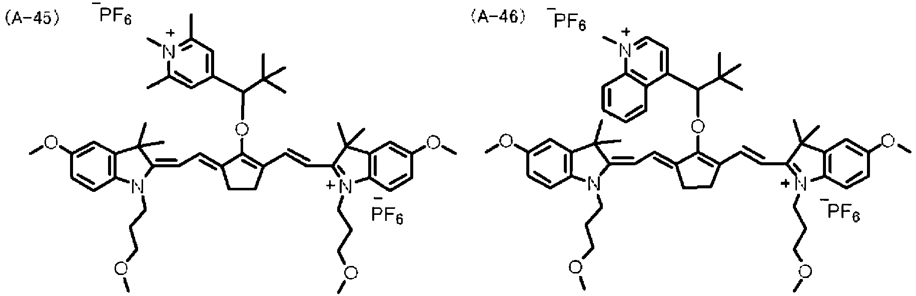

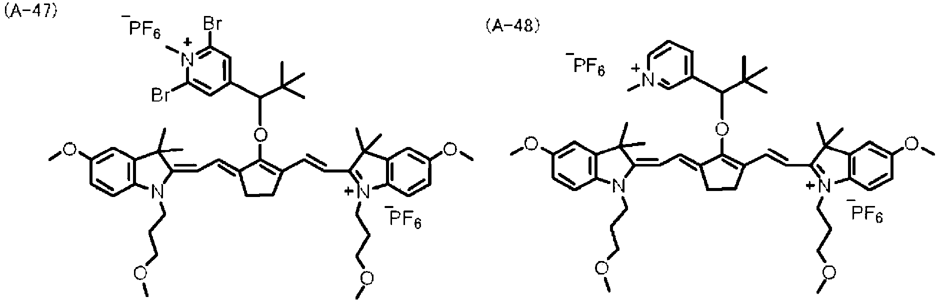

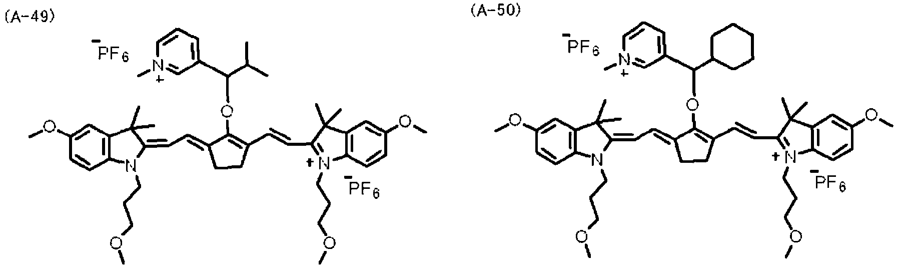

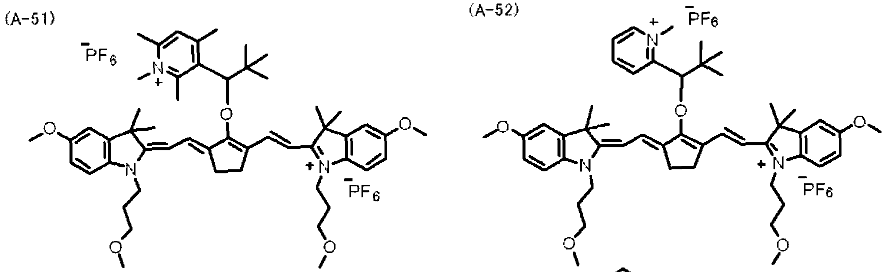

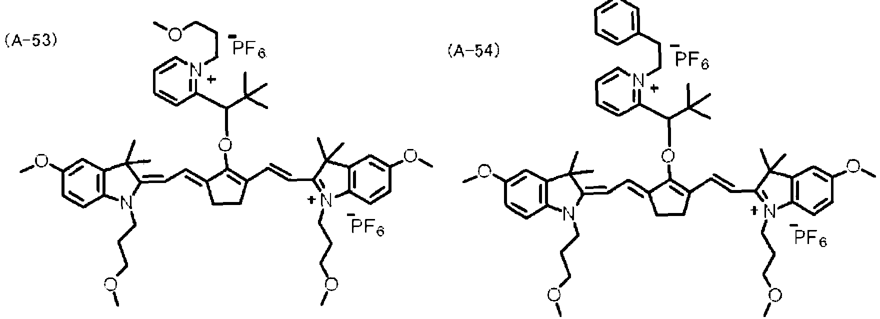

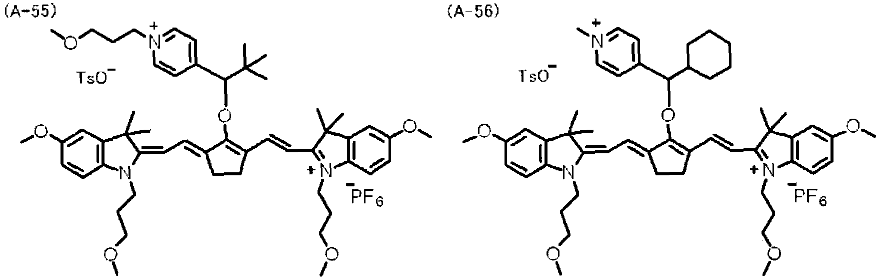

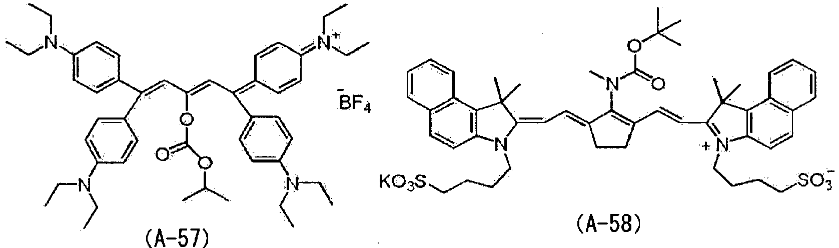

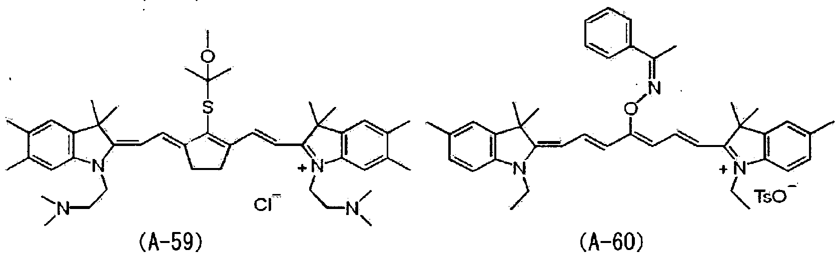

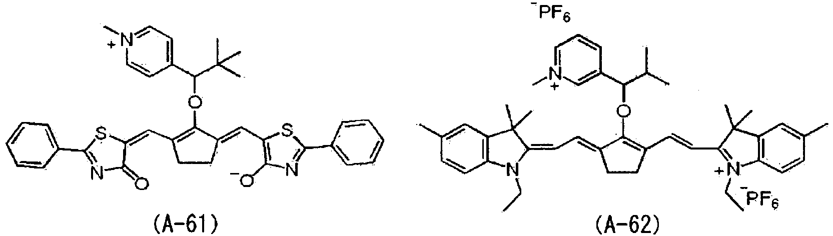

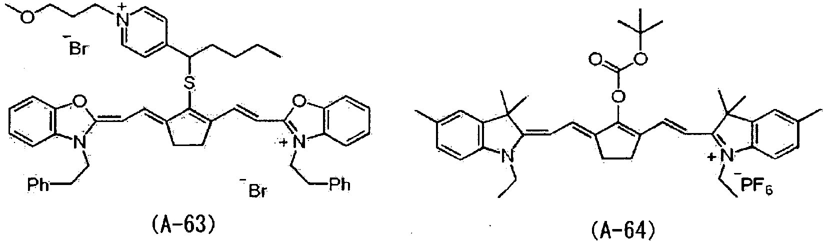

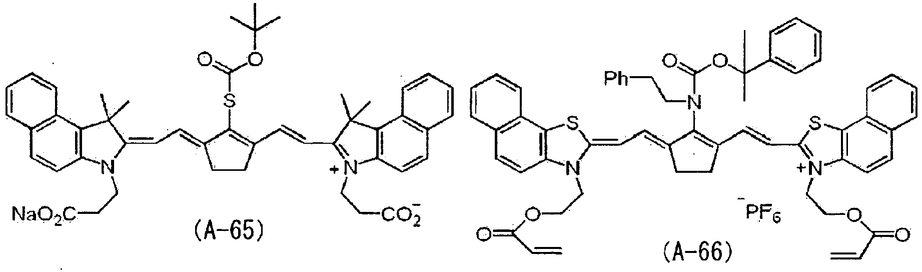

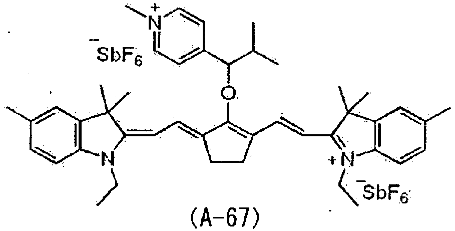

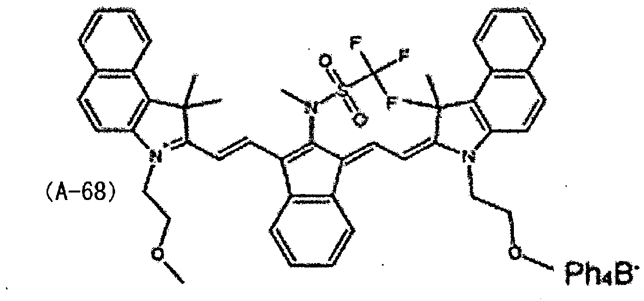

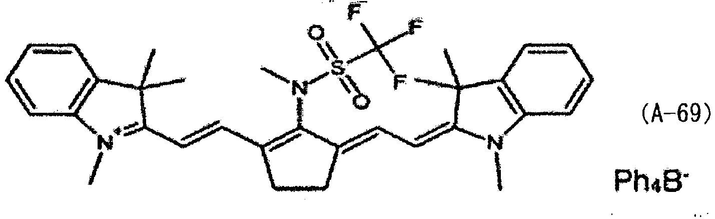

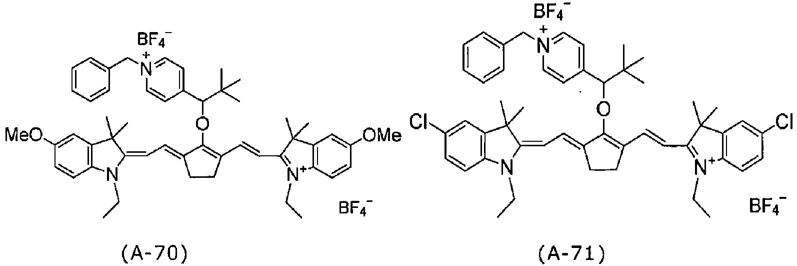

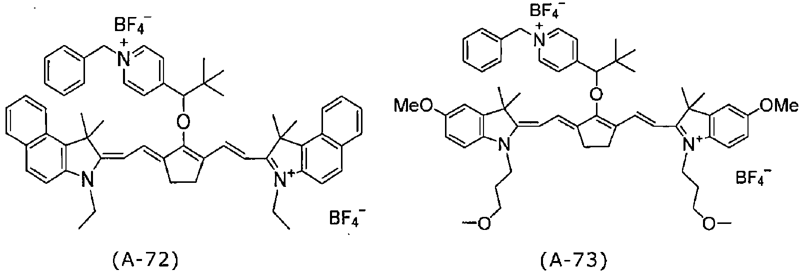

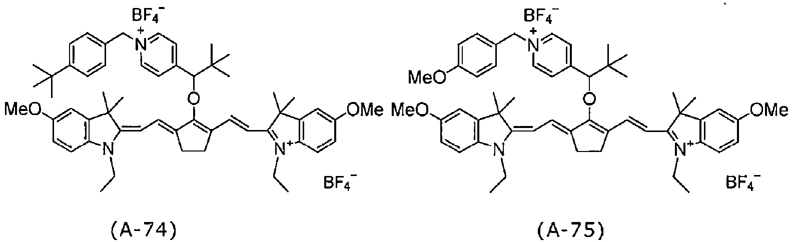

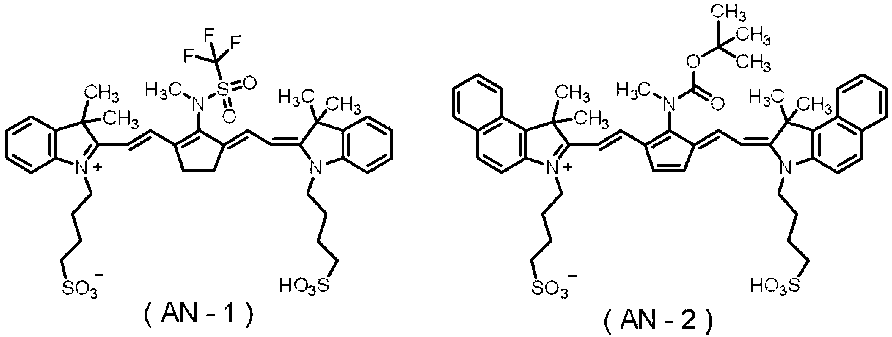

In addition, as the color-forming compound, those described in JP2008-544322A or WO2016/027886A can be suitably used.

The compound represented by Formula 1 or Formula 2 can be synthesized by applying a known method. The compound represented by Formula 1 or Formula 2 can be synthesized, for example, by the method described in paragraphs 0109 to 0113 of JP2020-69789A.

One color-forming compound may be used alone, or two or more color-forming compounds may be used in combination.

A content of the color-forming compound in the image-recording layer is preferably 0.1% by mass to 95% by mass, more preferably 0.5% by mass to 40% by mass, and still more preferably 1% by mass to 20% by mass with respect to the total solid content of the image-recording layer.

Since the color-forming compound itself has excellent infrared absorption properties, the color-forming compound functions well as an infrared absorber. Accordingly, in a case where the color-forming compound is used in the image-recording layer of the lithographic printing plate precursor, it is not necessary to use another infrared absorber other than the color-forming compound in practice, but the image-recording layer may contain another infrared absorber.

### [Polymerization initiator]

The polymerization initiator is a compound that generates a polymerization initiation species such as a radical or a cation by either or both of light energy and heat energy. The polymerization initiator to be used can be appropriately selected from known thermal polymerization initiators, compounds having a bond that requires low bond dissociation energy, photopolymerization initiators, and the like.

As the polymerization initiator, an infrared-sensitive photopolymerization initiator is preferable. In addition, as the polymerization initiator, a radical polymerization initiator is preferable. Two or more radical polymerization initiators may be used in combination.

The radical polymerization initiator may be either an electron-accepting polymerization initiator or an electron-donating polymerization initiator.

### <Electron-accepting polymerization initiator>

Examples of the electron-accepting polymerization initiator include an organic halide, a carbonyl compound, an azo compound, an organic peroxide, a metallocene compound, an azide compound, a hexaarylbiimidazole compound, a disulfone compound, an oxime ester compound, and an onium salt compound.

As the organic halide, for example, the compounds described in paragraphs "0022" and" 0023" of JP2008-195018A are preferable.

As the carbonyl compound, for example, the compounds described in paragraph "0024" of JP2008-195018A are preferable.

Examples of the azo compound include the azo compounds described in JP1996-108621A (JP-H08-108621A), and the like.

As the organic peroxide, for example, the compounds described in paragraph "0025" of JP2008-195018A are preferable.

As the metallocene compound, for example, the compounds described in paragraph "0026" of JP2008-195018A are preferable.

Examples of the azide compound include compounds such as 2,6-bis(4-azidobenzylidene)-4-methylcyclohexanone.

As the hexaarylbiimidazole compound, for example, the compounds described in paragraph "0027" of JP2008-195018A are preferable.

Examples of the disulfone compound include the compounds described in JP1986-166544A (JP-S61-166544A) and JP2002-328465A.

As the oxime ester compound, for example, the compounds described in paragraphs "0028" to "0030" of JP2008-195018A are preferable.

Among the electron-accepting polymerization initiators, for example, an onium salt compound such as an iodonium salt, a sulfonium salt, or an azinium salt is more preferable. Among these, an iodonium salt and a sulfonium salt are particularly preferable. Specific examples of the iodonium salt and the sulfonium salt will be shown below, but the present invention is not limited thereto.

As the iodonium salt, for example, a diphenyliodonium salt is preferable. Particularly, a diphenyl iodonium salt having an electron-donating group, for example, a diphenyl iodonium salt substituted with an alkyl group or an alkoxyl group is preferable, and an asymmetric diphenyl iodonium salt is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As the sulfonium salt, for example, a triarylsulfonium salt is preferable. Particularly, a triarylsulfonium salt having an electron withdrawing group as a substituent, for example, a triarylsulfonium salt is preferable in which at least some of the groups on an aromatic ring are substituted with halogen atoms, and a triarylsulfonium salt is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

It is preferable that the polymerization initiator includes an onium salt compound as an electron-accepting polymerization initiator.

One electron-accepting polymerization initiator may be used alone, or two or more electron-accepting polymerization initiators may be used in combination.

From the viewpoint of color formability during exposure, fading properties during exposure to a white light, printing durability, and coating liquid stability, a content of the electron-accepting polymerization initiator is preferably 0.1% to 30% by mass, more preferably 0.1% to 20% by mass, and still more preferably 0.5% to 15% by mass in the total solid content of the image-recording layer.

### <Electron-donating polymerization initiator>

The electron-donating polymerization initiator contributes to the improvement of printing durability of a lithographic printing plate prepared from the lithographic printing plate precursor. Examples of the electron-donating polymerization initiator include the following five initiators.
(i) Alkyl- or aryl-ate complex: considered to generate active radicals by oxidative cleavage of carbon-hetero bond. Specific examples thereof include a borate compound and the like.
(ii) Amino acetate compound: considered to generate active radicals by oxidation-induced cleavage of C-X bond on carbon adjacent to nitrogen. X is preferably a hydrogen atom, a carboxy group, a trimethylsilyl group, or a benzyl group. Specific examples thereof include N-phenylglycines (which may have a substituent in a phenyl group), N-phenyl iminodiacetic acid (which may have a substituent in a phenyl group), and the like.
(iii) Sulfur-containing compound: compound obtained by substituting nitrogen atoms of the aforementioned amino acetate compound with sulfur atoms and capable of generating active radicals by the same action as that of the amino acetate compound. Specific examples thereof include phenylthioacetic acid (which may have a substituent on a phenyl group) and the like.
(iv) Tin-containing compound: compound obtained by substituting nitrogen atoms of the aforementioned amino acetate compound with tin atoms and capable of generating active radicals by the same action as that of the amino acetate compound.
(v) Sulfinates: capable of generating active radicals by oxidation. Specific examples thereof include sodium aryl sulfinate and the like.

Among the electron-donating polymerization initiators, a borate compound is preferable. As the borate compound, a tetraaryl borate compound or a monoalkyl triaryl borate compound is preferable. From the viewpoint of compound stability, a tetraaryl borate compound is more preferable.

A countercation that the borate compound has is preferably an alkali metal ion or a tetraalkyl ammonium ion, and more preferably a sodium ion, a potassium ion, or a tetrabutylammonium ion.

It is preferable that the polymerization initiator includes a borate compound as an electron-donating polymerization initiator.

Specific examples of the borate compound include the following compounds. In the following compounds, X_{c}⁺ represents a monovalent cation, which is preferably an alkali metal ion or a tetraalkyl ammonium ion, and more preferably an alkali metal ion or a tetrabutylammonium ion. Further, Bu represents an n-butyl group.

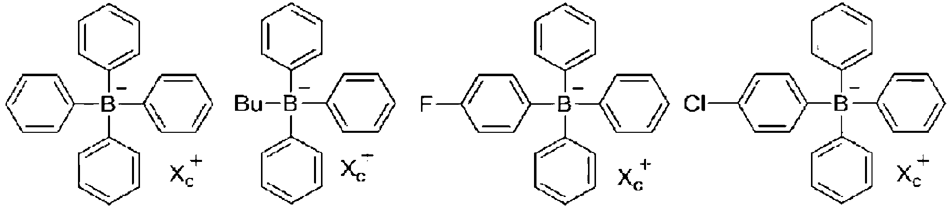

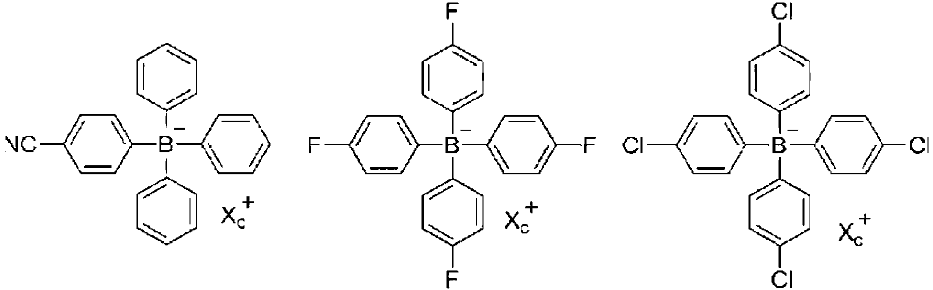

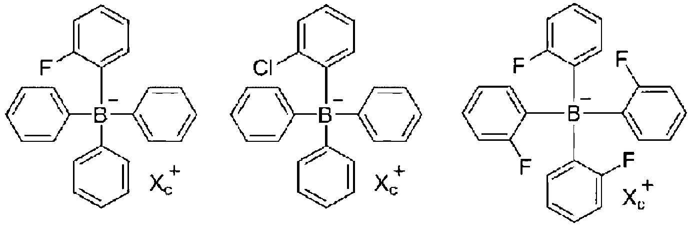

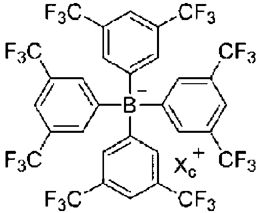

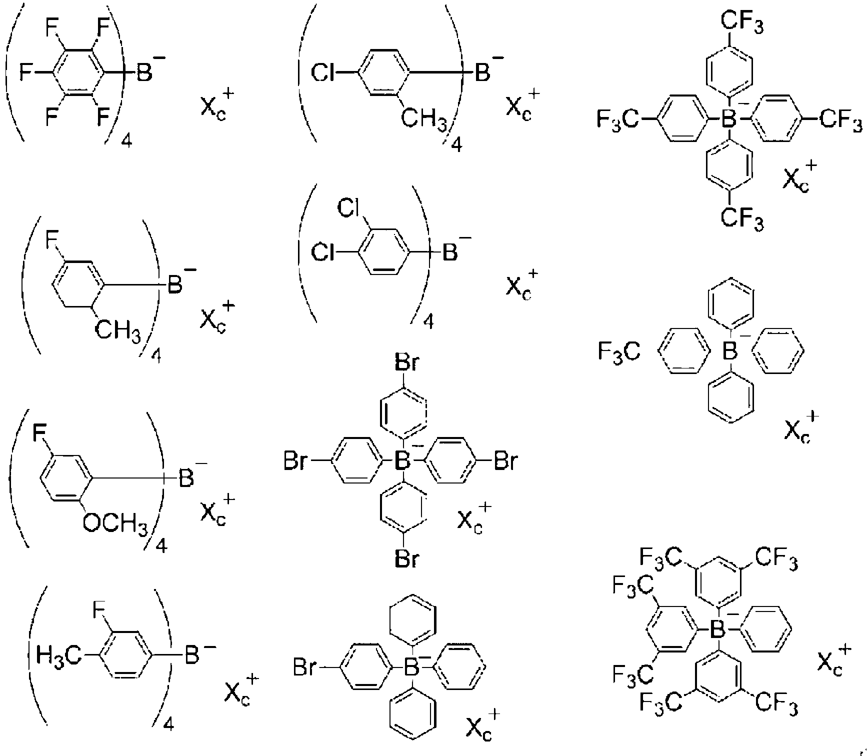

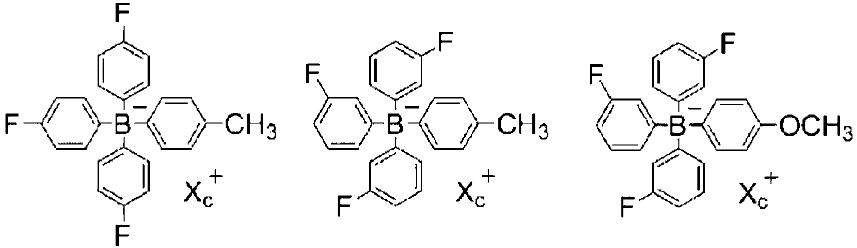

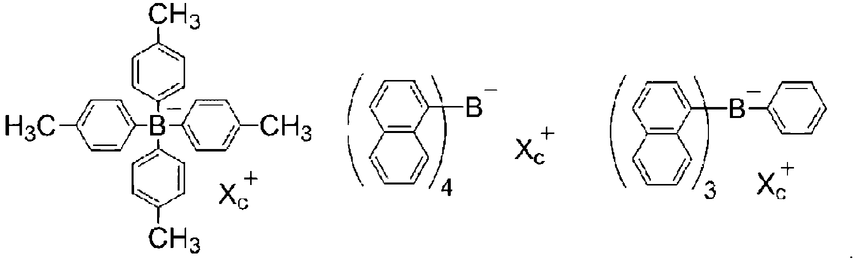

One electron-donating polymerization initiator may be used alone, or two or more electron-donating polymerization initiators may be used in combination.

From the viewpoint of color formability during exposure, printing durability, and coating liquid stability, a content of the electron-donating polymerization initiator is preferably 0.1% to 20% by mass, more preferably 0.3% to 15% by mass, and still more preferably 0.5% to 10% by mass in the total solid content of the image-recording layer.

### [Polymerizable compound]

The polymerizable compound may be, for example, a radically polymerizable compound or a cationically polymerizable compound. As the polymerizable compound, an addition polymerizable compound having at least one ethylenically unsaturated bond (ethylenically unsaturated compound) is preferable. The ethylenically unsaturated compound is preferably a compound having at least one ethylenically unsaturated bond on a terminal, and more preferably a compound having two or more ethylenically unsaturated bonds on a terminal. The polymerizable compound can have a chemical form such as a monomer or a prepolymer, that is, a dimer, a trimer, an oligomer, a mixture of these, or the like.

From the viewpoint of printing durability, the polymerizable compound preferably has 5 or more functionalities, more preferably has 7 or more functionalities, and still more preferably has 11 or more functionalities. The "functionality" indicates a group (functional group) that contributes to polymerization, and an ethylenically unsaturated bond is preferable. For example, the term "4 or more functionalities" indicates that the number of groups contributing to polymerization is 4 or more.

The polymerizable compound is not particularly limited, but usually has 20 or less functionalities.

From the viewpoint of printing durability, the polymerizable compound is preferably an ethylenically unsaturated compound having 5 or more functionalities, more preferably an ethylenically unsaturated compound having 7 or more functionalities, and still more preferably an ethylenically unsaturated compound having 11 or more functionalities.

The molecular weight of the polymerizable compound (the weight-average molecular weight in a case where the compound has molecular weight distribution) is not particularly limited, but the molecular weight thereof is preferably smaller from the viewpoint of on-press developability and the molecular weight thereof is preferably larger from the viewpoint of printing durability.

The molecular weight of the polymerizable compound is preferably less than 15,000. In addition, the molecular weight thereof is preferably 100 or greater.

From the viewpoints of achieving both on-press developability and printing durability, the molecular weight of the polymerizable compound is preferably 100 or more and less than 15,000, more preferably 500 or more and less than 13,000, and even more preferably 1,000 or more and less than 10,000.

As a preferred aspect, the image-recording layer preferably contains a polymerizable compound having 7 or more functionalities and having a molecular weight of less than 15,000, as the polymerizable compound.

As a preferred aspect, the image-recording layer preferably contains a polymerizable compound having 11 or more functionalities and having a molecular weight of less than 15,000, as the polymerizable compound.

Examples of the monomer include unsaturated carboxylic acids (for example, acrylic acid, methacrylic acid, itaconic acid, crotonic acid, isocrotonic acid, and maleic acid), and esters and amides thereof. It is preferable to use esters of an unsaturated carboxylic acid and a polyhydric alcohol compound, or amides of an unsaturated carboxylic acid and a polyvalent amine compound. In addition, products of an addition reactant of unsaturated carboxylic acid esters or amides having a nucleophilic substituent such as a hydroxy group, an amino group, or a mercapto group and monofunctional or polyfunctional isocyanates or epoxies, a dehydrocondensation reactant of the aforementioned unsaturated carboxylic acid esters or amides and a monofunctional or polyfunctional carboxylic acid, and the like are also suitably used. Furthermore, an addition reactant of unsaturated carboxylic acid esters or amides having an electrophilic substituent such as an isocyanate group or an epoxy group and monofunctional or polyfunctional alcohols, amines, or thiols, and a substitution reactant of unsaturated carboxylic acid esters or amides having a leaving substituent such as a halogen atom or a tosyloxy group and monofunctional or polyfunctional alcohols, amines, or thiols are also suitable. In addition, as another example, it is also possible to use a group of compounds obtained by substituting the unsaturated carboxylic acid with an unsaturated phosphonic acid, styrene, vinyl ether, or the like. These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, JP1998-333321A (JP-H10-333321A), and the like.

Specific examples of monomers of esters of polyhydric alcohol compounds and unsaturated carboxylic acids include acrylic acid esters such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, and polyester acrylate oligomers, and Examples of the methacrylic acid ester include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane, and bis[p-(methacryloxyethoxy)phenyl]dimethylmethane. In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds manufactured using an addition reaction between an isocyanate and a hydroxy group are also suitable, and specific examples thereof include vinyl urethane compounds having two or more polymerizable vinyl groups in one molecule obtained by adding vinyl monomers containing a hydroxy group represented by the following Formula (M) to a polyisocyanate compound having two or more isocyanate groups in one molecule which is described in, for example, JP1973-41708B (JP-S48-41708B).

CH₂=C(R^{M4})COOCH₂CH(R^{M5})OH (M)

In Formula (M), R^{M4} and R^{M5} each independently represent a hydrogen atom or a methyl group.

Furthermore, urethane acrylates described in JP1976-37193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also suitable.

Details of how to use the polymerizable compound, such as the structure of the compound, whether the compound is used alone or used in combination with other compounds, and the amount of the compound to be added, can be randomly set in consideration of the final use of the lithographic printing plate precursor or the like.

The content of the polymerizable compound with respect to the total solid content of the image-recording layer is preferably 1% to 90% by mass, more preferably 5% to 70% by mass, and even more preferably 10% to 50% by mass.

### [Hydrogen-donating compound]

The hydrogen-donating compound is a compound different from the polymerization initiator, the polymerizable compound, the color-forming compound, and the acid-cleavable compound, and is a compound having at least one group selected from the group consisting of -OH, -NH-, -SO₂-NH-, -SO₂-OH, -CO-NH-, and -CO-OH in a molecule and having a molecular weight of less than 3,000.

A group selected from the group consisting of -OH, -NH-, -SO₂-NH-, -SO₂-OH, -CO-NH-, and -CO-OH (hereinafter, also simply referred to as a "hydrogen-donating group") is a group capable of donating a hydrogen atom.

"-OH" represents a hydroxyl group, and is a group different from "-CO-OH" (carboxyl group) and does not bond to -SO₂-.

"-NH-" is a group that does not bond to -SO₂- or -CO-.

The "compound different from the polymerization initiator, the polymerizable compound, the color-forming compound, and the acid-cleavable compound" represents that the compound is not included in the hydrogen-donating compound as long as the compound has the above-described hydrogen-donating group, has a molecular weight of less than 3,000, and functions as the polymerization initiator, the polymerizable compound, the color-forming compound, or the acid-cleavable compound.

The polymerization initiator, the polymerizable compound, and the color-forming compound are as described above.

The acid-cleavable compound represents a compound that cleaves by the action of an acid, and specifically, indicates that a ring in the molecule cleaves (ring opening) by the action of an acid. A so-called acid color-forming agent that cleaves and colors by the action of an acid is included in the acid-cleavable compound. The hydrogen-donating compound is a compound different from the acid color-forming agent.

The hydrogen-donating compound is preferably a compound having at least one partial structure represented by Formula (I) in the molecule.

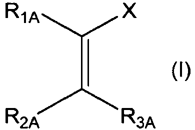

In Formula (I),
X is a group selected from the group consisting of -OH, -NH-, -SO₂-NH-, -SO₂-OH, -CO-NH-, and -CO-OH.

R_{1A} to R_{3A} each independently are a group having at least one selected from the group consisting of a hydrogen atom, a carbon atom, a halogen atom, and a heteroatom.

At least two of R_{1A} to R_{3A} may be linked to each other to form a ring.

In a case where X is a monovalent group, one or more hydrogen atoms included in R_{1A} to R_{3A} are removed to form a bonding site.

In a case where X represents a divalent group, one or more hydrogen atoms included in R_{1A} to R_{3A} may be further removed to form a bonding site.

As the hydrogen-donating group of X, from the viewpoint of suppressing fading during exposure to a white light and ease of familiarity with the image-recording layer, -OH, -NH-, -SO₂-NH-, or -CO-NH- is preferable, and -OH or -SO₂-NH- is more preferable.

The group (hereinafter, also referred to as a "substituent A") having at least one selected from the group consisting of a hydrogen atom, a carbon atom, a halogen atom, and a heteroatom as R_{1A} to R_{3A} is not particularly limited; however, it is preferably a group having 0 to 30 carbon atoms.

The halogen atom is not particularly limited, and examples thereof include a fluorine atom, a chlorine atom, a bromine atom, and an iodine atom.

The heteroatom is not particularly limited, and examples thereof include a nitrogen atom, an oxygen atom, a sulfur atom, and a phosphorus atom.

The substituent A is not particularly limited, but for example, a hydrogen atom or a hydrocarbon group is preferable. The hydrocarbon group may have a heteroatom or a halogen atom.

At least two of R_{1A} to R_{3A} may be linked to each other to form a ring. The ring to be formed may be a monocyclic ring or a polycyclic ring. Examples of the ring to be formed include an aromatic ring and an aliphatic hydrocarbon ring, and the number of ring member atoms of the ring to be formed is preferably 6 to 14.

In a case where X is a monovalent group (specifically, a group selected from the group consisting of -OH, -SO₂-OH, and -CO-OH), one or more hydrogen atoms included in R_{1A} to R_{3A} are removed to form a bonding site.

In a case where X is a divalent group (specifically, a group selected from the group consisting of -NH-, -SO₂-NH-, and -CO-NH-), the divalent group can constitute a partial structure in Formula (I), but one or more hydrogen atoms included in R_{1A} to R_{3A} may be further removed to form a bonding site.

The hydrogen-donating compound is preferably a compound having at least one partial structure represented by Formula (I) in the molecule, and may be a compound having at least two or more partial structures represented by Formula (I) in the molecule.

The number of the partial structures represented by Formula (I) in the molecule is not particularly limited, but is preferably 1 to 10 and more preferably 1 to 5.

The hydrogen-donating compound is preferably a compound having at least one partial structure represented by Formula (II) in the molecule.

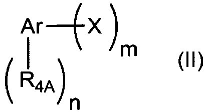

In Formula (II),
Ar represents an aromatic ring group.

X is a group selected from the group consisting of -OH, -NH-, -SO₂-NH-, -SO₂-OH, -CO-NH-, and -CO-OH.

R_{4A} is a group having at least one selected from the group consisting of a hydrogen atom, a carbon atom, a halogen atom, and a heteroatom.

m represents an integer of 1 to 5. In a case where m represents an integer of 2 or more, a plurality of X's may be the same or different from each other.

n represents an integer of 0 to 5. In a case where n represents an integer of 2 or more, a plurality of R_{4A}'s may be the same or different from each other. In a case where n is 2 or more, a plurality of R_{4A}'s may be linked to each other to form a ring.

In a case where all X's are monovalent groups, one or more hydrogen atoms included in R_{4A} are removed to form a bonding site.

In a case where at least one X is a divalent group, one or more hydrogen atoms included in R_{4A} may be further removed to form a bonding site.

X has the same meaning as X in Formula (I), and the same applies to the preferred range thereof.

Examples of the aromatic ring in the aromatic ring group of Ar include an aromatic hydrocarbon ring and an aromatic heterocyclic ring.

The aromatic hydrocarbon ring may be monocyclic or polycyclic. The number of ring member atoms is preferably 6 to 15 and more preferably 6 to 10.

Examples of the aromatic hydrocarbon ring include a benzene ring, a naphthalene ring, and an anthracene ring. Among these, a benzene ring or a naphthalene ring is preferable, and a benzene ring is more preferable.

The aromatic heterocyclic ring may be monocyclic or polycyclic. The number of ring member atoms is preferably 5 to 15.

Examples of the heterocyclic ring having aromaticity include a furan ring, a thiophene ring, a benzofuran ring, a benzothiophene ring, a dibenzofuran ring, a dibenzothiophene ring, a pyridine ring, an indole ring, a benzodiazole ring, and a carbazole ring.

The group (hereinafter, also referred to as a "substituent A1") having at least one selected from the group consisting of a hydrogen atom, a carbon atom, a halogen atom, and a heteroatom as R_{4A} is not particularly limited, but is preferably a group having 0 to 24 carbon atoms.

The halogen atom is not particularly limited, and examples thereof include a fluorine atom, a chlorine atom, a bromine atom, and an iodine atom.

The heteroatom is not particularly limited, and examples thereof include a nitrogen atom, an oxygen atom, a sulfur atom, and a phosphorus atom.

The substituent A1 is not particularly limited, but for example, a hydrogen atom or a hydrocarbon group is preferable. The hydrocarbon group may have a heteroatom or a halogen atom.

m represents an integer of 1 to 5. m preferably represents an integer of 1 to 3, and more preferably represents 1 or 2.

n represents an integer of 0 to 5. n preferably represents an integer of 0 to 2, and more preferably represents 0 or 1.

In a case where n is 2 or more, a plurality of R_{4A}'s may be linked to each other to form a ring.

The ring formed by linking a plurality of R_{4A}'s may be a monocyclic ring or a polycyclic ring. Examples of the ring to be formed include an aromatic ring and an aliphatic hydrocarbon ring, and the number of ring member atoms of the ring to be formed is preferably 6 to 10.

In a case where X is a monovalent group (specifically, a group selected from the group consisting of -OH, -SO₂-OH, and -CO-OH), one or more hydrogen atoms included in R_{4A} are removed to form a bonding site.

In a case where X is a divalent group (specifically, a group selected from the group consisting of -NH-, -SO₂-NH-, and -CO-NH-), the divalent group can constitute a partial structure in Formula (I), but one or more hydrogen atoms included in R_{4A} may be further removed to form a bonding site.

The hydrogen-donating compound is preferably a compound having at least one partial structure represented by Formula (II) in the molecule, and may be a compound having at least two or more partial structures represented by Formula (II) in the molecule.

The number of the partial structures represented by Formula (I) in the molecule is not particularly limited, but is preferably 1 to 5 and more preferably 1 to 3.

The hydrogen-donating compound is preferably a compound having at least one partial structure represented by Formula (III) in the molecule.

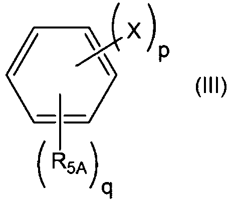

In Formula (III),
X is a group selected from the group consisting of -OH, -NH-, -SO₂-NH-, -SO₂-OH, -CO-NH-, and -CO-OH.

R_{5A} is a group having at least one selected from the group consisting of a hydrogen atom, a carbon atom, a halogen atom, and a heteroatom.

p represents an integer of 1 to 5. In a case where p represents an integer of 2 or more, a plurality of X's may be the same or different from each other.

q represents an integer of 0 to 5. In a case where q represents an integer of 2 or more, a plurality of R₅'s may be the same or different from each other. In a case where q is 2 or more, a plurality of R_{5A}'s may be linked to each other to form a ring.

p + q is 6 or less.

In a case where all X's are monovalent groups, one or more hydrogen atoms included in R_{5A} are removed to form a bonding site.

In a case where at least one X is a divalent group, one or more hydrogen atoms included in R_{5A} may be further removed to form a bonding site.

X has the same meaning as X in Formula (I), and the same applies to the preferred range thereof.

The group (hereinafter, also referred to as a "substituent A2") having at least one selected from the group consisting of a hydrogen atom, a carbon atom, a halogen atom, and a heteroatom as R_{5A} is not particularly limited; however, it is preferably a group having 0 to 24 carbon atoms.

The halogen atom is not particularly limited, and examples thereof include a fluorine atom, a chlorine atom, a bromine atom, and an iodine atom.

The heteroatom is not particularly limited, and examples thereof include a nitrogen atom, an oxygen atom, a sulfur atom, and a phosphorus atom.

The substituent A2 is not particularly limited, but for example, a hydrogen atom or a hydrocarbon group is preferable. The hydrocarbon group may have a heteroatom or a halogen atom.

p represents an integer of 1 to 5. p preferably represents an integer of 1 to 3, and more preferably represents 1 or 2.

q represents an integer of 0 to 5. q preferably represents an integer of 0 to 2, and more preferably represents 0 or 1.

In a case where q is 2 or more, a plurality of R_{5A}'s may be linked to each other to form a ring.

The ring formed by linking a plurality of R_{5A}'s may be a monocyclic ring or a polycyclic ring. Examples of the ring to be formed include an aromatic ring and an aliphatic hydrocarbon ring, and the number of ring member atoms of the ring to be formed is preferably 6 to 10.

From the viewpoint of suppressing fading during exposure to a white light and ease of familiarity with the image-recording layer, the hydrogen-donating group in the hydrogen-donating compound is preferably a group selected from the group consisting of -OH, -NH-, -SO₂-NH-, and -CO-NH-, and more preferably a group selected from the group consisting of -OH and -SO₂-NH-.

From the viewpoint of suppressing fading during exposure to a white light, the hydrogen-donating compound preferably contains at least one hydrogen-donating group, more preferably at least two hydrogen-donating groups, and still more preferably at least three hydrogen-donating groups.

The number of hydrogen-donating groups included in the hydrogen-donating compound is not particularly limited, but is, for example, preferably 10 or less, more preferably 7 or less, and still more preferably 5 or less.

As a preferred aspect, the hydrogen-donating compound is preferably a compound having at least two groups selected from the group consisting of -OH, -NH-, -SO₂-NH-, -SO₂-OH, -CO-NH-, and -CO-OH in the molecule.

As a preferred aspect, the hydrogen-donating compound preferably has at least one group selected from the group consisting of -OH and -SO₂-NH-.

As a preferred aspect, the hydrogen-donating compound preferably has at least two groups selected from the group consisting of -OH and -SO₂-NH-.

The hydrogen-donating compound preferably has at least one phenolic hydroxyl group.

The phenolic hydroxyl group represents a hydroxyl group (-OH) directly connected to an aromatic ring (specifically, a benzene ring).

The hydrogen-donating compound preferably has two or more phenolic hydroxyl groups.

The hydrogen-donating compound preferably has two or more and six or less phenolic hydroxyl groups, and more preferably has two or more and four or less phenolic hydroxyl groups.

"Having two or more phenolic hydroxyl groups" may mean that an aromatic ring bonded to one phenolic hydroxyl group may further bond one or more phenolic hydroxyl groups, or an aromatic ring different from the aromatic ring bonded to one phenolic hydroxyl group may further bond one or more phenolic hydroxyl groups.

The hydrogen-donating compound is preferably a compound represented by Formula (IV) or a compound represented by Formula (V).

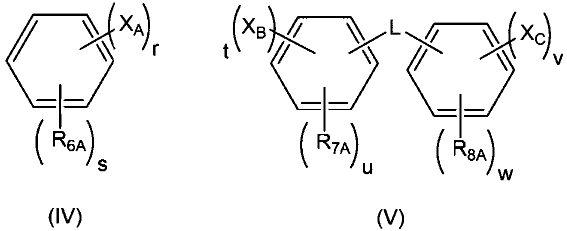

In Formula (IV), X_{A} represents -OH.

R_{6A} represents an organic group or a halogen atom.

r represents an integer of 1 to 5.

s represents an integer of 0 to 5. In a case where s represents an integer of 2 or more, a plurality of R_{6A}'s may be the same or different from each other. In a case where s is 2 or more, a plurality of R_{6A}'s may be linked to each other to form a ring.

In Formula (V), L represents a single bond or a divalent linking group.

X_{B} represents -OH.

R_{7A} represents an organic group or a halogen atom.

X_{c} represents -OH.

R_{8A} represents an organic group or a halogen atom.

t represents an integer of 1 to 5.

u represents an integer of 0 to 5. In a case where u represents an integer of 2 or more, a plurality of R_{7A}'s may be the same or different from each other. In a case where u is 2 or more, a plurality of R_{7A}'s may be linked to each other to form a ring.

v represents an integer of 1 to 5.

w represents an integer of 0 to 5. In a case where w represents an integer of 2 or more, a plurality of R_{8A}'s may be the same or different from each other. In a case where w is 2 or more, a plurality of R_{8A}'s may be linked to each other to form a ring.

The organic group of R_{6A}, R_{7A}, and R_{8A} is not particularly limited, and examples thereof include an alkyl group and an aryl group.

The alkyl group may be linear or branched, and examples thereof include an alkyl group having 1 to 10 carbon atoms.

The aryl group may be monocyclic or polycyclic, and examples thereof include an aryl group having 6 to 20 carbon atoms.

The halogen atom of R_{6A}, R_{7A}, and R_{8A} is not particularly limited, and examples thereof include a fluorine atom, a chlorine atom, a bromine atom, and an iodine atom.

r represents an integer of 1 to 5. r preferably represents an integer of 1 to 3, and more preferably represents 1 or 2.

s represents an integer of 0 to 5. s preferably represents an integer of 0 to 3, and more preferably represents 0 or 1.

r + s is preferably 6 or less.

The ring formed by linking a plurality of R_{6A}'s may be a monocyclic ring or a polycyclic ring. Examples of the ring to be formed include an aliphatic hydrocarbon ring, and the number of ring member atoms of the ring to be formed is preferably 6 to 10.

The divalent linking group of L is not particularly limited, and examples thereof include an alkylene group, -CO-, -SO₂-, -O-, and a combination thereof.

Examples of the alkylene group include a linear or branched alkylene group having 1 to 5 carbon atoms.

The alkylene group may further have a substituent. The substituent is not particularly limited, and examples thereof include an aryl group (preferably having 6 to 10 carbon atoms). The aryl group may further have a substituent, and examples of the further substituent include a hydroxyl group.

t represents an integer of 1 to 5. t preferably represents an integer of 1 to 3, and more preferably represents 1 or 2.

u represents an integer of 0 to 5. u preferably represents an integer of 0 to 3, and more preferably represents 0 or 1.

t + u is preferably 6 or less.

The ring formed by linking a plurality of R_{7A}'s may be a monocyclic ring or a polycyclic ring. Examples of the ring to be formed include an aliphatic hydrocarbon ring, and the number of ring member atoms of the ring to be formed is preferably 6 to 10.

v represents an integer of 1 to 5. v preferably represents an integer of 1 to 3, and more preferably represents 1 or 2.

w represents an integer of 0 to 5. w preferably represents an integer of 0 to 3, and more preferably represents 0 or 1.

It is preferable that v + w is 6 or less.

The ring formed by linking a plurality of R_{8A}'s may be a monocyclic ring or a polycyclic ring. Examples of the ring to be formed include an aliphatic hydrocarbon ring, and the number of ring member atoms of the ring to be formed is preferably 6 to 10.

The hydrogen-donating compound is a low-molecular-weight compound having a molecular weight of less than 3,000, preferably a low-molecular-weight compound having a molecular weight of 1,500 or less, and more preferably a low-molecular-weight compound having a molecular weight of 1,000 or less.

Here, the low-molecular-weight compound in the present invention is not a so-called polymer or oligomer obtained by cleaving an unsaturated bond of a compound (so-called polymerizable monomer) having an unsaturated bond while using an initiator and growing a bond in a chain-like manner, but is a compound having a certain molecular weight of 3000 or less (more preferably 2000 or less and still more preferably 1000 or less) (a compound having substantially no molecular weight distribution).

The molecular weight of the hydrogen-donating compound is not particularly limited, but is preferably 50 or more, preferably 100 or more, and more preferably 200 or more.

As a preferred aspect, from the viewpoint of on-press developability and printing durability, the molecular weight is preferably 50 or more and 3,000 or less, more preferably 100 or more and 1,500 or less, and still more preferably 200 or more and 1,000 or less.

Specific examples of the hydrogen-donating compound are shown below, but the present invention is not limited thereto.

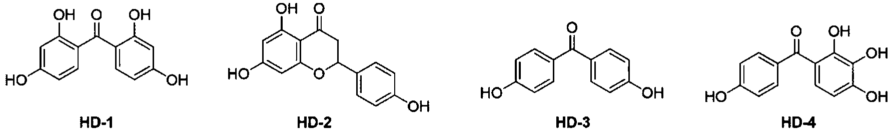

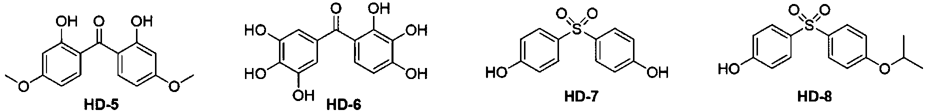

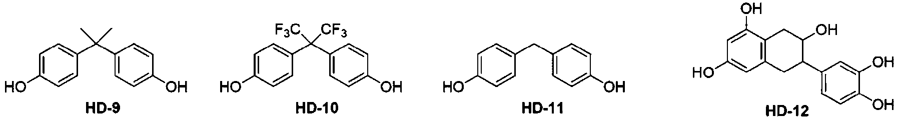

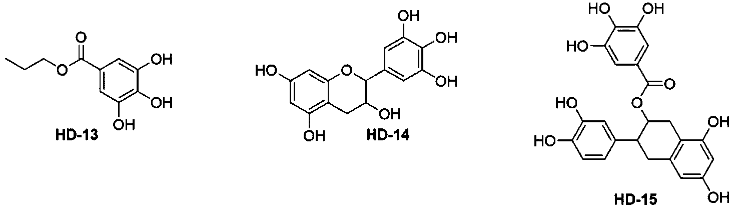

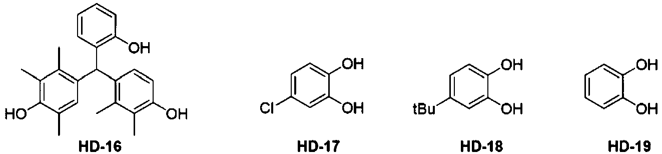

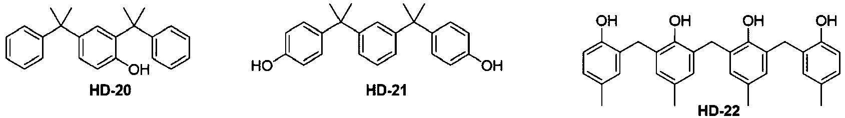

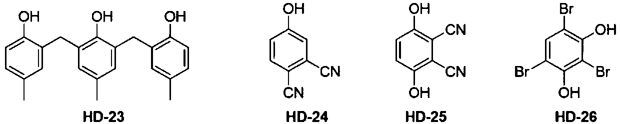

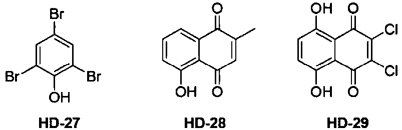

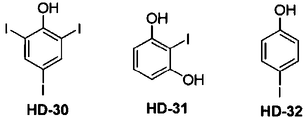

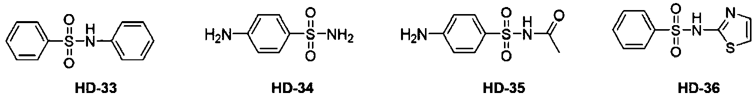

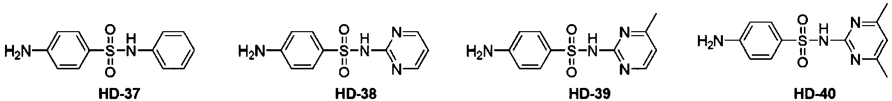

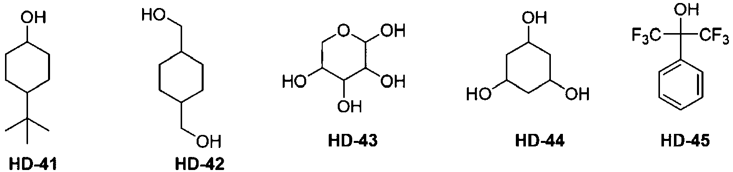

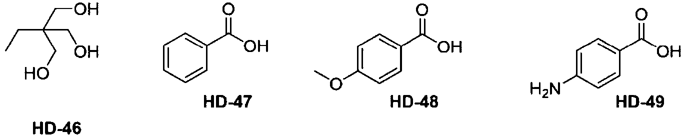

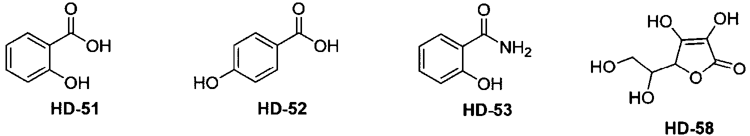

The hydrogen-donating compound may be used alone or in combination of two or more kinds thereof.

A content of the hydrogen-donating compound is preferably 0.5% to 30% by mass, more preferably 1% to 20% by mass, and still more preferably 1% to 10% by mass in the total solid content of the image-recording layer.

In the on-press development type lithographic printing plate, the image-recording layer can contain an infrared absorber other than the color-forming compound, an acid color-forming agent, a polymer compound, a chain transfer agent, a low-molecular-weight hydrophilic compound, a lipophilizing agent, and other components.

### [Other infrared absorbers]

The image-recording layer may contain an infrared absorber other than the color-forming compound.

Examples of other infrared absorbers include pigments and dyes.

As dyes used as other infrared absorbers, commercially available dyes and known dyes described in the literatures such as "Dye Handbook" (edited by the Society of Synthetic Organic Chemistry, Japan, published in 1970) can be used. Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine colorant, a squarylium colorant, a pyrylium salt, a nickel thiolate complex, and an indolenine cyanine colorant are particularly preferable. Furthermore, for example, a cyanine colorant or an indolenine cyanine colorant is preferable. Among these, a cyanine colorant is particularly preferable.

Specific examples of the cyanine colorant include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine colorant, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

In addition, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to "0076" of JP2008-195018A are preferable.

Other infrared absorbers may be used alone or in combination of two or more kinds thereof. Further, pigments and dyes may be used in combination as other infrared absorbers.

From the viewpoints of the color developability and the UV printing durability of the lithographic printing plate to be obtained, it is preferable that the content of other infrared absorbers in the image recording layer is smaller than the content of the color-forming compound and more preferable that the image recording layer does not contain other infrared absorbers.

The image-recording layer preferably contains an acid color-forming agent in addition to the color-forming compound having a group that cleaves by infrared exposure.

### [Acid color-forming agent]

"Acid color-forming agent" used in the present invention means a compound having a property of developing or removing color by being heated in a state of accepting an electron accepting compound (for example, a proton of an acid or the like) and thus changing the color of the image-recording layer. The acid color-forming agent is particularly preferably a colorless compound which has a partial skeleton such as lactone, lactam, sultone, spiropyran, an ester, or an amide and allows such a partial skeleton to rapidly open the ring or to be cleaved when coming into contact with an electron-accepting compound.

Specifically, suitable examples of the acid color-forming agent include those described in WO2020/158138A.

Particularly, from the viewpoint of color formability, the acid color-forming agent used in the present invention is preferably at least one kind of compound selected from the group consisting of a spiropyran compound, a spirooxazine compound, a spirolactone compound, and a spirolactam compound.

From the viewpoint of visibility, the hue of the colorant after color forming is preferably green, blue, or black.

From the viewpoints of color formability and visibility, the acid color-forming agent preferably includes a leuco colorant.

The aforementioned leuco colorant is not particularly limited as long as it has a leuco structure. The leuco colorant preferably has a spiro structure, and more preferably has a spirolactone ring structure.

From the viewpoint of color formability and visibility of exposed portions, the leuco colorant is preferably a leuco colorant having a phthalide structure or a fluoran structure.

Furthermore, from the viewpoint of color formability and visibility of exposed portions, the leuco colorant having a phthalide structure or a fluoran structure is preferably a compound represented by any of Formula (Le-1) to Formula (Le-3), and more preferably a compound represented by Formula (Le-2).

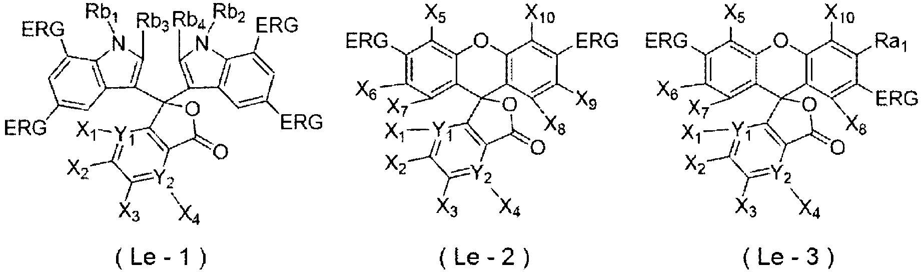

In Formula (Le-1) to Formula (Le-3), ERG's each independently represent an electron-donating group, X₁ to X₄ each independently represent a hydrogen atom, a halogen atom, or dialkylanilino group, X₅ to X₁₀ each independently represent a hydrogen atom, a halogen atom, or a monovalent organic group, Y₁ and Y₂ each independently represent C or N, X₁ does not exist in a case where Y₁ is N, X₄ does not exist in a case where Y₂ is N, Ra₁ represents a hydrogen atom, an alkyl group, or an alkoxy group, and Rb₁ to Rb₄ each independently represent a hydrogen atom, an alkyl group, an aryl group, or a heteroaryl group.

From the viewpoint of color formability and visibility of exposed portions, the electron-donating group represented by ERG in Formula (Le-1) to Formula (Le-3) is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, or an aryloxy group, even more preferably a monoalkyl monoarylamino group, a diarylamino group, a diheteroarylamino group, or a monoaryl monoheteroarylamino group, and particularly preferably a monoalkyl monoarylamino group.

From the viewpoints of color formability and visibility of exposed portions, the electron-donating group represented by ERG is preferably a disubstituted amino group having an aryl group that has a substituent on at least one ortho position or a heteroaryl group that has a substituent on at least one ortho position, more preferably a disubstituted amino group having a phenyl group having a substituent on at least one ortho position and an electron-donating group at a para position, even more preferably an amino group having a phenyl group having a substituent on at least one ortho position and an electron-donating group at a para position, and an aryl group or a heteroaryl group, and particularly preferably an amino group having a phenyl group having a substituent on at least one ortho position and an electron-donating group at a para position, and an aryl group having an electron-donating group or a heteroaryl group having an electron-donating group.

In the present invention, in a case where a bonding position of an aryl group or a heteroaryl group with other structures is defined as position 1, the ortho position in the aryl group or heteroaryl group other than a phenyl group is called a bonding position (for example, position 2 or the like) adjacent to the position 1.

Furthermore, from the viewpoints of color formability and visibility of exposed portions, the electron-donating group that the aryl group or heteroaryl group has is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoints of color formability and visibility of exposed portions, X₁ to X₄ in Formula (Le-1) to Formula (Le-3) each independently are preferably a hydrogen atom or a chlorine atom, and more preferably each independently represent a hydrogen atom.

From the viewpoints of color formability and visibility of exposed portions, X₅ to X₁₀ in Formula (Le-2) or Formula (Le-3) each independently are preferably a hydrogen atom, a halogen atom, an alkyl group, an aryl group, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, or a cyano group, more preferably a hydrogen atom, a halogen atom, an alkyl group, an aryl group, an alkoxy group, or an aryloxy group, even more preferably a hydrogen atom, a halogen atom, an alkyl group, or an aryl group, and particularly preferably a hydrogen atom.

From the viewpoints of color formability and visibility of exposed portions, it is preferable that at least one of Y₁ or Y₂ in Formula (Le-1) to Formula (Le-3) be C, and it is more preferable that both of Y₁ and Y₂ be C.

From the viewpoints of color formability and visibility of exposed portions, Ra₁ in Formula (Le-1) to Formula (Le-3) is preferably an alkyl group or an alkoxy group, more preferably an alkoxy group, and particularly preferably a methoxy group.

From the viewpoints of color formability and visibility of exposed portions, Rb₁ to Rb₄ in Formula (Le-1) to Formula (Le-3) preferably each independently represent a hydrogen atom or an alkyl group, more preferably each independently represent an alkyl group, and particularly preferably each independently represent a methyl group.

In addition, from the viewpoints of color formability and visibility of exposed portions, the leuco colorant having a phthalide structure or a fluoran structure is more preferably a compound represented by any of Formula (Le-4) to Formula (Le-6), and even more preferably a compound represented by Formula (Le-5).

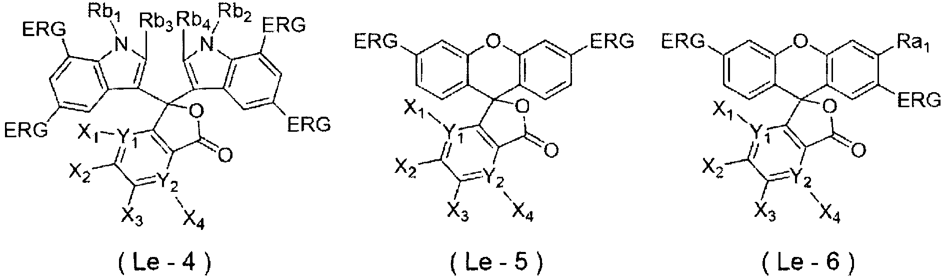

In Formula (Le-4) to Formula (Le-6), ERG's each independently represent an electron-donating group, X₁ to X₄ each independently represent a hydrogen atom, a halogen atom, or a dialkylanilino group, Y₁ and Y₂ each independently represent C or N, X₁ does not exist in a case where Y₁ is N, X₄ does not exist in a case where Y₂ is N, Ra₁ represents a hydrogen atom, an alkyl group, or an alkoxy group, and Rb₁ to Rb₄ each independently represent a hydrogen atom, an alkyl group, an aryl group, or a heteroaryl group.

ERG, X₁ to X₄, Y₁, Y₂, Ra₁, and Rb₁ to Rb₄ in Formula (Le-4) to Formula (Le-6) have the same definitions as ERG, X₁ to X₄, Y₁, Y₂, Ra₁, and Rb₁ to Rb₄ in Formula (Le-1) to Formula (Le-3) respectively, and preferred aspects thereof are also the same.

Furthermore, from the viewpoints of color formability and visibility of exposed portions, the leuco colorant having a phthalide structure or a fluoran structure is even more preferably a compound represented by any of Formula (Le-7) to Formula (Le-9), and particularly preferably a compound represented by Formula (Le-8).

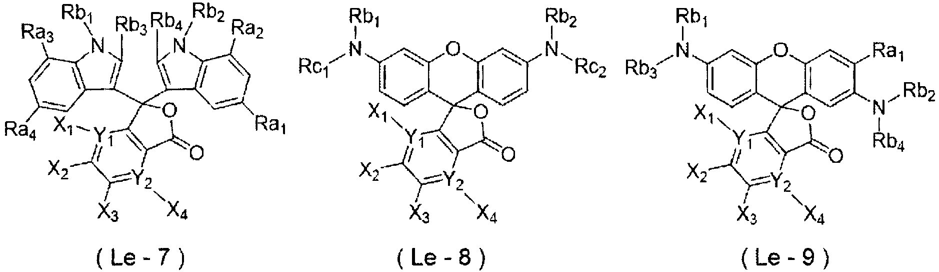

In Formula (Le-7) to Formula (Le-9), X₁ to X₄ each independently represent a hydrogen atom, a halogen atom, or a dialkylanilino group, Y₁ and Y₂ each independently represent C or N, X₁ does not exist in a case where Y₁ is N, X₄ does not exist in a case where Y₂ is N, Ra₁ to Ra₄ each independently represent a hydrogen atom, an alkyl group, or an alkoxy group, Rb₁ to Rb₄ each independently represent a hydrogen atom, an alkyl group, an aryl group, or a heteroaryl group, and Rc₁ and Rc₂ each independently represent an aryl group or a heteroaryl group.

X₁ to X₄, Y₁, and Y₂ in Formula (Le-7) to Formula (Le-9) have the same definition as X₁ to X₄, Y₁, and Y₂ in Formula (Le-1) to Formula (Le-3) respectively, and preferred aspects thereof are also the same.

From the viewpoints of color formability and visibility of exposed portions, Ra₁ to Ra₄ in Formula (Le-7) or Formula (Le-9) each independently are preferably an alkyl group or an alkoxy group, more preferably an alkoxy group, and particularly preferably represent a methoxy group.

From the viewpoints of color formability and visibility of exposed portions, Rb₁ to Rb₄ in Formula (Le-7) to Formula (Le-9) each independently are preferably a hydrogen atom, an alkyl group, or an aryl group substituted with an alkoxy group, more preferably an alkyl group, and particularly preferably a methyl group.

From the viewpoints of color formability and visibility of exposed portions, Rc₁ and Rc₂ in Formula (Le-8) each independently are preferably a phenyl group or an alkylphenyl group, and more preferably a phenyl group.

From the viewpoints of color formability and visibility of exposed portions, Rc₁ and Rc₂ in Formula (Le-8) each independently are preferably an aryl group having a substituent on at least one ortho position or a heteroaryl group having a substituent on at least one ortho position, more preferably an aryl group having a substituent on at least one ortho position, even more preferably a phenyl group having a substituent on at least one ortho position, and particularly preferably a phenyl group having a substituent on at least one ortho position and having an electron-donating group at the para position. Examples of the substituent in Rc₁ and Rc₂ include substituents that will be described later.

In Formula (Le-8), from the viewpoints of color formability and visibility of exposed portions, it is preferable that X₁ to X₄ are a hydrogen atom, and Y₁ and Y₂ are C.

Furthermore, from the viewpoints of color formability and visibility of exposed portions, in Formula (Le-8), Rb₁ and Rb₂ each independently are preferably an alkyl group or an aryl group substituted with an alkoxy group.

Moreover, from the viewpoints of color formability and visibility of exposed portions, in Formula (Le-8), Rb₁ and Rb₂ each independently are preferably an aryl group or a heteroaryl group, more preferably an aryl group, even more preferably an aryl group having an electron-donating group, and particularly preferably a phenyl group having an electron-donating group at the para position.

From the viewpoints of color formability and visibility of exposed portions, the electron-donating group in Rb₁, Rb₂, Rc₁, and Rc₂ is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoint of color formability and visibility of exposed portions, the acid color-forming agent preferably includes a compound represented by Formula (Le-10).

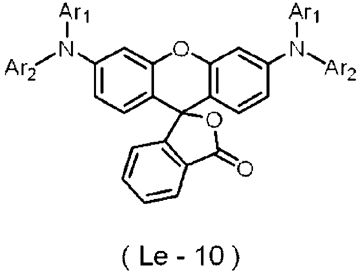

In Formula (Le-10), Ar₁'s each independently represent an aryl group or a heteroaryl group, and Ar₂'s each independently represent an aryl group having a substituent on at least one ortho position or a heteroaryl group having a substituent on at least one ortho position.

Ar₁ in Formula (Le-10) has the same definition as Rb₁ and Rb₂ in Formula (Le-7) to Formula (Le-9), and preferred aspects thereof are also the same.

Ar₂ in Formula (Le-10) has the same definition as Rc₁ and Rc₂ in Formula (Le-7) to Formula (Le-9), and preferred aspects thereof are also the same.

From the viewpoint of color formability and visibility of exposed portions, the acid color-forming agent preferably includes a compound represented by Formula (Le-A).

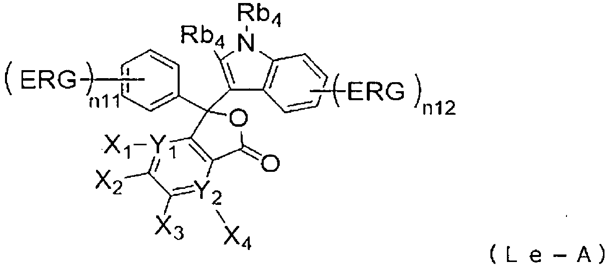

In Formula (Le-A), ERG's each independently represent an electron-donating group, n11 represents an integer of 1 to 5, n12 represents an integer of 0 to 2, X₁ to X₄ each independently represent a hydrogen atom, a halogen atom, or a dialkylanilino group, Y₁ and Y₂ each independently represent C or N, X₁ is not present in a case where Y₁ represents N, X₄ is not present in a case where Y₂ represents N, and Rb₄'s each independently represent a hydrogen atom, an alkyl group, an aryl group, or a heteroaryl group.

ERG, X₁ to X₄, Y₁, Y₂, and Rb₄ in Formula (Le-A) each have the same definition as that for ERG, X₁ to X₄, Y₁, Y₂, and Rb₄ in Formulae (Le-1) to (Le-3), and the preferable aspects thereof are also the same as described above.

n 11 in Formula (Le-A) is preferably an integer of 1 to 3, and more preferably 1 or 2.

n12 in Formula (Le-A) is preferably 0 or 1, and more preferably 0.

From the viewpoint of color formability and visibility of exposed portions, the acid color-forming agent preferably includes a compound represented by Formula (Le-11).

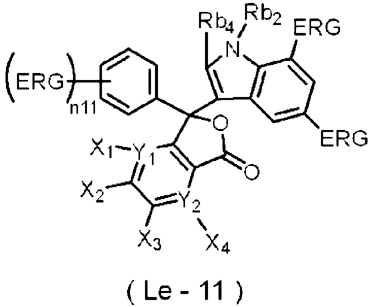

In Formula (Le-11), ERG's each independently represent an electron-donating group, n11 represents an integer of 1 to 5, X₁ to X₄ each independently represent a hydrogen atom, a halogen atom, or a dialkylanilino group, Y₁ and Y₂ each independently represent C or N, X₁ is not present in a case where Y₁ represents N, X₄ is not present in a case where Y₂ represents N, and Rb₂ and Rb₄ each independently represent a hydrogen atom, an alkyl group, an aryl group, or a heteroaryl group.

ERG, X₁ to X₄, Y₁, Y₂, Rb₂, and Rb₄ in Formula (Le-11) each have the same definition as that for ERG, X₁ to X₄, Y₁, Y₂, Rb₂, and Rb₄ in Formulae (Le-1) to (Le-3), and the preferable aspects thereof are also the same as described above.

n 11 in Formula (Le-11) is preferably an integer of 1 to 3, and more preferably 1 or 2.

The alkyl group in Formula (Le-1) to Formula (Le-9), Formula (Le-A), or Formula (Le-11) may be linear, branched, or may have a ring structure.

The number of carbon atoms in the alkyl group in Formula (Le-1) to Formula (Le-9), Formula (Le-A), or Formula (Le-11) is preferably 1 to 20, more preferably 1 to 8, even more preferably 1 to 4, and particularly preferably 1 or 2.

The number of carbon atoms in the aryl group in Formula (Le-1) to Formula (Le-11), or Formula (Le-A) is preferably 6 to 20, more preferably 6 to 10, and particularly preferably 6 to 8.

Specific examples of the aryl group in Formula (Le-1) to Formula (Le-11), or Formula (Le-A) include a phenyl group, a naphthyl group, an anthracenyl group, a phenanthrenyl group, and the like, which may have a substituent.

Specific examples of the heteroaryl group in Formula (Le-1) to Formula (Le-11), Formula (Le-A) include a furyl group, a pyridyl group, a pyrimidyl group, a pyrazoyl group, a thiophenyl group, and the like, which may have a substituent.

Each of the groups in Formula (Le-1) to Formula (Le-11), or Formula (Le-A), such as a monovalent organic group, an alkyl group, an aryl group, a heteroaryl group, a dialkylanilino group, an alkylamino group, and an alkoxy group, may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, a cyano group, and the like. In addition, these substituents may be further substituted with these substituents.

In addition, from the viewpoint of color formability and visibility of the exposed portion, it is preferable that the acid color-forming agent contains a compound represented by any of Formulae 3a and 3b.

As a preferred aspect, the acid color-forming agent is preferably a compound represented by any of Formulae 3a and 3b.

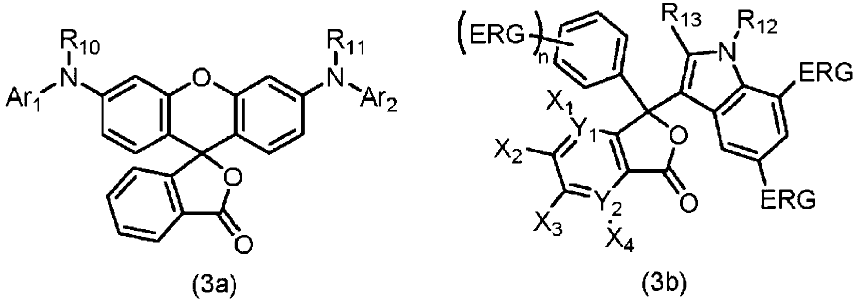

In Formula (3a),
Ar₁ and Ar₂ each independently represent an aryl group or a heteroaryl group, and

R₁₀ and R₁₁ each independently represent a hydrogen atom, an alkyl group, an aryl group, or a heteroaryl group.

In Formula (3b), ERG's each independently represent an electron-donating group, n represents an integer of 1 to 5, X₁ to X₄ each independently represent a hydrogen atom, a halogen atom, or a monovalent organic group, Y₁ and Y₂ each independently represent C or N, X₁ does not exist in a case where Y₁ is N, X₄ does not exist in a case where Y₂ is N, and R₁₂ and R₁₃ each independently represent a hydrogen atom, an alkyl group, an aryl group, or a heteroaryl group.

The alkyl group in Formula (3a) and Formula (3b) may be linear, branched, or may have a ring structure.

In addition, the number of carbon atoms in the alkyl group in Formula (3a) and Formula (3b) is preferably 1 to 20, more preferably 1 to 8, still more preferably 1 to 4, and particularly preferably 1 or 2.

The number of carbon atoms in the aryl group in Formula (3a) and Formula (3b) is preferably 6 to 20, more preferably 6 to 10, and particularly preferably 6 to 8.

Specific examples of the aryl group in Formula (3a) and Formula (3b) include a phenyl group, a naphthyl group, an anthracenyl group, and a phenanthrenyl group, which may have a substituent.

Specific examples of the heteroaryl group in Formula (3a) and Formula (3b) include a furyl group, a pyridyl group, a pyrimidyl group, a pyrazoyl group, and a thiophenyl group, which may have a substituent.

ERG in Formula (3b) has the same meaning as ERG in Formula (Le-1) to Formula (Le-3), and the same applies to the preferred aspect thereof.

n in Formula (3b) is preferably an integer of 1 to 3, and more preferably 1 or 2.

The monovalent organic group in Formula (3b) has the same meaning as the monovalent organic group as X₅ to X₁₀ in Formula (Le-2) and Formula (Le-3), and the same applies to the preferred aspect thereof.

In addition, each of the groups such as the monovalent organic group, the alkyl group, the aryl group, and the heteroaryl group in Formula (3a) and Formula (3b) may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, a cyano group, and the like. In addition, these substituents may be further substituted with these substituents.

The leuco coloring agent having a phthalide structure or a fluoran structure that can be suitably used is not particularly limited, and examples thereof include compounds described in [0141] to [0150] of JP2023-98447A.

In addition, as the acid color-forming agent, compounds described in [0151] to [0188] of JP2023-98447A can also be used.

Each of these acid color-forming agents may be used alone. Alternatively, two or more components can be used in combination.

The content of the acid color-forming agent with respect to the total solid content of the image-recording layer is preferably 0.5% by mass to 10% by mass and more preferably 1% by mass to 5% by mass.

### (Polymer compound)

The polymer compound may function as a binder polymer of the image-recording layer, or may be present in the image-recording layer as a particle-formed polymer compound (polymer particles).

### <Binder polymer>

As the binder polymer, a polymer having film forming properties is preferable, and preferred examples thereof include a (meth)acrylic resin, a polyvinyl acetal resin, a polyurethane resin, and the like.

As the binder polymer used in the image-recording layer, a binder polymer having an alkylene oxide chain is preferable. The binder polymer having an alkylene oxide chain may have a poly(alkylene oxide) moiety on a main chain or side chain. In addition, the binder polymer may be a graft polymer having poly(alkylene oxide) moiety on a side chain or a block copolymer of a block configured with a poly(alkylene oxide) moiety-containing repeating unit and a block configured with an (alkylene oxide) moiety-free repeating unit.

As a binder polymer having a poly(alkylene oxide) moiety on a main chain, a polyurethane resin is preferable. In a case where the binder polymer has a poly(alkylene oxide) moiety on a side chain, examples of polymers as the main chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.

As the alkylene oxide, an alkylene oxide having 2 to 6 carbon atoms is preferable, and ethylene oxide or propylene oxide is particularly preferable.

The number of repetitions of alkylene oxide in the poly(alkylene oxide) moiety is preferably 2 to 120, more preferably 2 to 70, and even more preferably 2 to 50.

It is preferable that the number of repetitions of alkylene oxide be 120 or less, because then printing durability deterioration resulting from abrasion and printing durability deterioration resulting from deterioration of ink receiving properties are suppressed.

The poly(alkylene oxide) moiety is preferably contained in the binder polymer as a side chain of the binder polymer in the form of a structure represented by Formula (AO), and more preferably contained in the binder polymer as a side chain of a (meth)acrylic resin in the form of a structure represented by Formula (AO).

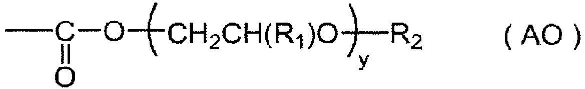

In Formula (AO), y represents 2 to 120, R₁ represents a hydrogen atom or an alkyl group, and R₂ represents a hydrogen atom or a monovalent organic group.

As the monovalent organic group, an alkyl group having 1 to 6 carbon atoms is preferable. Specifically, examples thereof include a methyl group, an ethyl group, an n-propyl group, an isopropyl group, an n-butyl group, a sec-butyl group, an isobutyl group, a tert-butyl group, an n-pentyl group, an isopentyl group, a neopentyl group, an n-hexyl group, an isohexyl group, a 1,1-dimethylbutyl group, a 2,2-dimethylbutyl group, a cyclopentyl group, and a cyclohexyl group.

In Formula (AO), y is preferably 2 to 70, and more preferably 2 to 50. R₁ is preferably a hydrogen atom or a methyl group, and particularly preferably a hydrogen atom. R₂ is particularly preferably a hydrogen atom or a methyl group.

In order to enhance the film hardness of an image area, the binder polymer may have crosslinking properties. In order to impart crosslinking properties to the polymer, a crosslinking functional group such as an ethylenically unsaturated bond may be introduced into a main chain or a side chain of the polymer. The crosslinking functional group may be introduced by either copolymerization or a polymer reaction.

Examples of the polymer having an ethylenically unsaturated bond on a main chain of the molecule include poly-1,4-butadiene, poly-1,4-isoprene, and the like.

Examples of the polymer having an ethylenically unsaturated bond on a side chain of the molecule include a polymer of an ester or amide of an acrylic or methacrylic acid in which a residue of the ester or amide (R of -COOR or -CONHR) has an ethylenically unsaturated bond.

Examples of the residue (R described above) having an ethylenically unsaturated bond include-(CH₂)ₙCR^{1A}= CR^{2A}R^{3A},-(CH₂O)ₙCH₂CR^{1A}=CR2^{A} R^{3A},-(CH₂CH₂O)ₙCH₂CR^{1A}=CR^{2A}R^{3A}, -(CH₂),NH-CO-O-CH₂CR^{1A}=CR^{2A}R^{3A} -(CH₂)ₙ-O-CO-CR^{1A}= CR^{2A}R^{1A}, and -(CH₂CH₂O)₂-X^{A} (in the formulas, R^{A1} to R^{A3} each independently represent a hydrogen atom, a halogen atom, an alkyl group having 1 to 20 carbon atoms, an aryl group, an alkoxy group, or an aryloxy group, R^{A1} and R^{A2} or R^{A3} may be bonded to each other to form a ring, n represents an integer of 1 to 10, and X^{A} represents a dicyclopentadienyl residue).

Specific examples of the ester residue include -CH₂CH=CH₂, -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂, and -CH₂CH₂O-X (in the formula, X represents a dicyclopentadienyl residue).

Specific examples of the amide residue include -CH₂CH=CH₂, -CH₂CH₂-Y (in the formula, Y represents a cyclohexene residue), and -CH₂CH₂-OCO-CH=CH₂.

For example, free radicals (polymerization initiating radicals or growing radicals in a polymerization process of a polymerizable compound) are added to crosslinking functional groups of the binder polymer having crosslinking properties, the polymers are addition-polymerized directly or via polymerization chains of polymerizable compounds, and crosslinks are formed between the polymer molecules, which cures the binder polymer. Alternatively, atoms in the polymer (for example, hydrogen atoms on carbon atoms adjacent to a functional crosslinking group) are abstracted by free radicals to generate polymer radicals, and the polymer radicals are bonded to each other, which forms crosslinks between the polymer molecules and cures the binder polymer.

From the viewpoint of excellent sensitivity and excellent storage stability, the content of the crosslinkable group (content of the unsaturated double bond capable of being radically polymerized by iodine titration) in the binder polymer per 1 g of the binder polymer is preferably 0.1 to 10.0 mmol, more preferably 1.0 to 7.0 mmol, and even more preferably 2.0 to 5.5 mmol.

Specific examples 1 to 11 of the binder polymer will be shown below, but the present invention is not limited thereto. In the following exemplary compounds, the numerical value written together with each repeating unit (the numerical value written together with the main chain repeating unit) represents the molar percentage of the repeating unit. The numerical value written together with the repeating unit of the side chain means the number of repetitions of the repeating moiety. In addition, Me represents a methyl group, Et represents an ethyl group, and Ph represents a phenyl group.

(1) 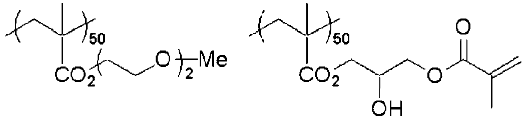
(2) 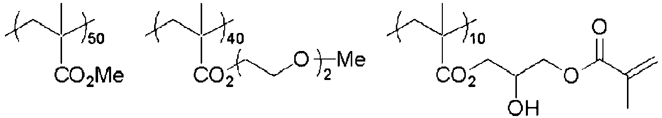
(3) 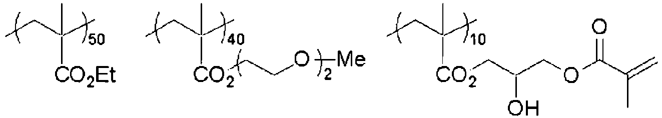
(4) 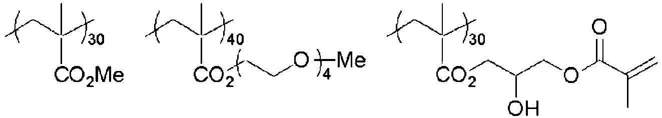
(5) 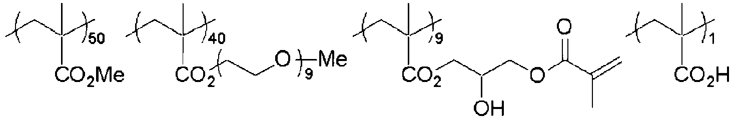
(6) 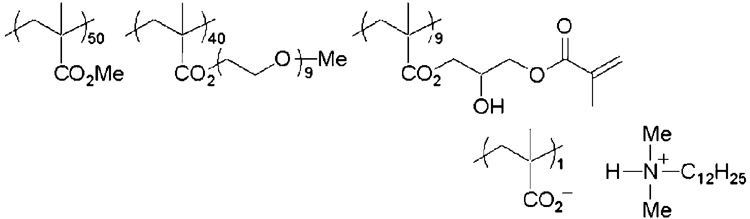
(7) 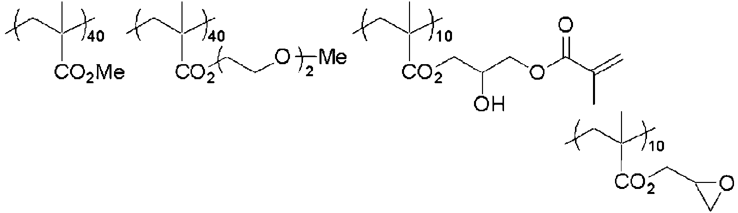
(8) 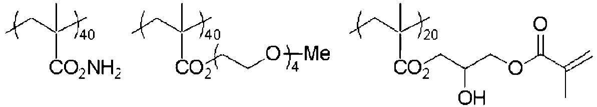
(9) 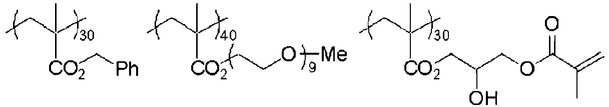
(10) 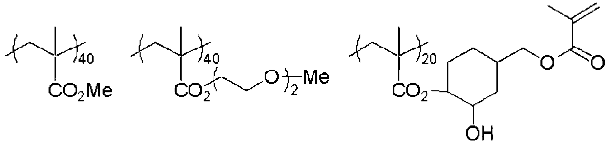
(11)

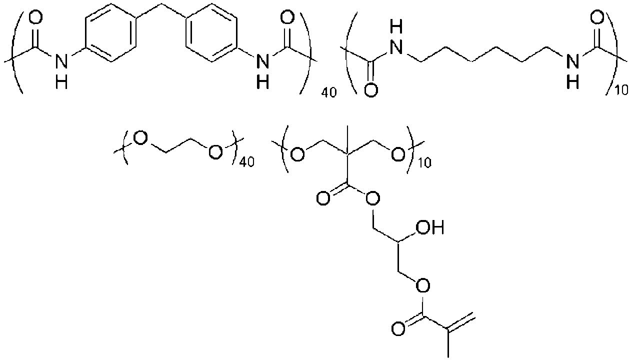

The molecular weight of the binder polymer that is a polystyrene-equivalent weight-average molecular weight (Mw) determined by GPC is preferably 2,000 or more, more preferably 5,000 or more, and still more preferably 10,000 to 300,000.

As necessary, a hydrophilic polymer such as polyacrylic acid or polyvinyl alcohol described in JP2008-195018A can be used in combination. In addition, a lipophilic polymer and a hydrophilic polymer can be used in combination.

One binder polymer may be used alone, or two or more binder polymers may be used in combination.

The content of the binder polymer in the total solid content of the image-recording layer is preferably 1% to 90% by mass, and more preferably 5% to 80% by mass.

### <Polymer compound in form of particles (polymer particles)>

It is preferable that the image-recording layer contain polymer particles. The polymer particles contribute to the improvement of on-press developability. The polymer particles are preferably polymer particles that can convert the image-recording layer into hydrophobic when heat is applied thereto. The polymer particles are preferably at least one kind of particles selected from hydrophobic thermoplastic polymer particles, thermal reactive polymer particles, polymer particles having a polymerizable group, microcapsules encapsulating a hydrophobic compound, and a microgel (crosslinked polymer particles).

Suitable examples of the hydrophobic thermoplastic polymer particles include the hydrophobic thermoplastic polymer particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like.

Specific examples of polymers constituting the hydrophobic thermoplastic polymer particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and mixtures of these. For example, copolymers having polystyrene, styrene, and acrylonitrile or polymethyl methacrylate are preferable. The average particle diameter of the hydrophobic thermoplastic polymer particles is preferably 0.01 to 2.0 µm.

Examples of the thermal reactive polymer particles include polymer particles having a thermal reactive group. The polymer particles having a thermal reactive group form a hydrophobic region through crosslinking by a thermal reaction and the accompanying change in functional groups.

As the thermal reactive group in the polymer particles having a thermal reactive group, any functional group performing any reaction may be used as long as a chemical bond is formed. As the thermal reactive group, a polymerizable group is preferable. Suitable examples of the thermal reactive group include an ethylenically unsaturated group that causes a radical polymerization reaction (for example, an acryloyl group, a methacryloyl group, a vinyl group, an allyl groups, and the like), a cationically polymerizable group (for example, a vinyl group, a vinyloxy group, an epoxy group, an oxetanyl group, and the like), an isocyanate group or a blocked isocyanate group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

Examples of the microcapsules include microcapsules encapsulating all or some of the constituent components of the image-recording layer as described in JP2001-277740A and JP2001-277742A. The constituent components of the image-recording layer can also be incorporated into the exterior of the microcapsules. In a preferred aspect of the image-recording layer containing microcapsules, hydrophobic constituent components are encapsulated in the microcapsules and hydrophilic constituent components are incorporated into the exterior of the microcapsules.

The microgel (crosslinked polymer particles) can contain some of the constituent components of the image-recording layer, in at least one of the interior or the surface of the microgel. Particularly, from the viewpoint of sensitivity in image formation and printing durability, an aspect is preferable in which a radically polymerizable group is incorporated into the surface thereof to form a reactive microgel.

In order to encapsulate the constituent components of the image-recording layer in microcapsules or microgel, known methods can be used.

An average particle diameter of the microcapsules or microgels is preferably 0.01 to 3.0 µm, more preferably 0.05 to 2.0 µm, and particularly preferably 0.10 to 1.0 µm. In a case where the average particle diameter is in this range, excellent resolution and temporal stability are obtained.

One kind of polymer particles may be used alone, or two or more kinds of polymer particles may be used in combination.

The content of the polymer particles in the total solid content of the image-recording layer is preferably 5% to 90% by mass, more preferably 5% to 80% by mass, and even more preferably 10% to 75% by mass.

As a preferred aspect, the polymer particles have a hydrophobic main chain, and include both.
i) a constituent unit having a pendant cyano group directly bonded to the hydrophobic main chain, and
ii) a constituent unit having a pendant group that contains a hydrophilic poly(alkylene oxide) segment.

Preferred examples of the hydrophobic main chain include an acrylic resin chain.

Preferred examples of the pendant cyano group include -[CH₂CH(C=N)-] or -[CH₂C(CH₃)(C≡N)-].

In addition, the constituent unit having the pendant cyano group can be easily derived from an ethylenically unsaturated monomer, for example, acrylonitrile or methacrylonitrile, or a combination of these.

Furthermore, as an alkylene oxide in the hydrophilic poly(alkylene oxide) segment, ethylene oxide or a propylene oxide is preferable, and ethylene oxide is more preferable.

The number of repeating alkylene oxide structures in the hydrophilic poly(alkylene oxide) segment is preferably 10 to 100, more preferably 25 to 75, and even more preferably 40 to 50.

As the resin particles having a hydrophobic main chain and including both i) constituent unit having the pendant cyano group directly bonded to the hydrophobic main chain and ii) constituent unit having a pendant group including the hydrophilic poly(alkylene oxide) segment, for example, the particles described in paragraphs "0039" to "0068" of JP2008-503365A are preferable.

As a preferred aspect, the polymer particles are preferably obtained by a reaction of a polyvalent isocyanate compound that is an adduct of a polyhydric phenol compound having two or more hydroxy groups in a molecule and isophorone diisocyanate, with a compound having active hydrogen.

The average particle diameter of the polymer particles is preferably in a range of 0.01 to 3.0 µm, more preferably in a range of 0.05 to 2.0 µm, and particularly preferably in a range of 0.10 to 1.0 µm. In a case where the average particle diameter is in this range, excellent resolution and temporal stability are obtained.

One kind of polymer particles may be used alone, or two or more kinds of polymer particles may be used in combination.

The content of the polymer particles in the total solid content of the image-recording layer is preferably 5% to 90% by mass, more preferably 5% to 80% by mass, and even more preferably 10% to 75% by mass.

As the polymer compound contained in the image-recording layer, a polymer compound containing a constitutional unit derived from a styrene compound and/or a constitutional unit derived from an acrylonitrile compound is also preferable. From the viewpoint of contribution to on-press developability, this polymer compound can be suitably used as a binder polymer or as polymer particles.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, styrene is preferable.

Examples of the acrylonitrile compound include acrylonitrile, methacrylonitrile, and the like. Among these, acrylonitrile is preferable.

In the polymer compound containing a styrene compound and an acrylonitrile compound as constitutional units, a compositional ratio between the constitutional unit derived from the styrene compound and the constitutional unit derived from the acrylonitrile compound is preferably 4:1 to 1:4.

### (Chain transfer agent)

The chain transfer agent contributes to the improvement of printing durability of the lithographic printing plate prepared from the lithographic printing plate precursor.

As the chain transfer agent, a thiol compound is preferable, a thiol having 7 or more carbon atoms is more preferable from the viewpoint of boiling point (low volatility), and a compound having a mercapto group on an aromatic ring (aromatic thiol compound) is even more preferable. The thiol compound is preferably a monofunctional thiol compound.

Specific examples of the chain transfer agent include the following compounds.

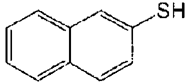

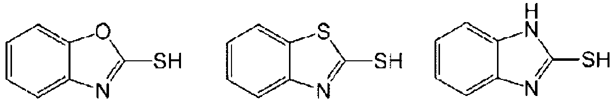

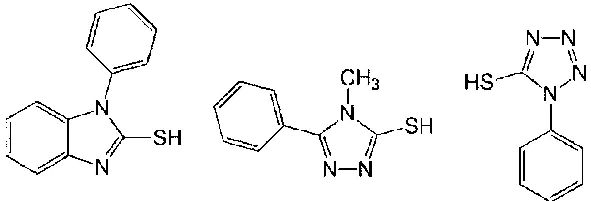

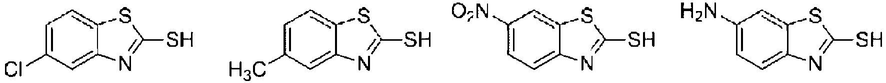

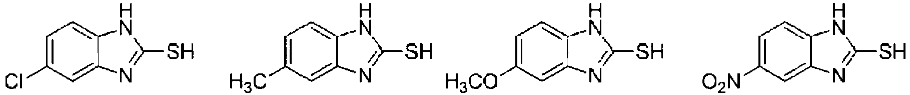

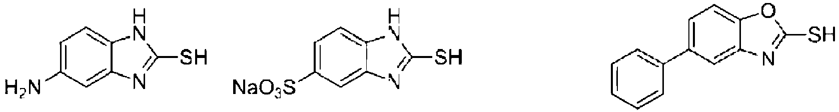

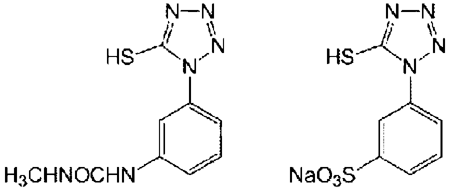

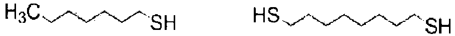

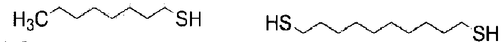

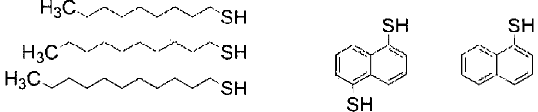

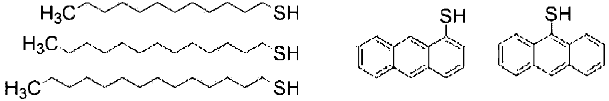

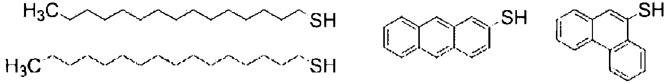

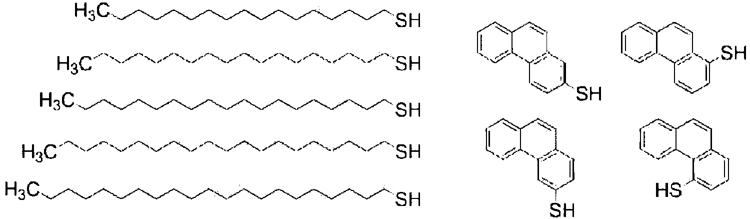

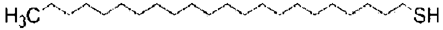

One chain transfer agent may be used alone, or two or more chain transfer agents may be used in combination.

The content of the chain transfer agent in the total solid content of the image-recording layer is preferably 0.01% to 50% by mass, more preferably 0.05% to 40% by mass, and even more preferably 0.1% to 30% by mass.

### (Oil sensitizing agent)

The oil sensitizing agent contributes to the improvement of ink receptivity (hereinafter, also simply called "receptivity") of the lithographic printing plate prepared from the lithographic printing plate precursor. Examples of the oil sensitizing agent include a phosphonium compound, a nitrogen-containing low-molecular-weight compound, an ammonium group-containing polymer, and the like. Particularly, in a case where the lithographic printing plate precursor has a protective layer containing an inorganic lamellar compound, these compounds function as a surface coating agent for the inorganic lamellar compound and can inhibit the receptivity deterioration caused in the middle of printing by the inorganic lamellar compound.

As the oil sensitizing agent, it is preferable to use a phosphonium compound, a nitrogen-containing low-molecular-weight compound, and an ammonium group-containing polymer in combination, and it is more preferable to use a phosphonium compound, quaternary ammonium salts, and an ammonium group-containing polymer in combination.

As the oil sensitizing agent, it is possible to use the compound described in [0151] to [0155] of WO2020/137919A.

The content of the oil sensitizing agent in the total solid content of the image-recording layer is preferably 0.01% to 30% by mass, more preferably 0.1% to 15% by mass, and even more preferably 1% to 10% by mass.

### (Other components)

As other components, a surfactant, a printing-out agent, a polymerization inhibitor, a higher fatty acid derivative, a plasticizer, inorganic particles, an inorganic lamellar compound, and the like can be contained in the image-recording layer. Specifically, the above components described in paragraphs "0114" to "0159" of JP2008-284817A can be used.

The content of the polymer compound having a weight-average molecular weight more than 15,000, which is not particle-shaped, with respect to the total solid content of the image-recording layer is preferably 5% by mass or less and more preferably 4% by mass or less.

### (Formation of image-recording layer)

The image-recording layer can be formed, for example, by preparing a coating liquid by appropriately dispersing or dissolving the necessary components described above in a known solvent, performing coating with the coating liquid by a known method such as bar coating, and drying the coating liquid, as described in paragraphs "0142" and "0143" of JP2008-195018A. The coating amount (solid content) of the image-recording layer after coating and drying varies with uses. However, from the viewpoint of obtaining excellent sensitivity and excellent film forming characteristics of the image-recording layer, the coating amount is preferably about 0.3 to 3.0 g/m².

From the viewpoint of imparting on-press developability, the image-recording layer preferably has water solubility or water-dispersibility. Here, the "water soluble" means that 0.1 g or more of compound is dissolved in 100 g of water at 20°C, and the "water-dispersible" means that the compound is uniformly dispersed in water at 20°C.

The on-press development type lithographic printing plate precursor according to the present invention can include an undercoat layer (also referred to as an interlayer) between the image-recording layer and the support.

### [Undercoat layer]

The undercoat layer enhances the adhesion between the support and the image-recording layer in an exposed portion, and enables the image-recording layer to be easily peeled from the support in an unexposed portion. Therefore, the undercoat layer contributes to the improvement of developability without deteriorating printing durability. In addition, in the case of exposure to an infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent groups that can be adsorbed onto the surface of the support and hydrophilic groups. In order to improve adhesiveness to the image-recording layer, it is preferable that polymers having adsorbent groups and hydrophilic groups further have crosslinkable groups. The compounds that are used in the undercoat layer may be low-molecular-weight compounds or polymers. As necessary, as the compounds that are used in the undercoat layer, two or more compounds may be used by being mixed together.

In a case where the compound used in the undercoat layer is a polymer, a copolymer of a monomer having an adsorbent group, a monomer having a hydrophilic group, and a monomer having a crosslinkable group is preferable.

As the adsorbent group that can be adsorbed onto the surface of the support, a phenolic hydroxy group, a carboxy group, -PO₃H₂, -OPO₃H₂, -CONHSO₂-, -SO₂NHSO₂-, and -COCH₂COCH₃ are preferable. As the hydrophilic groups, a sulfo group or salts thereof and salts of a carboxy group are preferable. As the crosslinkable groups, an acryloyl group, a methacryloyl group, an acrylamide group, a methacrylamide group, an allyl group, and the like are preferable.

The polymer may have a crosslinkable group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinkable groups (preferably ethylenically unsaturated bond groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinkable groups described in JP2005-125749A and JP2006-188038A are more preferable.

The content of ethylenically unsaturated bond group in the polymer used in the undercoat layer is preferably 0.1 to 10.0 mmol per gram of the polymer, and more preferably 0.2 to 5.5 mmol per gram of the polymer.

The weight-average molecular weight (Mw) of the polymer used in the undercoat layer is preferably 5,000 or more and more preferably 10,000 to 300,000.

In order to prevent contamination with the passage of time, the undercoat layer may contain, in addition to the compounds for the undercoat layer described above, a chelating agent, a secondary or tertiary amine, a polymerization inhibitor, a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.

The undercoat layer can be formed by coating with a known method, followed by drying. The coating amount (solid content) of the undercoat layer after drying is preferably 0.1 to 100 mg/m², and more preferably 1 to 30 mg/m².

The on-press development type lithographic printing plate precursor according to the present invention may have or may not have a protective layer on the image-recording layer.

### [Protective layer]

The protective layer has a function of suppressing the reaction inhibiting image formation by blocking oxygen, a function of preventing the damage of the image-recording layer, and a function of preventing ablation during exposure to high-illuminance lasers.

The protective layer having such characteristics is described, for example, in US3458311A and JP1980-49729B (JP-S55-49729B). As polymers with low oxygen permeability that are used in the protective layer, any of water-soluble polymers and water-insoluble polymers can be appropriately selected and used. If necessary, two or more such polymers can be used by being mixed together. Specific examples thereof include a polyvinyl alcohol resin (including polyvinyl alcohol and modified polyvinyl alcohol), polyvinylpyrrolidone, a water-soluble cellulose derivative, poly (meth)acrylonitrile, and the like.

As the polyvinyl alcohol, a polyvinyl alcohol having a saponification degree of 50% or more is suitable. The saponification degree of the polyvinyl alcohol is preferably 60% or more, more preferably 70% or more, and even more preferably 85% or more. The upper limit of the saponification degree is not particularly limited. The saponification degree may be 100% or less.

The saponification degree can be measured according to the method described in JIS K 6726:1994.

As the modified polyvinyl alcohol, acid-modified polyvinyl alcohol having a carboxy group or a sulfo group is preferably used. Specific examples thereof include the modified polyvinyl alcohols described in JP2005-250216A and JP2006-259137A.

Among water-soluble polymers, a polyvinyl alcohol resin is preferable.

In order to improve oxygen barrier properties, it is preferable that the protective layer contain an inorganic lamellar compound. The inorganic lamellar compound refers to particles in the form of a thin flat plate, and examples thereof include mica groups such as natural mica and synthetic mica, talc represented by Formula 3MgO·4SiO·H₂O, taeniolite, montmorillonite, saponite, hectorite, zirconium phosphate, and the like.

As the inorganic lamellar compound, a mica compound is preferably used. Examples of the mica compound include mica groups such as natural mica and synthetic mica represented by Formula: A(B, C)₂₋₅D₄O₁₀(OH, F, O)₂ [here, A represents any of K, Na, and Ca, B and C represent any of Fe (II), Fe (III), Mn, Al, Mg, and V, and D represents Si or Al.].

In the mica group, examples of the natural mica include muscovite, soda mica, phlogopite, biotite, and lepidolite. Examples of synthetic mica include non-swelling mica such as fluorophlogopite KMg₃(AlSi₃O₁₀)F₂, potassium tetrasilic mica KMg_{2.5}(Si₄O₁₀)F₂, and, Na tetrasilylic mica NaMg_{2.5}(Si₄O₁₀)F₂, swelling mica such as Na or Li taeniolite (Na, Li)Mg₂Li(Si₄O₁₀)F₂, montmorillonite-based Na or Li hectorite (Na, Li)_{1/8}Mg_{2/5}Li_{1/8}(Si₄O₁₀)F₂, and the like. Furthermore, synthetic smectite is also useful.

Among the mica compounds, fluorine-based swelling mica is particularly useful. That is, swelling synthetic mica has a laminated structure consisting of unit crystal lattice layers having a thickness in a range of approximately 10 to 15Å, and metal atoms in lattices are more actively substituted than in any other clay minerals. As a result, positive charges are deficient in the lattice layers, and positive ions such as Li⁺, Na⁺, Ca²⁺, and Mg²⁺ are adsorbed between the layers in order to compensate for the deficiency. Positive ions interposed between the layers are referred to as exchangeable positive ions and are exchangeable with various positive ions. Particularly, in a case where the positive ions between the layers are Li⁺ and Na⁺, the ionic radii are small, and thus the bonds between lamellar crystal lattices are weak, and mica is significantly swollen by water. In a case where shear is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired. As a result, the aspect ratio is preferably 20 or more, more preferably 100 or more, and particularly preferably 200 or more. The aspect ratio is the ratio of the major diameter to the thickness of a particle, and it can be measured, for example, from a projection view obtained from the microphotograph of the particle. As the aspect ratio increases, the obtained effect is stronger.

Regarding the particle diameter of the mica compound, the average major diameter thereof is preferably 0.3 to 20 µm, more preferably 0.5 to 10 µm, and particularly preferably 1 to 5 µm. The average thickness of the particles is preferably 0.1 µm or less, more preferably 0.05 µm or less, and particularly preferably 0.01 µm or less. Specifically, for example, in the case of swelling synthetic mica which is a typical compound, an aspect is preferable in which the compound has a thickness of about 1 to 50 nm and a surface size (major diameter) of about 1 to 20 µm.

The content of the inorganic lamellar compound in the total solid content of the protective layer is preferably 0% to 60% by mass, and more preferably 3% to 50% by mass. Even in a case where two or more inorganic lamellar compounds are used in combination, the total amount of the inorganic lamellar compounds preferable equals the content described above. In a case where the content is within the above range, the oxygen barrier property is improved, and excellent sensitivity is obtained. In addition, the deterioration of receptivity can be prevented.

The content of the inorganic lamellar compound is preferably 0.01 to 100 mg/m², more preferably 5 to 80 mg/m², and particularly preferably 5 to 50 mg/m².

The protective layer may contain known additives such as a plasticizer for imparting flexibility, a surfactant for improving coating properties, and inorganic fine particles for controlling surface sliding properties. In addition, the oil sensitizing agent described above regarding the image-recording layer may be contained in the protective layer.

The protective layer can be formed by performing coating with a known method, followed by drying. The coating amount (solid content) of the protective layer after drying is preferably 0.01 to 10 g/m², more preferably 0.02 to 3 g/m², and particularly preferably 0.02 to 1 g/m².

The on-press development type lithographic printing plate precursor according to an embodiment of the present invention may have a bevel shape at end parts.

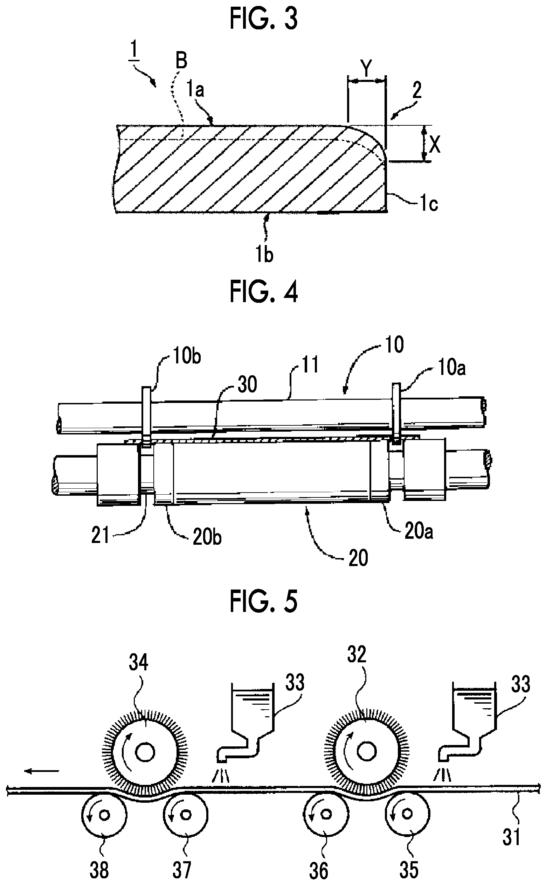

FIG. 3 is a schematic view showing a cross-sectional shape of an end part of a lithographic printing plate precursor.

In FIG. 3, a lithographic printing plate precursor 1 has a bevel 2 at an end part thereof. A distance X between the upper edge of an edge surface 1c of the lithographic printing plate precursor 1 (boundary point between the bevel 2 and the edge surface 1c) and an intersection between an extension line of the edge surface 1c and an extension line of an image-recording layer surface (protective layer surface in a case where a protective layer is formed) 1a is called "bevel amount X". A distance Y between a point at which the image-recording layer surface 1a of the lithographic printing plate precursor 1 begins to be beveled and the aforementioned intersection is called "bevel width Y".

In the bevel shape of the end part, the bevel amount X is preferably 25 µm or more, more preferably 35 µm or more, and even more preferably 40 µm or more. From the viewpoint of preventing on-press developability deterioration resulting from the deterioration of surface condition of the end part, the upper limit of the bevel amount X is preferably 150 µm. In a case where on-press developability deteriorates, ink adheres to the residual image-recording layer, which sometimes leads to the occurrence of edge contamination. In a case where the bevel amount X is too small, the ink having adhered to the end part is likely to be transferred to a blanket, which sometimes leads to the occurrence of edge contamination. In a case where the bevel amount X is in a range of 25 to 150 µm, and the bevel width Y is small, the occurrence of cleaves at the end part increases, and the printing ink is accumulated in the cleaves, which sometimes leads to edge contamination. In this respect, the bevel width Y is preferably in a range of 70 to 300 µm, and more preferably in a range of 80 to 250 µm. It should be noted that the ranges of the bevel amount and bevel width are not involved in the edge shape of a support surface 1b of the lithographic printing plate precursor 1.

Usually, at the end part of the lithographic printing plate precursor 1, bevels occur in a boundary B between the image-recording layer and the support and in the support surface 1b as in the image-recording layer surface 1a.

The end part having the bevel shape can be formed, for example, by adjusting the cutting conditions of the lithographic printing plate precursor.

Specifically, the beveled end part can be formed by adjusting the gap between an upper cutting blade and a lower cutting blade in a slitter device used for cutting the lithographic printing plate precursor, intrusion amounts of the blades, tip angle of the blades, and the like.

FIG. 4 is a conceptual view showing an example of a cutting portion of a slitter device. In the slitter device, a pair of upper and lower cutting blades 10 and 20 are vertically disposed. The cutting blades 10 and 20 consist of round blades on a disk. Upper cutting blades 10a and 10b are coaxially supported by a rotary shaft 11, and lower cutting blades 20a and 20b are coaxially supported by a rotary shaft 21. The upper cutting blades 10a and 10b and the lower cutting blades 20a and 20b rotate in opposite directions. A lithographic printing plate precursor 30 is passed between the upper cutting blades 10a and 10b and the lower cutting blades 20a and 20b and is cut in a predetermined width. By adjusting the gap between the upper cutting blade 10a and the lower cutting blade 20a and the gap between the upper cutting blade 10b and the lower cutting blade 20b of the cutting portion of the slitter device, it is possible to form an end part having a bevel shape.

In the on-press development type lithographic printing plate precursor according to the embodiment of the present invention, the arithmetic mean height Sa of the surface of the outermost layer on the side opposite to the side where the image-recording layer is provided is preferably in a range of 0.3 to 20 µm. Here, the side opposite to the side where the image-recording layer is provided means the side opposite to the side where the image-recording layer is provided with reference to the support.

In the on-press development type lithographic printing plate precursor according to the embodiment of the present invention, the arithmetic mean height Sa of the surface of the outermost layer on the side where the image-recording layer is provided is preferably in a range of 0.3 to 20 µm. Here, the side where the image-recording layer is provided means the side where the image-recording layer is provided with reference to the support.

By providing the outermost layer surface having such characteristics, even in a case of being stacked in a form in which an interleaving paper is not interleaved between precursors (also referred to as elimination of interleaving paper), the on-press development type lithographic printing plate precursor according to the embodiment of the present invention is excellent in properties such as a property of preventing multiple plates from being fed in a step of taking out a precursor from a stack, a property of preventing scratches caused by a projection provided on the surface of the outermost layer of the precursor, and a property of preventing development delay caused by a projection provided on the surface of the outermost layer of the precursor.

In a case where the outermost layer surface on the side opposite to the side where the image-recording layer is provided has a backcoat layer on the opposite side, the outermost layer surface is the surface of the backcoat layer. In a case where the outermost layer surface has no layer on the opposite side, the outermost layer surface is the support surface.
For example, in a case where protrusions that will be described later are formed, the backcoat layer may be the outermost layer of the lithographic printing plate precursor, and a plurality of protrusions containing a polymer compound may be on the backcoat layer. Alternatively, the support may be the outermost layer, and a plurality of protrusions containing a polymer compound may be on the support.

In a case where an image-recording layer or a protective layer is the outermost layer, the outermost layer surface on the side where the image-recording layer is provided is the surface of the image-recording layer or the surface of the protective layer.

For example, in a case where protrusions that will be described later are formed, the image-recording layer or the protective layer may be the outermost layer of the lithographic printing plate precursor, and a plurality of protrusions containing a polymer compound may be on the image-recording layer or the protective layer.

The arithmetic mean height Sa of the surface of the outermost layer on the side opposite to the side where the image-recording layer is provided is more preferably in a range of 0.5 to 10 µm, and even more preferably in a range of 0.5 to 7 µm.

The arithmetic mean height Sa of the surface of the outermost layer on the side where the image-recording layer is provided is more preferably in a range of 0.5 to 10 µm, and even more preferably in a range of 0.5 to 7 µm.

The arithmetic mean height Sa of the outermost layer surface is measured according to the method described in ISO 25178. Specifically, the arithmetic mean height Sa is obtained by using MICROMAP MM3200-M100 (manufactured by Mitsubishi Chemical Systems, Inc.), selecting three or more sites from the same sample, performing the measurement, and averaging the obtained values. Regarding the measurement range, a range of 500 µm × 500 µm randomly selected from the sample surface is measured.

In order that the condition where the arithmetic mean height Sa of the outermost layer surface is 0.3 to 20 µm is satisfied, it is preferable that the outermost layer be in the form having irregularities.

Specifically, examples of aspects thereof include an aspect in which the outermost layer contains particles having an average particle diameter of 0.5 to 20 µm (aspect 1), and an aspect in which a plurality of protrusions containing a polymer compound as a main component is on the outermost layer (aspect 2). Here, the main component indicates a component whose content ratio (% by mass) is the highest.

In the aspect 1, the particles having an average particle diameter of 0.5 to 20 µm are not particularly limited, but are preferably at least one kind of particles selected from organic resin particles and inorganic particles.

As the particles, particles described in [0150] to [0166] of WO2022/138880A can be used.

In the aspect 1, the average particle diameter of the particles is preferably in a range of 0.5 to 10 µm and more preferably in a range of 0.5 to 5 µm.

The average particle diameter of particles means a volume average particle diameter. The volume average particle diameter is measured with a laser diffraction/scattering-type particle size distribution analyzer. Specifically, the measurement is performed using, for example, a particle size distribution measuring device "MICROTRAC MT-3300II" (manufactured by Nikkiso Co., Ltd.).

For other particles, unless otherwise specified, the average particle diameter is measured by the above measuring method.

In the aspect 1, an in-plane density of particles having an average particle diameter of 0.5 to 20 µm is preferably 10,000 particles/mm² or less. The in-plane density is more preferably 100 to 5,000 particles/mm², and even more preferably 100 to 3,000 particles/mm².

The in-plane density can be checked by observing the surface of the lithographic printing plate precursor with a scanning electron microscope (SEM). Specifically, five sites within the surface of the lithographic printing plate precursor are observed with a scanning electron microscope (SEM), the number of particles is counted and converted into the number of particles per area (mm²) of the visual field of observation, and the average thereof is calculated. In this way, the in-plane density can be determined.

It is preferable that the outermost layer on the side opposite to the side where the image-recording layer is provided contain a binder, in addition to the particles having an average particle diameter of 0.5 to 20 µm.

The binder preferably contains at least one compound selected from the group consisting of a novolac or resol resin such as a phenolformaldehyde resin, an m-cresol formaldehyde resin, a p-cresol formaldehyde resin, an m-/p-mixed cresol formaldehyde resin, or a phenol/cresol (which may be any of m-, p-, or m-/p-mixed) mixed formaldehyde resin, pyrogallol, an acetone resin, an epoxy resin, a saturated copolymerized polyester resin, a phenoxy resin, a polyvinyl acetal resin, a vinylidene chloride copolymer resin, polybutene, polybutadiene, polyamide, an unsaturated copolymerized polyester resin, polyurethane, polyurea, polyimide, polysiloxane, polycarbonate, an epoxy resin, chlorinated polyethylene, an aldehyde condensation resin of alkylphenol, polyvinyl chloride, polyvinylidene chloride, polystyrene, polyacrylate, a carboxyvinyl polymer, an acrylic resin copolymer resin, hydroxycellulose, hydroxymethylcellulose, polyvinyl alcohol, polyvinylpyrrolidone, cellulose acetate, methylcellulose, and carboxymethylcellulose. In order to prevent concerns on dissolution in dampening water during on-press development, a water-insoluble resin is preferable.

In addition, the binder preferably contains at least one compound selected from the group consisting of polyurethane, an acrylic resin, polystyrene, and polyethylene.

Furthermore, in the aspect 1, it is preferable that the aforementioned particles and the binder each independently contain at least one compound selected from the group consisting of polyurethane, an acrylic resin, polystyrene, and polyethylene.

The outermost layer on the side opposite to the side where the image-recording layer is provided may contain other components in addition to the particles and the binder. Examples of those other components include known additives, such as a surfactant.

The thickness of the outermost layer on the side opposite to the side where the image-recording layer is provided is preferably in a range of 0.5 to 10 µm, more preferably in a range of 0.5 to 5 µm, and still more preferably in a range of 0.5 to 3 µm.

The polymer compound configuring the plurality of protrusions containing a polymer compound as a main component in the aspect 2 preferably contains at least one polymer compound selected from the group consisting of a novolac or resol resin such as a phenolformaldehyde resin, an m-cresol formaldehyde resin, a p-cresol formaldehyde resin, an m-/p-mixed cresol formaldehyde resin, or a phenol/cresol (which may be any of m-, p-, or m-/p-mixed) mixed formaldehyde resin, pyrogallol, an acetone resin, an epoxy resin, a saturated copolymerized polyester resin, a phenoxy resin, a polyvinyl acetal resin, a vinylidene chloride copolymer resin, polybutene, polybutadiene, polyamide, an unsaturated copolymerized polyester resin, polyurethane, polyurea, polyimide, polysiloxane, polycarbonate, an epoxy resin, chlorinated polyethylene, an aldehyde condensation resin of alkylphenol, polyvinyl chloride, polyvinylidene chloride, polystyrene, polyacrylate, a carboxyvinyl polymer, an acrylic resin copolymer resin, hydroxycellulose, hydroxymethylcellulose, polyvinyl alcohol, polyvinylpyrrolidone, cellulose acetate, methylcellulose, and carboxymethylcellulose.

Among these, from the viewpoint of causing excellent developability to be exhibited even in a case where the detached protrusions move to the image-recording layer, a water-soluble polymer is more preferable. Specific examples thereof include polyacrylate, a carboxyvinyl polymer, an acrylic resin copolymer resin, hydroxycellulose, hydroxymethyl cellulose, polyvinyl alcohol, modified polyvinyl alcohol, polyvinylpyrrolidone, cellulose acetate, methylcellulose, carboxymethyl cellulose, and the like.

As the modified polyvinyl alcohol, acid-modified polyvinyl alcohol having a carboxy group or a sulfo group is preferably used. Specifically, the modified polyvinyl alcohols described in JP2005-250216A and JP2006-259137A are suitable.

The shape and height of the protrusions are not particularly limited, but the arithmetic mean height Sa is preferably 0.3 to 20 µm.

The method of forming protrusions in a stripe pattern (stripe coating film) is not particularly limited. It is possible to easily form such protrusions by performing coating with a composition containing at least one component selected from the group consisting of particles and a polymer compound, by at least one method selected from the group consisting of a bar coating method, an ink jet printing method, a gravure printing method, a screen printing method, a spray coating method, and a slot die coating method.

The method of forming protrusions in a dot pattern (dot coating film) is not particularly limited. It is possible to easily form such protrusions by performing coating with a composition containing at least one component selected from the group consisting of particles and a polymer compound, by at least one method selected from the group consisting of a spray coating method, an ink jet printing method, and a screen printing method.

The method of forming protrusions in a broken line pattern (broken line coating film) is not particularly limited. It is possible to easily form such protrusions by performing coating with a composition containing at least one component selected from the group consisting of particles and a polymer compound, by at least one method selected from the group consisting of an ink jet printing method and a screen printing method.

Examples of the binder contained in the outermost layer in the aspect 2 include the same polymer compound as the polymer compound contained in the protrusions, and preferred aspects thereof are also identical.

In the aspect 2, from the viewpoint of preventing the detachment of the protrusions, it is preferable that the binder contained in the outermost layer and the polymer compound contained in the protrusions contain the same type of resin. The "same type of resin" means that the types of resins, such as polyurethane, an acrylic resin, polystyrene, and polyethylene, are identical, and it is not necessary for all the constitutional units in the resins to be the same as each other.

### [Method of preparing printing plate]

The method of preparing a printing plate according to an embodiment of the present invention will be described using the lithographic printing plate precursor according to an embodiment of the present invention. The method of preparing a printing plate includes a step (exposure step) of image-exposing a lithographic printing plate precursor and a step (on-press development step) of removing an unexposed portion of an image-recording layer in the image-exposed lithographic printing plate precursor on a printing press by supplying at least one of printing ink or dampening water.

### [Exposure step]

The image exposure is preferably performed by a method of scanning and exposing digital data with an infrared laser or the like.

The wavelength of an exposure light source to be used is preferably 750 to 1,400 nm. As the light source having a wavelength of 750 to 1,400 nm, a solid-state laser or a semiconductor laser that radiates infrared rays is suitable. The exposure mechanism may be any of an in-plane drum method, an external surface drum method, a flat head method, and the like.

The exposure step can be performed by a known method using a platesetter or the like. In addition, a printing press comprising an exposure device may be used, the lithographic printing plate precursor may be mounted on the printing press, and then image exposure may be performed on the printing press.

### [On-press development step]

In the on-press development step, in a case where printing begins by supplying a printing ink and dampening water on a printing press without performing any development treatment on the lithographic printing plate precursor after image exposure, the unexposed portion of the lithographic printing plate precursor is removed at the initial stage during printing. As a result, the surface of the hydrophilic support is exposed, and a non-image area is formed. As the printing ink and the dampening water, known printing ink and dampening water for lithographic printing are used. What is supplied first to the surface of the printing plate precursor may be any of the printing ink or dampening water. In view of preventing the plate from being contaminated by the components of the image-recording layer from which the dampening water is removed, it is preferable that the printing ink be supplied first.

In the manner described above, the lithographic printing plate precursor is subjected to on-press development on an offset printing press and used as it is for printing a number of sheets.

The method of preparing a printing plate according to the embodiment of the present invention may include known steps other than the above-described steps. Examples of those other steps include a plate inspection step of checking the position and orientation of the lithographic printing plate precursor before each step, a checking step of checking a print-out image after the on-press development step, and the like.

### Examples

Hereinafter, the present invention will be specifically described based on examples, but the present invention is not limited thereto. In examples, unless otherwise specified, "%" and "part" mean "% by mass" and "part by mass" respectively. Unless otherwise described, the molecular weight of a polymer compound is a weight-average molecular weight (Mw), and the ratio of repeating constitutional units of a polymer compound is expressed as molar percentage. The weight-average molecular weight (Mw) is a value in terms of polystyrene obtained by performing measurement using a gel permeation chromatography (GPC) method.

### [Examples 1 to 67 and Comparative Examples 1 and 2]

### <Preparation of support 1>

The following treatments (J-a) to (J-m) were performed on an aluminum plate (aluminum alloy plate) made of a material 1S having a thickness of 0.3 mm, thereby manufacturing a support 1. A rinsing treatment was performed between all the treatment steps. After the rinsing treatment, water was drained using a nip roller.

### (J-a) Mechanical roughening treatment (brush graining method)

By using the device shown in FIG. 5, a pumice suspension (specific gravity: 1.1 g/cm³) as an abrasive slurry was supplied to the surface of an aluminum plate, and in this state, a mechanical roughening treatment is performed using a rotating bundled brush. In FIG. 5, 31 represents an aluminum plate, 32 and 34 represent roller-shaped brushes (bundled brushes in the present example), 33 represents an abrasive slurry, and 35, 36, 37, and 38 represent support rollers.

In the mechanical roughening treatment, an abrasive having a median diameter (µm) of 30 µm and 4 brushes were used, and the rotation speed (rpm) of the brushes was set to 250 rpm. The bundled brush was made of 6·10 nylon and consisted of bristles having a diameter of 0.3 mm and a length of 50 mm. The brush was prepared by making holes in a φ 300 mm stainless steel cylinder and densely implanting bristles therein. The distance between two support rollers (φ 200 mm) under the bundled brush was 300 mm. The bundled brush was pressed until the load of the drive motor for rotating the brush was 10 kW higher than the load applied before the bundled brush was pressed on the aluminum plate. The rotation direction of the brush was the same as the moving direction of the aluminum plate.

### (J-b) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 10 g/m².

### (J-c) Desmutting treatment using acidic aqueous solution

As an acidic aqueous solution, the waste liquid of nitric acid used in the following step, an electrochemical roughening treatment, at a liquid temperature of 35°C was sprayed on the aluminum plate for 3 seconds. In this way, a desmutting treatment was performed.

### (J-d) Electrochemical roughening treatment using aqueous nitric acid solution

An electrochemical roughening treatment was continuously performed using alternating current voltage of 60 Hz. An electrolytic solution at a liquid temperature of 35°C was used which was prepared by adding aluminum nitrate to 10.4 g/L aqueous nitric acid solution such that the aluminum ion concentration was adjusted to 4.5 g/L. By using an alternating current power source having the waveform shown in FIG. 1, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in FIG. 2 was used. The peak current density was 30 A/dm², and 5% of the current coming from the power source was allowed to flow into the auxiliary anode. The electricity quantity (C/dm²) was 185 C/dm², which is the total quantity of electricity used during the anodic reaction of the aluminum plate.

### (J-e) Alkaline etching treatment

An aqueous solution of caustic soda having a caustic soda concentration of 27% by mass and an aluminum ion concentration of 2.5% by mass was sprayed onto the aluminum plate at a temperature of 50°C, thereby performing an etching treatment. The amount of dissolved aluminum was 3.5 g/m².

### (J-f) Desmutting treatment using acidic aqueous solution

As an acidic aqueous solution, an aqueous solution at a liquid temperature of 30°C having a sulfuric acid concentration of 170 g/L and an aluminum ion concentration of 5 g/L was sprayed on an aluminum plate for 3 seconds, thereby performing a desmutting treatment.

### (J-g) Electrochemical roughening treatment using aqueous hydrochloric acid solution

An electrochemical roughening treatment was continuously performed using alternating current voltage of 60 Hz. An electrolytic solution at a liquid temperature of 35°C was used which was prepared by adding aluminum chloride to 6.2 g/L aqueous hydrochloric acid solution such that the aluminum ion concentration was adjusted to 4.5 g/L. By using an alternating current power source having the waveform shown in FIG. 1, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in FIG. 2 was used. The peak current density was 25 A/dm², and the electricity quantity (C/dm²) during the hydrochloric acid electrolysis was 63 C/dm² which is the total quantity of electricity used during the anodic reaction of the aluminum plate.

### (J-h) Alkaline etching treatment

An aqueous solution of caustic soda having a caustic soda concentration of 5% by mass and an aluminum ion concentration of 0.5% by mass was sprayed onto the aluminum plate at a temperature of 60°C, thereby performing an etching treatment. The amount of dissolved aluminum was 0.2 g/m².

### (J-i) Desmutting treatment using acidic aqueous solution

As an acidic aqueous solution, an aqueous solution at a liquid temperature of 35°C (sulfuric acid concentration 170 g/L and aluminum ion concentration 5 g/L) which was a waste liquid generated in the anodization treatment step was sprayed on an aluminum plate for 4 seconds, thereby performing a desmutting treatment.

### (J-j) First-stage anodization treatment

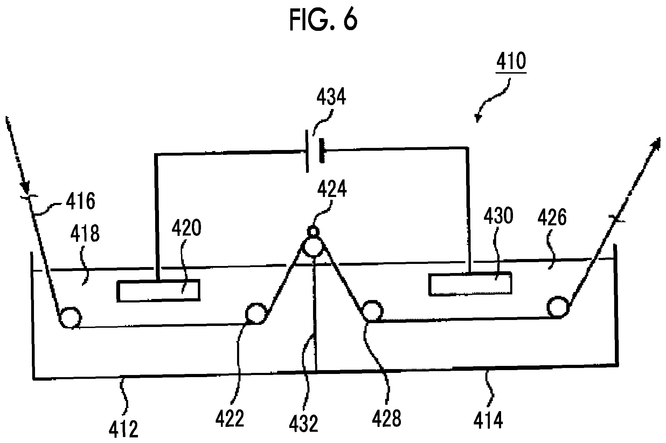

By using the anodization treatment device for direct current electrolysis having the structure shown in FIG. 6, a first-stage anodization treatment was performed. By using a 170 g/L aqueous sulfuric acid solution as an electrolytic solution, an anodization treatment was performed under the conditions of a liquid temperature of 50°C and a current density of 30 A/dm², thereby forming an anodic oxide film having a film amount of 0.3 g/m².

### (J-k) Pore widening treatment

The aluminum plate having undergone the anodization treatment was immersed in an aqueous solution of caustic soda having a caustic soda concentration of 5% by mass and an aluminum ion concentration of 0.5% by mass for 3 seconds at 40°C, thereby performing a pore widening treatment.

### (J-1) Second-stage anodization treatment

By using the anodization treatment device for direct current electrolysis having the structure shown in FIG. 6, a second-stage anodization treatment was performed. By using a 170 g/L aqueous sulfuric acid solution as an electrolytic solution, an anodization treatment was performed under the conditions of a liquid temperature of 50°C and a current density of 13 A/dm², thereby forming an anodic oxide film having a film amount of 2.1 g/m².

### (J-m) Hydrophilic treatment

In order to ensure the hydrophilicity of the non-image area, the aluminum plate was immersed in a 2.5% by mass No. 3 aqueous sodium silicate solution at 50°C for 7 seconds, thereby performing a silicate treatment. The amount of Si adhered was 8.5 mg/m². The average diameter of the micropores was 30 nm.

The value of the brightness L* of the surface of the anodic oxide film of the support 1 was 72.3 in the L*a*b* color system.

### <Preparation of support 2>

The following treatments (F-a) to (F-g) were performed on an aluminum plate (aluminum alloy plate) made of a material 1S having a thickness of 0.3 mm, thereby preparing a support 2. A rinsing treatment was performed between all the treatment steps. After the rinsing treatment, water was drained using a nip roller.

### (F-a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 5 g/m².

### (F-b) Desmutting treatment using acidic aqueous solution

As an acidic aqueous solution, an aqueous solution at a liquid temperature of 30°C having a sulfuric acid concentration of 150 g/L was sprayed on an aluminum plate for 3 seconds, thereby performing a desmutting treatment.

### (F-c) Electrochemical roughening treatment

An electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/dm² in terms of the peak current value of the alternating current waveform. In addition, the quantity of electricity was 450 C/dm² which was the total quantity of electricity used for the aluminum plate to have an anodic reaction, and the electrolytic treatment was performed 4 times by conducting electricity of 112.5 C/dm² for 4 seconds at each treatment session. A carbon electrode was used as the counter electrode of the aluminum plate.

### (F-d) Alkaline etching treatment

An aqueous solution of caustic soda having a caustic soda concentration of 5% by mass and an aluminum ion concentration of 0.5% by mass was sprayed onto the aluminum plate at a temperature of 45°C, thereby performing an etching treatment. The amount of dissolved aluminum within the surface having undergone the electrochemical roughening treatment was 0.2 g/m².

### (F-e) Desmutting treatment using acidic aqueous solution

As an acidic aqueous solution, an aqueous solution at a liquid temperature of 35°C having a sulfuric acid concentration of 170 g/L and an aluminum ion concentration of 5 g/L was sprayed on an aluminum plate for 3 seconds, thereby performing a desmutting treatment.

### (F-f) First-stage anodization treatment

By using the anodization treatment device for direct current electrolysis having the structure shown in FIG. 6, a first-stage anodization treatment was performed. By using a 150 g/L aqueous phosphoric acid solution as an electrolytic solution, an anodization treatment was performed under the conditions of a liquid temperature of 35°C and a current density of 4.5 A/dm², thereby forming an anodic oxide film having a film amount of 1 g/m².

In an anodization treatment device 410 shown in FIG. 6, an aluminum plate 416 is transported as indicated by the arrow in FIG. 6. In a power supply tank 412 containing an electrolytic solution 418, the aluminum plate 416 is positively (+) charged by a power supply electrode 420. Then, the aluminum plate 416 is transported upwards by a roller 422 in the power supply tank 412, makes a turn downwards by a nip roller 424, then transported toward an electrolytic treatment cell 414 containing an electrolytic solution 426, and makes a turn by a roller 428 to move in the horizontal direction. Subsequently, the aluminum plate 416 is negatively (-) charged by an electrolysis electrode 430. As a result, an anodic oxide film is formed on the surface of the aluminum plate 416. The aluminum plate 416 exits from the electrolytic treatment cell 414 and is then transported for the next step. In the anodization treatment device 410, the roller 422, the nip roller 424, and the roller 428 constitute a direction change unit. Furthermore, in the inter-tank portion between the power supply tank 412 and the electrolytic treatment cell 414, the aluminum plate 416 is transported in a ridge shape and an inverted U shape by the rollers 422, 424, and 428. The power supply electrode 420 and the electrolysis electrode 430 are connected to a direct current power source 434.

### (F-g) Second-stage anodization treatment

By using the anodization treatment device for direct current electrolysis having the structure shown in FIG. 6, a second-stage anodization treatment was performed. By using a 170 g/L aqueous sulfuric acid solution as an electrolytic solution, an anodization treatment was performed under the conditions of a liquid temperature of 50°C and a current density of 13 A/dm², thereby forming an anodic oxide film having a film amount of 2.1 g/m². Then, rinsing was performed by means of spraying. The average diameter of the micropores in the support 2 was 40 nm.

The value of the brightness L* of the surface of the anodic oxide film of the support 2 was 83.7 in the L*a*b* color system.

### <Preparation of support 3>

The following treatments (F-a) to (F-f) were performed on an aluminum plate (aluminum alloy plate) made of a material 1S having a thickness of 0.3 mm, thereby preparing a support 3. A rinsing treatment was performed between all the treatment steps. After the rinsing treatment, water was drained using a nip roller.

### (F-a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 5 g/m².

### (F-b) Desmutting treatment using acidic aqueous solution

As an acidic aqueous solution, an aqueous solution at a liquid temperature of 30°C having a sulfuric acid concentration of 150 g/L was sprayed on an aluminum plate for 3 seconds, thereby performing a desmutting treatment.

### (F-c) Electrochemical roughening treatment

An electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/dm² in terms of the peak current value of the alternating current waveform. In addition, the quantity of electricity was 450 C/dm² which was the total quantity of electricity used for the aluminum plate to have an anodic reaction, and the electrolytic treatment was performed 4 times by conducting electricity of 112.5 C/dm² for 4 seconds at each treatment session. A carbon electrode was used as the counter electrode of the aluminum plate.

### (F-d) Alkaline etching treatment

An aqueous solution of caustic soda having a caustic soda concentration of 5% by mass and an aluminum ion concentration of 0.5% by mass was sprayed onto the aluminum plate at a temperature of 45°C, thereby performing an etching treatment. The amount of dissolved aluminum within the surface having undergone the electrochemical roughening treatment was 0.2 g/m².

### (F-e) Desmutting treatment using acidic aqueous solution

As an acidic aqueous solution, an aqueous solution at a liquid temperature of 35°C having a sulfuric acid concentration of 170 g/L and an aluminum ion concentration of 5 g/L was sprayed on an aluminum plate for 3 seconds, thereby performing a desmutting treatment.

### (F-f) First-stage anodization treatment

By using the anodization treatment device for direct current electrolysis having the structure shown in FIG. 6, a first-stage anodization treatment was performed. By using a 150 g/L aqueous phosphoric acid solution as an electrolytic solution, an anodization treatment was performed under the conditions of a liquid temperature of 35°C and a current density of 4.5 A/dm², thereby forming an anodic oxide film having a film amount of 1 g/m².

The average diameter of the micropores in the support 3 was 40 nm.

The value of the brightness L* of the surface of the anodic oxide film of the support 3 was 82.4 in the L*a*b* color system.

### <Preparation of support 4>

A support 4 was prepared according to the manufacturing method of the support of Example 5 of WO2021/67054A.

### <Formation of undercoat layer 1>

The support was coated with an undercoat layer coating liquid (1) having the following composition such that the dry coating amount was 26 mg/m². In this way, an undercoat layer 1 was formed.

### (Undercoat layer coating liquid (1))

| | |
|---|---|
| · Compound for undercoat layer (2) (the following structure) | 0.013 parts |
| · Hydroxyethyl iminodiacetic acid | 0.005 parts |
| · Tetrasodium ethylenediaminetetraacetate | 0.005 parts |
| · Polyoxyethylene lauryl ether | 0.0003 parts |
| · Water | 3.15 parts |

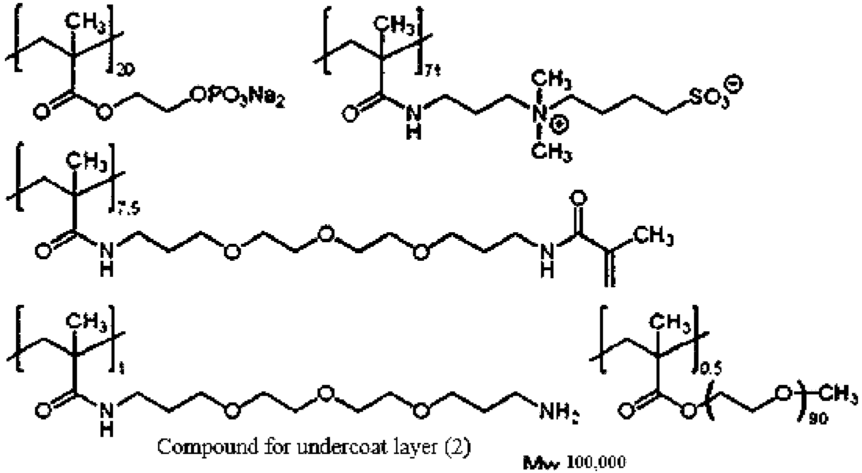

The numerical value at the right lower side of the parentheses of each constitutional unit in the compound (2) for an undercoat layer represents a mass ratio, and the numerical value at the right lower side of the parentheses of the ethyleneoxy unit represents the number of repeating units.

### <Formation of undercoat layer 2>

The support was coated with an undercoat layer coating liquid (2) having the following composition such that the dry coating amount was 0.03 g/m². In this way, an undercoat layer 2 was formed.

### (Undercoat layer coating liquid (2))

| | |
|---|---|
| · Aqueous polyacrylic acid solution (40% by mass) Jurymer AC-10S (manufactured by Toagosei Co., Ltd.) | 3.0 parts |
| · Water | 27.0 parts |

### <Formation of image-recording layers 1 to 58, 61 to 62, and 63 to 69>

Each of the following image-recording layer coating liquids (image-recording layer coating liquids (1) to (58), (61) to (62), and (63) to (69)) was bar-coated, and then dried in an oven at 110°C for 40 seconds to form image-recording layers 1 to 58, 61 to 62, and 63 to 69 having a dry weight of 1.0 g/m², respectively. The compounds described in Table 1 were selected such that the dry weight was the described content.

### (Image-recording layer coating liquid)

| | |
|---|---|
| · 2-Butanone | 5.3155 parts |
| · 1-Methoxy-2-propanol | 2.8825 parts |
| · Methanol | 2.3391 parts |
| · color-forming compound (described in Table 1) | Amount described in Table 1 |
| · hydrogen-donating compound (described in Table 1): | amount described in Table 1 |
| · Polymerizable compound (described in Table 1): | amount described in Table 1 |
| · Electron-accepting polymerization initiator (described in Table 1): | amount described in Table 1 |
| · Electron-donating polymerization initiator (described in Table 1): | amount described in Table 1 |
| · Infrared absorber (described in Table 1): | amount described in Table 1 |
| · Acid color-forming agent (described in Table 1): | amount described in Table 1 |
| · Tricresyl phosphate | 0.0125 parts |
| · Anionic surfactant (A-1): | 0.0162 parts |
| · Microgel liquid | 2.8779 parts |
| · Fluorine-based surfactant (W-1): | 0.0042 parts |

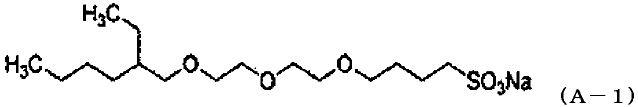

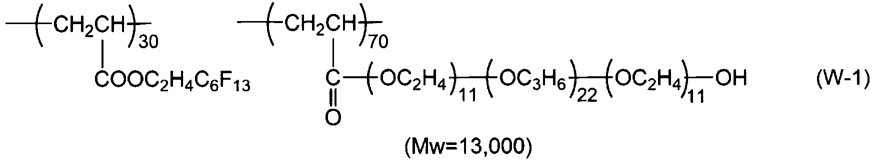

Microgel used in the aforementioned microgel liquid was prepared by the following method.

### -Preparation of polyvalent isocyanate compound-

0.043 parts of bismuth tris(2-ethylhexanoate) (NEOSTANN U-600, manufactured by NITTO KASEI CO., LTD.) was added to an ethyl acetate (25.31 parts) suspension solution of 17.78 parts (80 molar equivalent) of isophorone diisocyanate and 7.35 parts (20 molar equivalent) of a polyhydric phenol compound (1) represented by the following structural formula, and the mixture was stirred. The reaction temperature was set to 50°C at a point in time when heat release subsided, and the solution was stirred for 3 hours, thereby obtaining an ethyl acetate solution of the polyvalent isocyanate compound (1) (50% by mass).

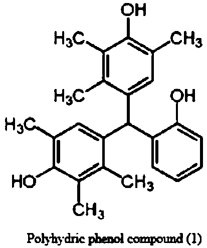

### -Preparation of microgel-

The following oil phase components and the water phase component were mixed with each other and emulsified at 12,000 rpm for 10 minutes using a homogenizer. The obtained emulsion was stirred at 45°C for 4 hours, 5.20 g of a 10% aqueous solution of 1,8-diazabicyclo[5.4.0]undeca-7-ene-octylate (U-CAT SA102, manufactured by San-Apro Ltd.) was added thereto, and the mixture was stirred at room temperature for 30 minutes and allowed to stand at 45°C for 24 hours. Distilled water was added thereto such that the concentration of solid contents was adjusted to 20% by mass, thereby obtaining an aqueous dispersion of microgel. The average particle diameter thereof measured by a light scattering method was 0.28 µm.

### ~Oil-phase component~

(Component 1) Ethyl acetate: 12.0 parts
(Component 2) Adduct (50% by mass of ethyl acetate solution, manufactured by Mitsui Chemicals, Inc.) obtained by adding trimethylolpropane (6 mol equivalent) and xylene diisocyanate (18 mol equivalent) and adding one-terminal methylated polyoxyethylene (1 mol equivalent, repetition number of oxyethylene units: 90) thereto: 3.76 parts
(Component 3) Polyvalent isocyanate compound (1) (as 50% by mass of ethyl acetate solution): 15.0 parts
(Component 4) 65% by mass of solution of dipentaerythritol pentaacrylate (SR-399, manufactured by Sartomer Japan Inc.) in ethyl acetate: 11.54 parts
(Component 5) 10% solution of sulfonate type surfactant (PIONINE A-41-C, manufactured by TAKEMOTO OIL & FAT Co., Ltd.) in ethyl acetate: 4.42 parts

### ~Water-phase component~

Distilled water: 46.87 parts

### <Formation of image-recording layers 59 and 60>

The undercoat layer was bar-coated with the image-recording layer coating liquids having the following composition (image-recording layer coating liquid (59) and (60), and dried in an oven at 110°C for 40 seconds, thereby forming a respective image-recording layer 59 and 60 having a dry weight of 0.9 g/m². The compounds described in Table 1 were selected such that the dry weight was the described content.

### (Image-recording layer coating liquid)

| | |
|---|---|
| · 1-Propanol: | 4.94 parts |
| · 2-Butanone: | 2.40 parts |
| · γ-Butyrolactone | 0.14 parts |
| · 1-Methoxy-2-propanol: | 4.22 parts |
| · Water: | 0.66 parts |
| · Polymer dispersion liquid¹ | 1.056 parts |
| · Hydroxypropyl methyl cellulose^{*2}: | 0.600 parts |
| · BYK 302^{*3} | 0.18 parts |
| · color-forming compound (described in Table 1) | Amount described in Table 1 |
| · hydrogen-donating compound (described in Table 1): | amount described in Table 1 |
| · Polymerizable compound (described in Table 1): | described in Examples table |
| · Electron-accepting polymerization initiator (described in Table 1): | amount described |
| | in Table 1 |
| · Electron-donating polymerization initiator (described in Table 1): | amount described in Table 1 |
| · Infrared absorber (described in Table 1): | amount described in Table 1 |
| · Acid color-forming agent (described in Table 1): | amount described in Table 1 |

| | |
|---|---|
| *1: The polymer dispersion liquid was prepared according to the description in EP1765593A, and used as a 23.5% by mass dispersion liquid of n-propanol/water (80:20 [mass ratio]). *2: 5.0% by mass aqueous solution *3: 25% by mass concentration 1-methoxy-2-propanol solution (manufactured by BYK Chemie) | |

### [Color-forming compound]

The color-forming compound described in Table 1 is as described above.

### [Hydrogen-donating compound]

The hydrogen-donating compound described in Table 1 is as described above.

### [Polymerizable compound]

The polymerizable compounds shown in Table 1 are described below.
M-1:
   A mixed solution of TAKENATE D-160N (polyisocyanate trimethylolpropane adduct, manufactured by Mitsui Chemicals, Inc., 4.7 parts), ARONIX M-403 (manufactured by TOAGOSEI Co., Ltd., amount yielding the ratio of NCO value of TAKENATE D-160N:hydroxyl number of ARONIX M-403 = 1:1), t-butylbenzoquinone (0.02 parts), and methyl ethyl ketone (11.5 parts) was heated at 65°C. NEOSTAN U-600 (bismuth-based polycondensation catalyst, manufactured by NITTO KASEI CO., LTD., 0.11 parts) was added to the reaction solution, and the reaction solution was heated at 65°C for 4 hours. The reaction solution was cooled to room temperature (25°C), and methyl ethyl ketone was added thereto, thereby synthesizing a urethane acrylate (M-2) solution having a solid content of 50% by mass. By using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed. The weight-average molecular weight was 14,000.
M-2:
   A polymerizable compound having a concentration of 80% by mass in a 2-butanone solution, which is obtained by reacting DESMODUR (registered trademark) N100, hydroxyethyl acrylate, and pentatritol acrylate at a molar ratio of 1:1.5:1.5
M-3:
   Dipentaerythritol hexaacrylate (DPHA)
M-4:
   Ethoxylated (4) pentaerythritol tetraacrylate "Sartmer SR494"

### [Electron-donating polymerization initiator]

The electron-donating polymerization initiator described in Table 1 is described below.

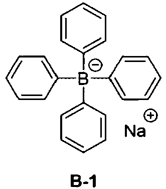

### [Electron-accepting polymerization initiator]

The electron-accepting polymerization initiator described in Table 1 is described below.

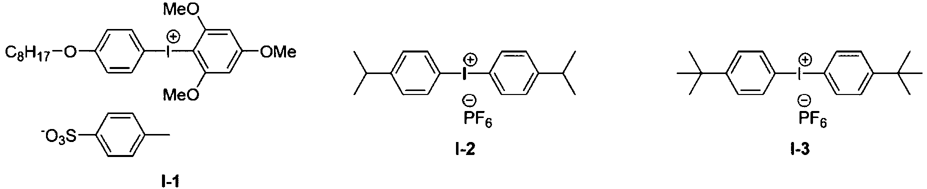

### [Infrared absorber]

The infrared absorbers described in Table 1 are shown below. It is a compound different from the color-forming compound.

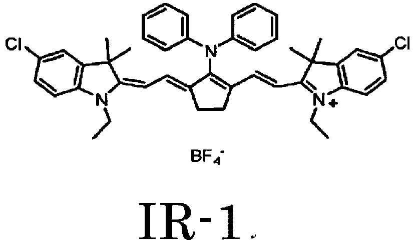

### [Acid color-forming agent]

The acid color-forming agent described in Table 1 is described below. It is a compound different from the color-forming compound.

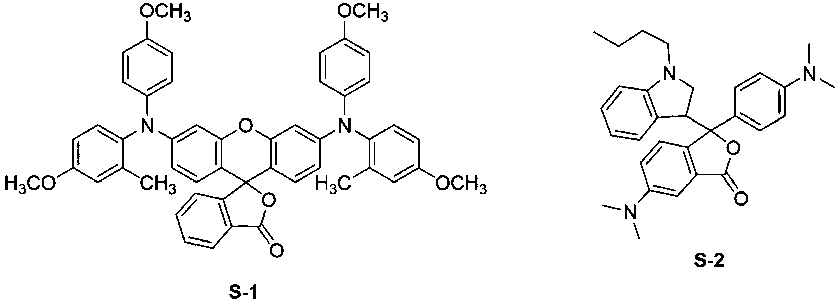

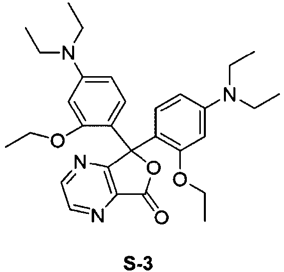

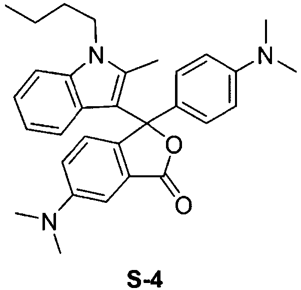

### <Formation of protective layers 1 to 5>

The image-recording layer was bar-coated with a protective layer coating liquid having the following composition (protective layer coating liquid (1) to (5)), and then dried in an oven at 120°C for 60 seconds, thereby forming a protective layer having a dry coating amount of 0.1 g/m².

(Protective layer coating liquid)
· Inorganic lamellar compound dispersion liquid (1) (below): amount described in Table 1
· Hydrophilic polymer (1) (the following structure, Mw: 30,000): 0.03 parts
· METOLOSE SM04 (manufactured by Shin-Etsu Chemical Co., Ltd.):
   0.0600 parts
· RAPISOL A-80 (80% aqueous solution) (manufactured by NOF CORPORATION): 0.0063 parts
· Water: 2.0 parts

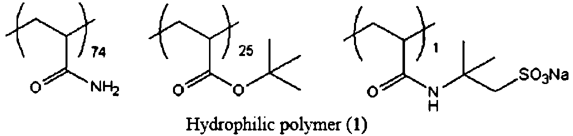

### (Preparation of inorganic lamellar compound dispersion (1))

Synthetic mica SOMASIF ME-100 manufactured by Co-op Chemical Co., Ltd., 6.4 parts) was added to 193.6 parts of deionized water and was dispersed using a homogenizer until the volume average particle diameter (the laser scattering method) reached 3 µm. The aspect ratio of the obtained dispersed particles was 100 or more.

In the protective layer of Table 1, the "Lamellar compound" represents "synthetic mica SOMASIF ME-100 (manufactured by Co-op Chemical Co., Ltd.)" which is a component of the inorganic layered compound dispersion liquid (1).
In addition, the content of the "inorganic lamellar compound dispersion liquid (1)" was selected such that the "Addition amount" in Table 1 was the content described in the dry weight.

### [Preparation of lithographic printing plate precursor]

The support, the undercoat layer, the image-recording layer, and the protective layer were combined as shown in Table 1, thereby preparing lithographic printing plate precursors of Examples 1 to 74 and Comparative Examples 1 and 2.

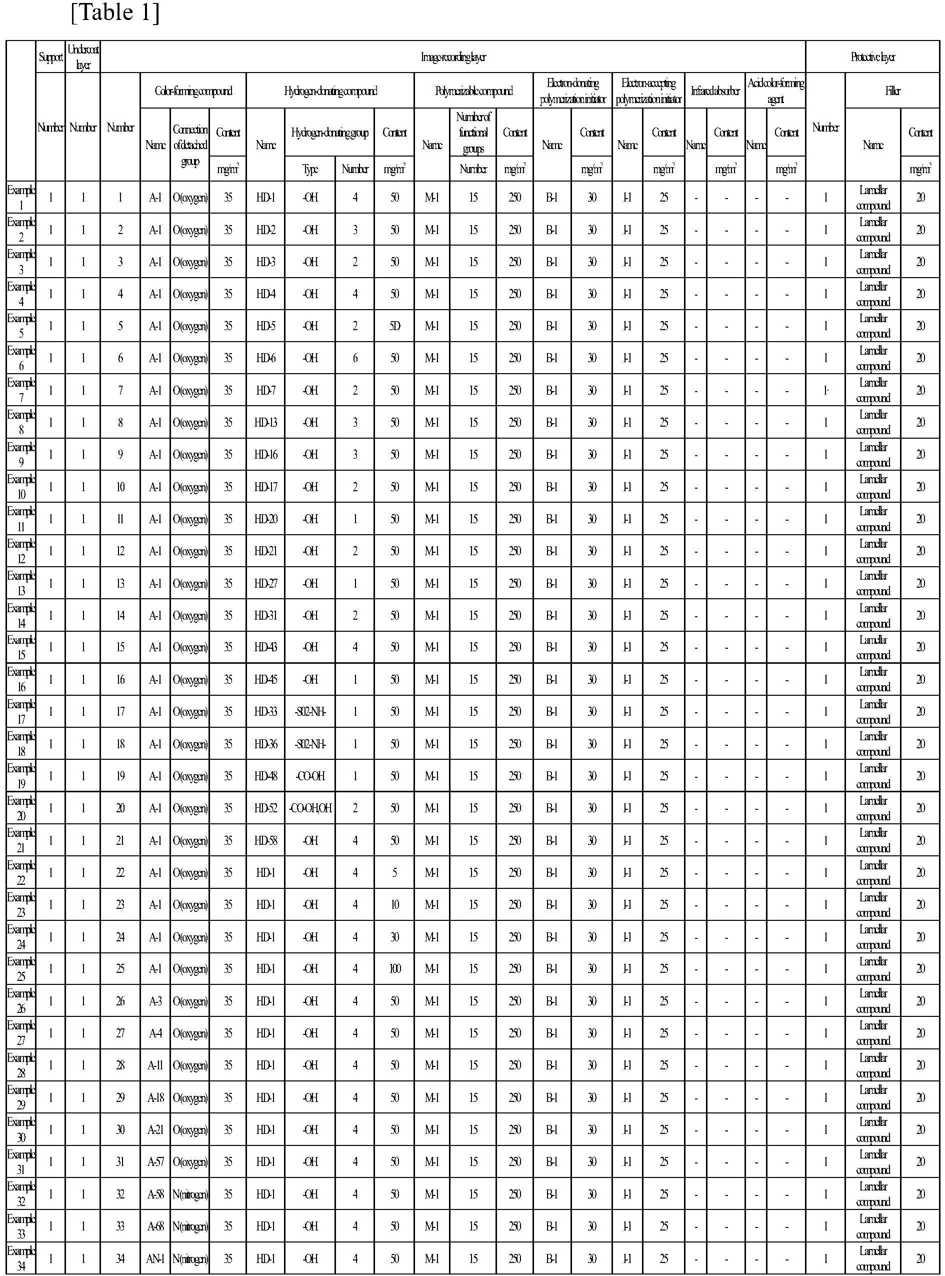

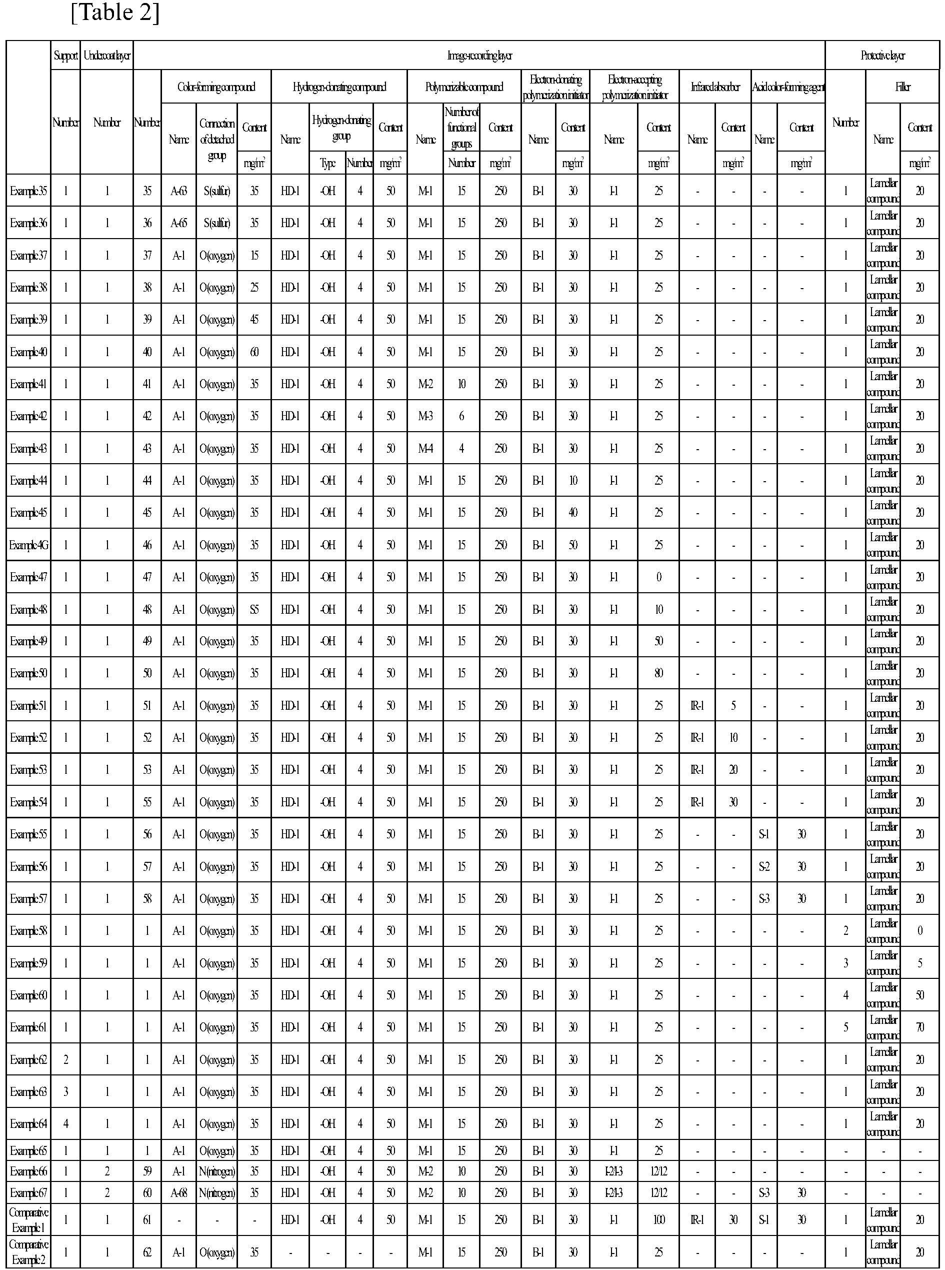

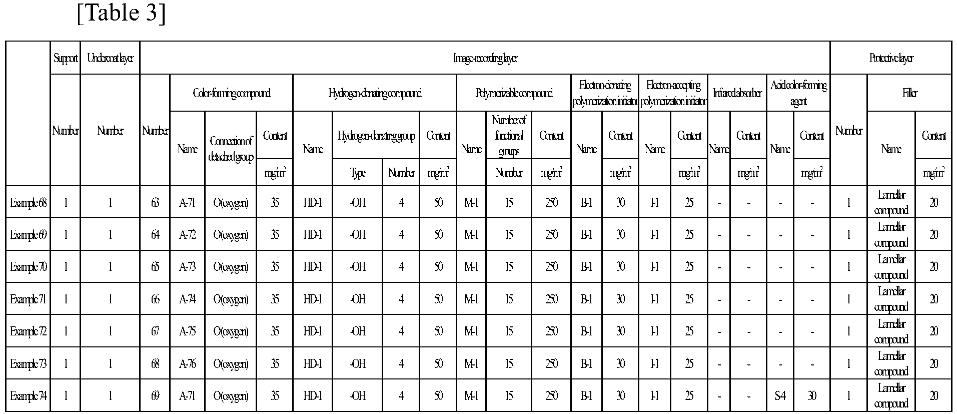

**[Table 4]**

| | Evaluation | | | | | |
|---|---|---|---|---|---|---|
| | Visibility | | | Printing durability | Dampening water contamination | Sensor reading suitability |
| | Immediately after exposure | After 72 hours in dark room | After exposure to white light | | | |
| Example 1 | 12.4 | 12.2 | 7.8 | 5 | 5 | A |
| Example 2 | 12.0 | 11.8 | 7.2 | 5 | 5 | A |
| Example 3 | 11.8 | 12.1 | 7.4 | 5 | 5 | |
| Example 4 | 11.9 | 12.0 | 7.4 | 5 | 5 | |
| Example 5 | 12.1 | 11.9 | 6.8 | 5 | 5 | |
| Example 6 | 12.6 | 12.4 | 8.0 | 5 | 5 | |
| Example 7 | 11.4 | 10.8 | 6.4 | 5 | 5 | |
| Example 8 | 12.4 | 12.5 | 7.1 | 5 | 5 | A |
| Example 9 | 12.8 | 12.6 | 7.4 | 5 | 5 | |
| Example 10 | 11.7 | 11.5 | 6.4 | 5 | 5 | B |
| Example 11 | 11.0 | 10.8 | 5.8 | 5 | 5 | B |
| Example 12 | 12.4 | 12.2 | 6.4 | 5 | 5 | |
| Example 13 | 11.0 | 10.8 | 5.2 | 5 | 5 | |
| Example 14 | 8.5 | 7.8 | 4.4 | 5 | 5 | |
| Example 15 | 11.0 | 9.2 | 4.2 | 5 | 5 | |
| Example 16 | 11.1 | 9.8 | 4.4 | 5 | 5 | |
| Example 17 | 12.1 | 12.4 | 6.2 | 5 | 5 | |
| Example 18 | 11.9 | 12.1 | 5.8 | 5 | 5 | |
| Example 19 | 11.5 | 11.0 | 5.0 | 5 | 5 | |
| Example 20 | 12.0 | 11.4 | 5.4 | 5 | 5 | |
| Example 21 | 10.9 | 9.4 | 4.6 | 5 | 5 | |
| Example 22 | 12.4 | 12.2 | 4.8 | 5 | 5 | |
| Example 23 | 12.4 | 12.2 | 5.7 | 5 | 5 | |
| Example 24 | 12.4 | 12.2 | 6.5 | 5 | 5 | |
| Example 25 | 12.4 | 12.2 | 8.6 | 3 | 5 | |
| Example 26 | 12.4 | 11.8 | 7.8 | 5 | 5 | |
| Example 27 | 11.2 | 11.7 | 7.2 | 5 | 5 | |
| Example 28 | 11.8 | 11.4 | 7.8 | 5 | 5 | |
| Example 29 | 7.5 | 7.2 | 4.5 | 4 | 5 | |
| Example 30 | 6.5 | 6.5 | 4.5 | 4 | 5 | |
| Example 31 | 8.0 | 7.1 | 5.2 | 4 | 5 | |
| Example 32 | 7.5 | 7.4 | 6.8 | 4 | 5 | |
| Example 33 | 5.8 | 5.2 | 4.4 | 4 | 5 | |
| Example 34 | 6.5 | 6.5 | 4.5 | 4 | 5 | |

**[Table 5]**

| | Evaluation | | | | | |
|---|---|---|---|---|---|---|
| | Visibility | | | Printing durability | Dampening water contamination | Sensor reading suitability |
| | Immediately after exposure | After 72 hours in dark room | After exposure to white light | | | |
| Example 35 | 6.5 | 6.5 | 4.5 | 4 | 5 | |
| Example 36 | 6.5 | 6.5 | 4.5 | 4 | 5 | |
| Example 37 | 8.4 | 7.9 | 5.1 | 5 | 5 | |
| Example 38 | 10.0 | 9.5 | 7.2 | 5 | 5 | B |
| Example 39 | 14.3 | 14.3 | 13.5 | 5 | 4 | A |
| Example 40 | 15.2 | 15.4 | 14.4 | 3 | 3 | A |
| Example 41 | 12.4 | 12.2 | 7.8 | 4 | 5 | |
| Example 42 | 12.4 | 12.2 | 7.8 | 4 | 4 | |
| Example 43 | 12.4 | 12.2 | 7.8 | 3 | 3 | |
| Example 44 | 8.4 | 8.5 | 5.4 | 4 | 5 | |
| Example 45 | 13.2 | 12.9 | 9.4 | 5 | 5 | A |
| Example 46 | 13.5 | 13.6 | 11.4 | 4 | 4 | |
| Example 47 | 14.1 | 14.3 | 12.4 | 3 | 5 | |
| Example 48 | 13.4 | 13.2 | 10.9 | 4 | 5 | |
| Example 49 | 10.8 | 9.2 | 6.1 | 5 | 5 | |
| Example 50 | 8.4 | 6.1 | 4.0 | 5 | 4 | |
| Example 51 | 11.5 | 10.8 | 7.1 | 5 | 5 | |
| Example 52 | 10.5 | 9.4 | 6.5 | 5 | 5 | |
| Example 53 | 9.7 | 9.4 | 6.8 | 5 | 5 | |
| Example 54 | 6.5 | 6.2 | 4.5 | 5 | 5 | |
| Example 55 | 14.5 | 12.1 | 11.1 | 5 | 5 | A |
| Example 56 | 14.9 | 13.4 | 12.5 | 5 | 4 | A |
| Example 57 | 13.4 | 11.2 | 10.3 | 5 | 5 | A |
| Example 58 | 12.4 | 9.5 | 6.6 | 3 | 5 | |
| Example 59 | 12.6 | 11.8 | 7.2 | 5 | 5 | |
| Example 60 | 12.4 | 12.1 | 9.5 | 5 | 4 | |
| Example 61 | 12.8 | 12.4 | 11.5 | 5 | 3 | |
| Example 62 | 13.6 | 13.0 | 8.5 | 5 | 5 | |
| Example 63 | 13.4 | 13.4 | 8.1 | 5 | 5 | |
| Example 64 | 13.6 | 13.5 | 8.5 | 5 | 5 | |
| Example 65 | 10.5 | 9.4 | 8.4 | 3 | 5 | A |
| Example 66 | 11.0 | 10.1 | 7.4 | 4 | 5 | A |
| Example 67 | 7.5 | 7.1 | 6.2 | 4 | 5 | A |
| Comparative Example 1 | 6.5 | 3.2 | 5.4 | 5 | 5 | |
| Comparative Example 2 | 11.2 | 8.5 | 2.4 | 4 | 5 | |

**[Table 6]**

| | Evaluation | | | | | |
|---|---|---|---|---|---|---|
| | Visibility | | | Printing durability | Dampening water contamination | Sensor reading suitability |
| | Immediately after exposure | After 72 hours in dark room | After exposure to white light | | | |
| Example 68 | 12.1 | 12.3 | 6.5 | 5 | 5 | A |
| Example 69 | 12.6 | 12.2 | 6.3 | 5 | 5 | A |
| Example 70 | 11.2 | 11.5 | 5.7 | 5 | 5 | A |
| Example 71 | 12.0 | 11.8 | 6.8 | 5 | 5 | A |
| Example 72 | 11.8 | 12.0 | 6.8 | 5 | 5 | A |
| Example 73 | 11.3 | 11.0 | 6.0 | 5 | 5 | A |
| Example 74 | 14.5 | 13.1 | 12.8 | 5 | 5 | A |

The obtained lithographic printing plate precursor was evaluated as follows.

### Visibility evaluation: immediately after exposure

The obtained lithographic printing plate precursor is exposed by Luxel PLATESETTER T-6000III (manufactured by Fujifilm Corporation) equipped with an infrared semiconductor laser with a wavelength of 830 nm such that the exposure amount is 110 mJ/cm². The exposed image includes a solid image and a non-image area. The exposure was carried out in an environment of 25°C and 50% RH.

Immediately after exposure, the color formation of the lithographic printing plate precursor was measured. The measurement was performed by the specular component excluded (SCE) method by using a spectrocolorimeter CM2600d and operation software CM-S100W manufactured by Konica Minolta, Inc. The color formability is evaluated based on a difference ΔL between the L* value of the exposed portion and the L* value of the unexposed portion using the L* value (brightness) of the L*a*b* color system. It can be said that the larger the value of ΔL', the better the color formability.

### <Evaluation of visibility: after storage in dark room>

The obtained lithographic printing plate precursor is exposed by Luxel PLATESETTER T-6000III (manufactured by Fujifilm Corporation) equipped with an infrared semiconductor laser with a wavelength of 830 nm such that the exposure amount is 110 mJ/cm². The exposed image includes a solid image and a non-image area. The exposure was carried out in an environment of 25°C and 50% RH.

The lithographic printing plate precursor immediately after exposure was stored for 72 hours in an environment of 25°C, 50% RH, and a dark room, and then the coloration was measured. In a case of storage, the lithographic printing plate precursor was stored by being stacked with another lithographic printing plate precursor such that the exposure surface of the lithographic printing plate precursor did not come into contact with air. The measurement was performed by the specular component excluded (SCE) method by using a spectrocolorimeter CM2600d and operation software CM-S100W manufactured by Konica Minolta, Inc. The color formability is evaluated based on a difference ΔL between the L* value of the exposed portion and the L* value of the unexposed portion using the L* value (brightness) of the L*a*b* color system. It can be said that the larger the value of ΔL', the better the color formability.

In a case where ΔL was 3.5 or more, it was within an allowable range.

### <Evaluation of visibility: after exposure to white light>

The obtained lithographic printing plate precursor is exposed by Luxel PLATESETTER T-6000III (manufactured by Fujifilm Corporation) equipped with an infrared semiconductor laser with a wavelength of 830 nm such that the exposure amount is 110 mJ/cm². The exposed image includes a solid image and a non-image area. The exposure was carried out in an environment of 25°C and 50% RH.

The lithographic printing plate precursor immediately after exposure was humidified for 1 hour in an environment of 25°C, 30% RH, and a dark room, and then exposed to a white fluorescent lamp for 1 hour such that the illuminance on the plate surface was 800 Lux. In a case of exposure to a white light, the environment of 25°C and 30% RH was maintained. The coloration of the lithographic printing plate precursor after exposure to a white light was measured. The measurement was performed by the specular component excluded (SCE) method by using a spectrocolorimeter CM2600d and operation software CM-S100W manufactured by Konica Minolta, Inc. The color formability is evaluated based on a difference ΔL between the L* value of the exposed portion and the L* value of the unexposed portion using the L* value (brightness) of the L*a*b* color system. It can be said that the larger the value of ΔL', the better the color formability.

In a case where ΔL was 3.5 or more, it was within an allowable range.

The obtained results are shown in Table 1.

The obtained lithographic printing plate precursor was further evaluated for "printing durability" and "dampening water contamination" as follows.

In addition, the lithographic printing plate precursors obtained in Examples 1, 2, 8, 10, 11, 38 to 40, 45, 55 to 57, and 65 to 73 were further evaluated for "sensor reading suitability" as follows.

### <Printing durability evaluation>

By using Magnus 800 Quantum manufactured by Kodak Japan Ltd. that was equipped with an infrared semiconductor laser, the obtained lithographic printing plate precursor was exposed (equivalent to irradiation energy of 110 mJ/cm²) under the conditions of output of 27 W, an outer drum rotation speed of 450 rpm, and a resolution of 2,400 dots per inch (dpi, 1 inch is equal to 2.54 cm). The exposed image included a solid image and an amplitude modulation screen (AM screen) as a 10% halftone dot chart.

The obtained exposed precursor was mounted on a Kikuban-sized cylinder of a printing press SX-74 manufactured by Heidelberger Druckmaschinen AG without being developed. This printing press was connected to a 100 L-capacity dampening water circulation tank having a non-woven fabric filter and a temperature control device. A circulation device was filled with 80 L of dampening water containing 3.5% dampening water S-Z1 (manufactured by FUJIFILM Corporation), UV CORE TYPE-A J ink GE M (manufactured by T & K TOKA CO., LTD.) was used as printing ink, dampening water and ink were supplied by a standard automatic printing start method, and then 1,000 sheets were printed on SHIRAOI paper (ream weight: 48.5 kg, manufactured by NIPPON PAPER INDUSTRIES Co., Ltd.) at a printing speed of 10,000 sheets per hour.

Then, printing was performed further. As the number of printing sheets increased, the image area gradually wore out, and thus the ink density on the printed matter decreased. The print durability was evaluated by determining the number of printed sheets, which is designated as the number of finished printed sheets, in a case where the halftone dot area ratio of a 10% AM screen dot on a printed material, which is measured using an eXact spectrophotometer (manufactured by X-Rite), was decreased by 3% compared to the measurement value at the 1,000th print. UV printing durability was evaluated according to the following standard, based on relative printing durability to 100 which represents the printing durability of a lithographic printing plate precursor capable of printing 50,000 sheets. The higher the numerical value, the better the printing durability. 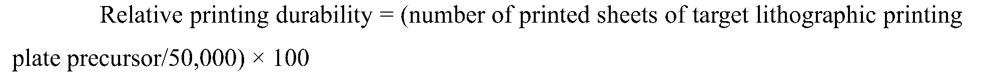 Relative printing durability = (number of printed sheets of target lithographic printing plate precursor/50,000) × 100

### -Evaluation criteria-

6: The value of relative printing durability is more than 110.
5: The value of relative printing durability is more than 100 and 110 or less.
4: The value of relative printing durability is more than 90 and 100 or less.
3: The value of relative printing durability is more than 80 and 90 or less.
2: The value of relative printing durability is more than 70 and 80 or less.
1: The value of relative printing durability is 70 or less.

### <Water contamination evaluation>

By using an adjustment plate (XP-F manufactured by FUJIFILM Corporation), water/ink balance was properly adjusted, and then 1,000 sheets were printed. The adjustment plate was then removed, and the blanket was washed. Subsequently, the ink pot key was set to zero. The dampening water used at the time of adjustment was discarded, and new dampening water was added. During this operation, the circulation system of dampening water was stopped, and the discharge port was closed with a rubber stopper.

Next, the following operations X1 to X3 were repeated 10 times.
X1: The prepared lithographic printing plate precursor (non-exposed plate) was dampened 50 times by manual pre-damping.
X2: After 50 times of dampening, printing was performed on 100 sheets of SHIRAOI (high-quality paper, manufactured by NIPPON PAPER INDUSTRIES CO., LTD.)
X3: The plate was removed.

The printing conditions are shown below.

Printing press: LITHRONE printing press LS26/104 manufactured by KOMORI Corporation.

Ink: UV ink (UV CORE TYPE-AJ yellow manufactured by T & K TOKA CO., LTD.) Dampening water: PRESSMAX S-Z1 2% (manufactured by FUJIFILM Corporation)

### Pre-damping: 50 times

Then, the rubber stopper was pulled out, dampening water was collected, and the turbidity of the dampening water was evaluated based on the transparency of the dampening water. The transparency was measured according to JIS K0102 (2019) and evaluated according to the following standard.

### -Evaluation criteria-

5: transmittance of 8 cm or more
4: transmittance of 6 cm or more and less than 8 cm
3: transmittance of 4 cm or more and less than 6 cm
2: transmittance of 2 cm or more and less than 4 cm
1: transmittance of 0 cm or more and less than 2 cm

### <Sensor reading suitability>

By using Trendsetter Q800 manufactured by Eastman Kodak Company that was equipped with an infrared semiconductor laser, the obtained lithographic printing plate precursor was exposed under the conditions of output of 14 W, an outer drum rotation speed of 360 rpm, and a resolution of 2,400 dpi (dot per inch, 1 inch is equal to 2.54 cm) (irradiation energy equivalent to 110 mJ/cm²). A data matrix code was included in the exposed image. Using an SR-1000W sensor manufactured by KEYENCE CORPORATION, the data matrix code (9 mm square size) was read, and the following evaluation was performed from the numerical value of the matching level (index representing the readability).

### -Evaluation criteria-

A: Matching level of 70% or more
B: Matching level of 50% or more and less than 70%
C: Matching level of 30% or more and less than 50%
D: Matching level of less than 30%

In other cases, the reading is impossible.

The obtained results are shown in Table 1.

From the results shown in Table 1, according to the on-press developability lithographic printing plate precursor according to the present invention, the visibility of the exposed portion is good immediately after exposure, the good visibility immediately after exposure is easily maintained, and the visibility of the exposed portion is also good after storage under a white light.

Comparative Example 1 is an aspect in which the image-recording layer of the lithographic printing plate precursor does not contain the color-forming compound and contains the infrared absorber. From Comparative Example 1, it can be seen that the visibility of the exposed portion is good immediately after exposure, and the visibility of the exposed portion is also good after storage under a white light, but the good visibility immediately after exposure cannot be maintained and deteriorates.

Comparative Example 2 is an aspect in which the image-recording layer of the lithographic printing plate precursor contains the color-forming compound but does not contain the hydrogen-donating compound. From Comparative Example 2, it can be seen that the visibility of the exposed portion is good immediately after exposure, and the good visibility immediately after exposure can be maintained, but the visibility of the exposed portion deteriorates even after storage under a white light.

In addition, it can be seen that, according to the on-press developability lithographic printing plate precursor according to the present invention, the printing durability is also good, the color formability is good, and the contamination by the dampening water can be suppressed.

In addition, it can be seen that, according to the on-press developability lithographic printing plate precursor according to the present invention, the sensor reading suitability is also good.

With the present invention, it is possible to provide an on-press development type lithographic printing plate precursor in which visibility of an exposed portion is good immediately after exposure, good visibility immediately after exposure is easily maintained, and visibility of the exposed portion is also good after storage under a white light, and a method of producing a printing plate using the on-press development type lithographic printing plate precursor.

The present invention has been described in detail with reference to specific embodiments. To those skilled in the art, it is obvious that various changes or modifications can be added without departing from the gist and scope of the present invention.
The present application is based on Japanese Patent Application (JP2023-141847) filed on August 31, 2023 and Japanese Patent Application (JP2024-030807) filed on February 29, 2024, the contents of which are incorporated in the present application by reference. Explanation of References

1: lithographic printing plate precursor
1a: image-recording layer surface
1b: support surface
1c: edge surface
2: bevel
10: cutting blade
10a: upper cutting blade
10b: upper cutting blade
11: rotary shaft
20: cutting blade
20a: lower cutting blade
20b: lower cutting blade
21: rotary shaft
30: lithographic printing plate precursor
31: aluminum plate
32, 34: roller-shaped brush
33: abrasive slurry
35, 36, 37, 38: support roller
50: main electrolytic cell
51: alternating current power source
52: radial drum roller
53a, 53b: main pole
54: electrolytic solution supply port
55: electrolytic solution
56: slit
57: electrolytic solution channel
58: auxiliary anode
60: auxiliary anode tank
410: anodization treatment device
412: power supply tank
414: electrolytic treatment cell
416: aluminum plate
418, 426: electrolytic solution
420: power supply electrode
422, 428: roller
424: nip roller
430: electrolysis electrode
432: cell wall
434: direct current power source
B: boundary between image-recording layer surface and support
W: aluminum plate
X: bevel amount
Y: bevel width

## Claims

1. An on-press development type lithographic printing plate precursor comprising:
an image-recording layer on a support,
wherein the image-recording layer contains a color-forming compound having a group that cleaves by infrared exposure, a polymerization initiator, a polymerizable compound, and a hydrogen-donating compound, and
the hydrogen-donating compound is a compound different from the polymerization initiator, the polymerizable compound, the color-forming compound, and an acid-cleavable compound and is a compound having at least one group selected from the group consisting of -OH, -NH-, -SO₂-NH-, -SO₂-OH, -CO-NH-, and -CO-OH in a molecule and having a molecular weight of less than 3,000.

2. The on-press development type lithographic printing plate precursor according to claim 1,
wherein the hydrogen-donating compound is a compound having at least one partial structure represented by the following Formula (I) in a molecule, 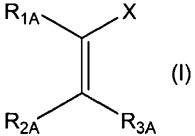 in Formula (I),
X is a hydrogen-donating group selected from the group consisting of -OH, -NH-, -SO₂-NH-, -SO₂-OH, -CO-NH-, and -CO-OH,
R_{1A} to R_{3A} each independently are a group having at least one selected from the group consisting of a hydrogen atom, a carbon atom, a halogen atom, and a heteroatom,
at least two of R_{1A} to R_{3A} may be linked to each other to form a ring,
in a case where X is a monovalent group, one or more hydrogen atoms included in R_{1A} to R_{3A} are removed to form a bonding site, and
in a case where X is a divalent group, one or more hydrogen atoms included in R_{1A} to R_{3A} may be further removed to form a bonding site.

3. The on-press development type lithographic printing plate precursor according to claim 1,
wherein the hydrogen-donating compound is a compound having at least one partial structure represented by Formula (II) in a molecule, 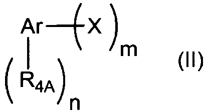 in Formula (II),
Ar represents an aromatic ring group,
X is a group selected from the group consisting of -OH, -NH-, -SO₂-NH-, -SO₂-OH, -CO-NH-, and -CO-OH,
R_{4A} is a group having at least one selected from the group consisting of a hydrogen atom, a carbon atom, a halogen atom, and a heteroatom,
m represents an integer of 1 to 5, in a case where m represents an integer of 2 or more, a plurality of X's may be the same or different from each other,
n represents an integer of 0 to 5, in a case where n represents an integer of 2 or more, a plurality of R_{4A}'s may be the same or different from each other, in a case where n is 2 or more, a plurality of R_{4A}'s may be linked to each other to form a ring,
in a case where all X's are monovalent groups, one or more hydrogen atoms included in R_{4A} are removed to form a bonding site, and
in a case where at least one X is a divalent group, one or more hydrogen atoms included in R_{4A} may be further removed to form a bonding site.

4. The on-press development type lithographic printing plate precursor according to claim 1,
wherein the hydrogen-donating compound is a compound having at least one partial structure represented by Formula (III) in a molecule, 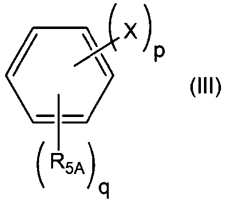 in Formula (III),
X is a group selected from the group consisting of -OH, -NH-, -SO₂-NH-, -SO₂-OH, -CO-NH-, and -CO-OH,
R_{5A} is a group having at least one selected from the group consisting of a hydrogen atom, a carbon atom, a halogen atom, and a heteroatom,
p represents an integer of 1 to 5, in a case where p represents an integer of 2 or more, a plurality of X's may be the same or different from each other,
q represents an integer of 0 to 5, in a case where q represents an integer of 2 or more, a plurality of R₅'s may be the same or different from each other, in a case where q is 2 or more, a plurality of R_{5A}'s may be linked to each other to form a ring,
p + q is 6 or less,
in a case where all X's are monovalent groups, one or more hydrogen atoms included in R_{5A} are removed to form a bonding site, and
in a case where at least one X is a divalent group, one or more hydrogen atoms included in R_{5A} may be further removed to form a bonding site.

5. The on-press development type lithographic printing plate precursor according to claim 1,
wherein the hydrogen-donating compound is a compound having at least two groups selected from the group consisting of -OH, -NH-, -SO₂-NH-, -SO₂-OH, -CO-NH-, and -CO-OH in a molecule.

6. The on-press development type lithographic printing plate precursor according to claim 1,
wherein the hydrogen-donating compound has at least one group selected from the group consisting of -OH and -SO₂-NH-.

7. The on-press development type lithographic printing plate precursor according to claim 1,
wherein the hydrogen-donating compound has at least two groups selected from the group consisting of -OH and -SO₂-NH-.

8. The on-press development type lithographic printing plate precursor according to claim 1,
wherein the hydrogen-donating compound has at least one phenolic hydroxyl group.

9. The on-press development type lithographic printing plate precursor according to claim 1,
wherein the hydrogen-donating compound has two or more phenolic hydroxyl groups.

10. The on-press development type lithographic printing plate precursor according to claim 1,
wherein the color-forming compound having the group that cleaves by the infrared exposure is a cyanine coloring agent represented by Formula 1, 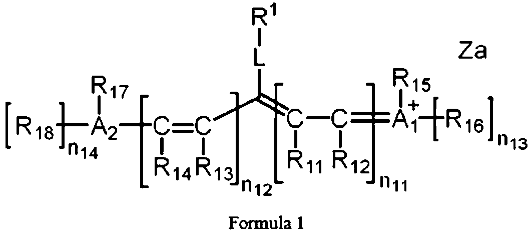
in Formula 1, R¹ represents a group having an R¹-L bond that cleaves by the infrared exposure,
R₁₁ to R₁₈ each independently represent a hydrogen atom, a halogen atom, -Ra, -ORb, -SRc, or -NRdRe,
Ra to Re each independently represent a hydrocarbon group,
A₁, A₂, and a plurality of R₁₁'s to R₁₈'s may be linked to each other to form a monocycle or a polycycle,
A₁ and A₂ each independently represent an oxygen atom, a sulfur atom, or a nitrogen atom,
n₁₁ and n₁₂ each independently represent an integer of 0 to 5, where a total of n₁₁ and n₁₂ is 2 or greater,
n₁₃ and n₁₄ each independently represent 0 or 1,
L represents an oxygen atom, a sulfur atom, or -NR¹⁰-,
R¹⁰ represents a hydrogen atom, an alkyl group, or an aryl group, and
Za represents a counterion that neutralizes charge.

11. The on-press development type lithographic printing plate precursor according to claim 10,
wherein the color-forming compound having the group that cleaves by the infrared exposure is a compound represented by Formula 2, 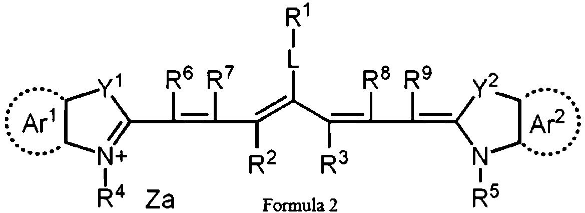
in Formula 2, R¹ represents a group having an R¹-L bond that cleaves by the infrared exposure,
R² and R³ each independently represent a hydrogen atom or an alkyl group and may be linked to each other to form a ring,
Ar¹ and Ar² each independently represent a group that forms a benzene ring or a naphthalene ring,
Y¹ and Y² each independently represent an oxygen atom, a sulfur atom, -NR⁰-, or a dialkylmethylene group,
R⁰ represents a hydrogen atom, an alkyl group, or an aryl group,
R⁴ and R⁵ each independently represent an aliphatic hydrocarbon group, a -CO₂M group, or a -PO₃M₂ group,
M represents a hydrogen atom, a Na atom, a K atom, or an onium group,
R⁶ to R⁹ each independently represent a hydrogen atom or an alkyl group,
L represents an oxygen atom, a sulfur atom, or -NR¹⁰-,
R¹⁰ represents a hydrogen atom, an alkyl group, or an aryl group, and
Za represents a counterion that neutralizes charge.

12. The on-press development type lithographic printing plate precursor according to claim 11,
wherein L in Formula 2 represents an oxygen atom.

13. The on-press development type lithographic printing plate precursor according to claim 12,
wherein R¹ in Formula 2 is a group represented by Formula (5), 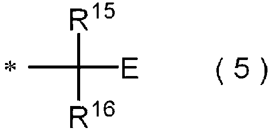
in Formula (5), R¹⁵ and R¹⁶ each independently represent a hydrogen atom, an alkyl group, or an aryl group, E represents an onium group, and * represents a bonding site with respect to the oxygen atom represented by L in Formula 2.

14. The on-press development type lithographic printing plate precursor according to claim 1,
wherein the polymerizable compound includes a polymerizable compound having 11 or more functional groups.

15. The on-press development type lithographic printing plate precursor according to claim 1,
wherein the polymerization initiator includes a borate compound as an electron-donating polymerization initiator.

16. The on-press development type lithographic printing plate precursor according to claim 1,
wherein the polymerization initiator includes an onium salt compound as an electron-accepting polymerization initiator.

17. The on-press development type lithographic printing plate precursor according to claim 1,
wherein the image-recording layer contains an acid color-forming agent in addition to the color-forming compound having the group that cleaves by the infrared exposure.

18. The on-press development type lithographic printing plate precursor according to any one of claims 1 to 17, further comprising:
a protective layer on the image-recording layer.

19. The on-press development type lithographic printing plate precursor according to claim 18,
wherein the protective layer contains an inorganic lamellar compound.

20. The on-press development type lithographic printing plate precursor according to claim 19,
wherein a content of the inorganic lamellar compound is 5 to 80 mg/m².

21. The on-press development type lithographic printing plate precursor according to any one of claims 1 to 17,
wherein micropores in an anodic oxide film of the support each comprise a large-diameter pore portion extending from a surface of the anodic oxide film to a position at a depth of 10 nm to 1,000 nm from the surface, and a small-diameter pore portion communicating with a bottom of the large-diameter pore portion and extending in a depth direction from a point of communication to a position at a depth of 20 nm to 2,000 nm from the point of communication,
an average diameter of the large-diameter pore portion at the surface of the anodic oxide film is 15 nm to 100 nm, and
an average diameter of the small-diameter pore portion at the point of communication is 15 nm or less.

22. The on-press development type lithographic printing plate precursor according to any one of claims 1 to 17,
wherein micropores in an anodic oxide film of the support each comprise a small-diameter pore portion extending from a surface of the anodic oxide film to a position at a depth of 10 nm to 1,000 nm from the surface, and a large-diameter pore portion communicating with a bottom of the small-diameter pore portion and extending in a depth direction from a point of communication to a position at a depth of 20 nm to 2,000 nm from the point of communication,
an average diameter of the small-diameter pore portion at the surface of the anodic oxide film is 35 nm or less, and
an average maximum diameter of the large-diameter pore portion is 40 to 300 nm.

23. The on-press development type lithographic printing plate precursor according to any one of claims 1 to 17,
wherein the support has an anodic oxide film, and
the anodic oxide film comprises, in order in a depth direction from a surface of the anodic oxide film:
an upper layer having a thickness of 30 nm to 500 nm and having micropores with an average diameter of 20 nm to 100 nm;
an intermediate layer having a thickness of 100 nm to 300 nm and having micropores with an average diameter of 1/2 to 5 times the average diameter of the micropores in the upper layer; and a lower layer having a thickness of 300 nm to 2,000 nm and having micropores with an average diameter of 15 nm or less.

24. A method of preparing a printing plate, comprising:
a step of image-exposing the on-press development type lithographic printing plate precursor according to any one of claims 1 to 17; and
a step of supplying at least one of printing ink or dampening water on a printing press to remove an unexposed portion of the image-recording layer in the on-press development type lithographic printing plate precursor.
